# EUROPEAN PATENT APPLICATION

(11) **EP 1 892 258 A1**
(43) Date of publication of application: **27.02.2008**
(21) Application number: 06766521.6
(22) Date of filing: 09.06.2006
(51) Int. Cl.: C08G 61/00

(54) **PROCESS FOR PRODUCING POLYMER**

(30) Priority: 10.06.2005 JP 2005171067; 10.06.2005 JP 2005171068
(71) Applicant: Sumitomo Chemical Company, Limited, Tokyo 104-8260 (JP)
(72) Inventor: OHUCHI, Kazuei, 3050005 (JP); FUKUSHIMA, Daisuke, 3050045 (JP); HIGASHIMURA, Hideyuki, 3050045 (JP)
(74) Representative: Vossius & Partner
(86) International application number: PCT/JP2006/311609
(87) International publication number: WO 2006/132356

(57) **Abstract**

A process for producing a polymer, **characterized by** comprising the following step (A) and step (B). (A) A step in which a polymer having repeating units represented by the general formula (1): -Ar¹- (wherein Ar¹ represents an arylene, divalent heterocyclic, or divalent aromatic amine group having at least one C-H bond on the aromatic ring) is used as a raw material and one or more of the C-H bond(s) on the aromatic ring are converted to thereby produce a polymer having repeating units which have one or more characteristic groups X and are represented by the general formula (2): (wherein X represents a characteristic group; Ar² represents an arylene group, heterocyclic group, or aromatic amine group which each has a valence of n+2 and in each of which n of the C-H bonds on the aromatic ring of Ar¹ have been converted into a C-X bond; and n is an integer of 1-4) (hereinafter, this polymer is referred to as polymer having the characteristic group (X)). (B) A step in which the polymer having the characteristic group (X) produced in the step (A) is reacted with a compound having a characteristic group (Y) which reacts with the characteristic group (X) to form a bond.

## Description

### TECHNICAL FIELD

The present invention relates to a process for producing polymers. The polymers produced according to the process of the present invention can be used for the electronic devices such as polymeric light-emitting devices (polymer LED).

### BACKGROUND ART

The polymers having an aromatic ring in the backbone demonstrate their own specificities in the electronic properties such as charge transport and light emission as well as in mechanical properties such as rigidity and thermal stability, so that they are finding useful application to the fields of electronic materials, chemistry, energy-generative materials, medicines, etc. (See, for instance, Non-Patent Document 1.)

Particularly, extensive researches have been pursued on their application to the electronic elements. As the high-molecular weight light-emitting materials (polymeric fluorescent substances) for instance, there are known polyarylene and polyarylene-vinylene type polymers such as polyfluorene and polyparaphenylene derivatives. (See, for instance, Non-Patent Document 2.) For improving the properties of these polymers, it has been attempted in many studies to introduce a substituent group to the side chain of the aromatic ring of the polymer. (See, for instance, Patent Documents 1 and 2.)

For example, researches have been made on the use of an aromatic polymer having a characteristic group as an intermediate for initiating a reaction for introducing the said substituent group.

For producing a polymer having a substituent group in the side chain of the aromatic ring, it has been the conventional method to synthesize a monomer having the said substituent group and polymerize this monomer.

Recently, there has been proposed a method for producing a polymer having a relatively complex side chain by first producing a polymer which is to become the backbone having a characteristic group, by polymerizing a monomer having a characteristic group under the condition that the monomer won't lose its characteristic group in the polymerization, and further reacting with this polymer a compound having a characteristic group which is reactive with the above-said characteristic group. (Patent Document 3.) Particularly, the aromatic polymers having a halogen group such as bromo group are useful as an intermediate for certain types of products such as conductive polymers, ion exchange resins, flame retardants, ion conductive polymers and insulators, because in these aromatic polymers, like in the halides of the low-molecular aromatic compounds, the halogen group acting as a substituent group can be converted into other substituent group. As means for brominating the aromatic polymers, the methods using an excess amount of a brominating agent have been known. (See, for instance, Patent Document 5 or Non-Patent Document 3.) There is also known a method for synthesizing a polymer having a branch point by copolymerizing a polyfunctional monomer which can serve as a branch point. (Patent Document 4.)
Non-Patent Document 1: Journal of Polymer Science: Part A, Vol. 39. p. 1533 (2001).
Non-Patent Document 2: Progress in Polymer Science, Vol. 28, p. 875 (2003).
Non-Patent Document 3: Polymer, Vol. 30, p. 1137 (1989).
Patent Document 1: JP-A-2003-155476
Patent Document 2: WO98/2713
Patent Document 3: JP-A-2003-253001
Patent Document 4: JP-A-2001-342459
Patent Document 5: JP-A-2001-517256

### DISCLOSURE OF THE INVENTION

### PROBLEM TO BE SOLVED BY THE INVENTION

Of these conventional methods, however, the methods comprising copolymerizing a monomer which can serve as a branch point had difficulty in producing a polymer having an aromatic ring side chain of a complicate structure since there is no distinction between the main and side chains. Also, in order to produce a polymer having a substituent group of a complicate structure in the side chain of the aromatic ring, it was necessary to produce a monomer having a complicate substuent group in the aromatic ring side chain, and the production of such a monomer was not easy. Also, polymerization of such a monomer would be difficult depending on the type of the substituent group. Further, the method in which a polymer that becomes the backbone having a characteristic group is produced by polymerization had the disadvantage in that the characteristic groups which can be possessed by the backbone polymer are limited because the said characteristic group is required not to react during polymerization of the backbone. Moreover, in the production of the said backbone polymer, the reactivity may drop depending on the type of the characteristic group.

Still further, in the method in which an aromatic polymer having a characteristic group is produced by polymerization (Patent Document 5), which is a conventional method mentioned above, there is a restriction on the characteristic groups that can be possessed by the aromatic polymer as it is required that the characteristic group won't react during polymerization. For instance, in case of using Suzuki coupling or Yamamoto coupling which is useful for the synthesis of an aromatic polymer, there was a drawback that the production of an aromatic polymer having a halogen group as a characteristic group was difficult. The reactivity may even drop during production of the backbone polymer depending on the type of the characteristic group.

The first object of the present invention is to provide a process capable of producing with ease a polymer having an aromatic ring in the backbone and having a substituent group of a complex structure in the side chain of the said aromatic ring.

The second object of the present invention is to provide a process for producing with ease an aromatic polymer having a characteristic group. The above-mentioned bromination reaction of an aromatic polymer (Non-Patent Document 3 and Patent Document 5) had the industrial problems in that as the reaction is let proceed by using a brominating agent in large excess, the bromination yield is low and it is difficult to control the rate of bromination; that it is necessary to remove a large excess of brominating agent; and that in case the aromatic polymer has a linking group such as ether linkage in the backbone, even though bromination is possible under a mild condition, a high-temperature reaction using an iron type catalyst or a solid catalyst such as aluminum chloride is necessitated for bromination into a compound with a relatively low activity for an electropholic substitution reaction, and the purification of the brominated compound becomes complex because of the need to remove the solid catalyst.

The third object of the present invention is to provide a process for producing with ease an aromatic polymer having a bromo group which is relatively unsusceptible to the electrophilic reactions, under a mild condition and in a high yield while controlling the bromination rate with high bromination yield.

### MEANS FOR SOLVING THE PROBLEM

In the course of studies for attaining the above-said first object, the present inventors found that a polymer having an aromatic ring in the backbone and having a substitutent group of a complex structure in the side chain of said aromatic ring can be produced with ease by using as the starting material a polymer having repeating units represented by the following general formula (1), converting the C-H bond(s) on the aromatic ring to produce a polymer having repeating units having a characteristic group X represented by the following general formula (2) (this polymer being hereinafter referred to as polymer having a characteristic group X), and reacting this polymer having a characteristic group X with a compound having a characteristic group Y which reacts with the characteristic group X to form a bond. The present invention has been achieved on the basis of the above finding.

Thus, the present invention, in its first embodiment, pertains to a process for producing a polymer characterized by comprising the following step (A) and step (B):
(A) A step in which a polymer having repeating units represented by the general formula (1):

   -Ar¹- (1)

   (wherein Ar¹ represents an arylene, divalent heterocyclic or divalent aromataic amine group having at least one C-H bond on the aromatic ring) is used as a staring material, and the C-H bond(s) on the aromatic ring is(are) converted to produce a polymer having repeating units which have one or more characteristic groups X represented by the general formula (2): 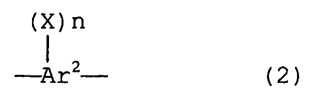 (wherein X represents a characteristic group; Ar² represents an arylene group, heterocyclic group or aromatic amine group which each has a valence of n + 2 and in each of which n of the C-H bonds on the aromatic ring of Ar¹ have been converted into C-X bond; and n is an integer of 1 to 4).
(B) A step in which the polymer having the characteristic group X produced in the step (A) is reacted with a compound having a characteristic group Y which reacts with the characteristic group X to form a bond.

Further, as a result of studies for fulfilling the above-mentioned second and third objects, the present inventors found that a polymer having repeating units which have a characteristic group(s) X represented by the general formula (2) can be produced with easy by using as a starting material a polymer having repeating units represented by the formula (1), and converting the C-H bond(s) on the aromatic ring by an aromatic electrophilic substitution reaction, typically a halogenation reaction. The present inventors have also found that an aromatic polymer having a bromo group can be produced with ease, under a mild condition and in a high yield while controlling the bromination rate with a high bromination yield, by acting bromine as a brominating agent to a polymer having one or more types of repeating units represented by the general formula (1) in an organic solvent in the presence of an organic strong acid in an amount 5 times or more by mol the total of said repeating units, and these findings have led to the completion of the present invention.

Thus, in the second embodiment of the present invention, there is provided a process for producing a polymer characterized in that a polymer having one or more types of repeating units represented by the following general formula (1):

-Ar¹- (1)

(wherein Ar¹ represents an arylene, divalent heterocyclic or divalent aromatic amine group having at least one C-H bond on the aromatic ring) is used as a starting material, the total of the repeating units represented by the formula (1) being 0.1 to 100 mol% of the total of the overall repeating units (here the said polymer may have, in addition to the repeating units represented by the formula (1), the repeating units represented by the following general formula (1a):

-Ar⁰- (1a)

(wherein Ar⁰ represents an arylene, divalent heterocyclic or divalent aromatic amine group having no C-H bond on the aromatic ring) and may also have a linking group including a non-conjugated portion represented by the following formulae X-1 to X-11: 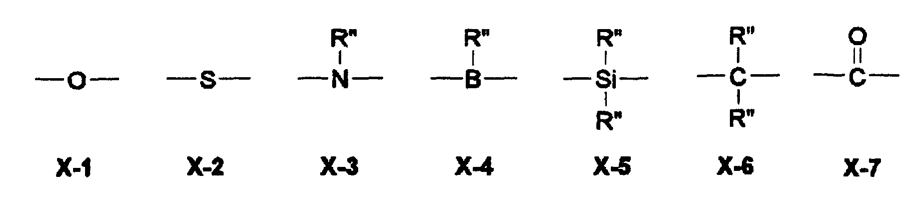 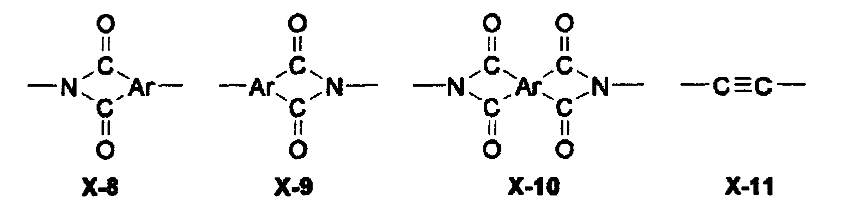 (wherein Ar represents a C6-C60 hydrocarbon group; and R" represents a substituent group selected from the group consisting of hydrogen atom, alkyl group, aryl group and monovalent heterocyclic group) and/or a group comprising a combination of 2 or more of such linking groups, in an amount of 40 mol% or less based on the total of the repeating units represented by the above formulae (1) and (1a)), and the C-H bond on the aromatic ring is converted by an aromatic electrophilic substitution reaction selected from the group consisting of halogenation, nitration, Friedel-Crafts alkylation, halomethylation, Friedel-Crafts acylation, Gattermann aldehyde sysnthesis and Vilsmeier formylation to obtain a polymer having repeating units which have a characteristic group X^{b} and are represented by the general formula (2'): 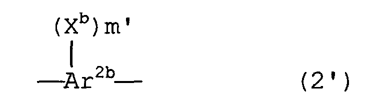 (wherein X^{b} represents a characteristic group introduced by the said aromatic electrophilic substitution reaction or a characteristic group derived therefrom; Ar^{2b} represents an arylene group, heterocyclic group or aromatic amine group which each has a valence of m' + 2 and in each of which m' of the C-H bonds on the aromatic ring of Ar¹ have been converted into a C-X bond; and m' is an integer of 1 to 4).

### ADVATAGES OF THE INVENTION

According to the process in the first embodiment of the present invention, it is possible to produce with ease a polymer having an aromatic ring in the backbone and a substituent group of an intricate structure in the side chain of the aromatic ring. The polymer produced according to the process of the present invention is expected to serve as a polymeric substance useful for the production of a variety of high-performance materials in the fields of electronic materials, chemistry, energy-generative materials, medicines, etc. Particularly, in case the polymer produced by the process of the present invention is used in the field of electronic materials, it is possible to realize higher performance such as improvement of charge injection and transport due to the incorporation of a functional substituent group capable of improving charge injection and transport in the charge transportable backbone comprising a conjugated polymer or the control of light emission wavelength due to the incorporation of a functional substituent group having a fluorescent or phosphorescent coloring matter. For instance, it is possible to improve electron injection and transport by providing an electron injecting and transporting side chain to the electron injecting and transporting backbone, or to improve hole injection and transport by providing a hole injecting and transporting side chain to the hole injecting and transporting backbone. It is also possible to improve both electron and hole injection and transport by providing a hole injecting and transporting side chain to the electron injecting and transporting backbone or by providing an electron injecting and transporting side chain to the hole injecting and transporting backbone. As viewed above, the polymer produced according to the process of the present invention can be used as a light-emitting material for polymer LED, charge transport material, coloring matter for laser, organic solar cell material, organic semiconductor for organic transistors, conductive film material and the like.

According to the process in the second embodiment of the present invention, it is possible to produce with ease an aromatic polymer having repeating units which have a characteristic group(s). It is also possible to produce with ease even an aromatic polymer of the type which is perfectly incapable of being brominated or can be brominated only under a strict condition with the conventional methods, that is, a brominated aromatic polymer can be produced under a mild condition and in a high yield while controlling the bromination rate.

### BEST MODE FOR CARRYING OUT THE INVENTION

(I) First, the process according to the first embodiment of the present invention is described.

The step (A) in the process of the first embodiment of the present invention is a step in which a polymer having repeating units represented by the above-shown general formula (1) is used as a starting material and the C-H bond(s) on the aromatic ring is converted to produce a polymer having repeating units which have a characteristic group(s) X represented by the above-shown general formula (2).

In the repeating units of the formula (1) used in the present invention, Ar¹ represents an arylene, divalent heterocyclic or divalent aromatic amine group having at least one C-H bond on the aromatic ring. It may have a substituent group.

The arylene group mentioned here is an atomic group comprising an aromatic hydrocarbon from which two hydrogen atoms have been eliminated. It includes the type having a condensed ring as well as the type in which two or more independent benzene rings or condensed rings are bonded directly or through a group such as vinylene. The arylene group may have a substituent. The carbon number of the portion exclusive of the substituent in the arylene group is usually about 6 to 60, preferably 6 to 20. The overall carbon number of the arylene group including the substituent is usually about 6 to 100. Examples of the arylene group are shown below by the formulae 1A-1 to 1A-20.

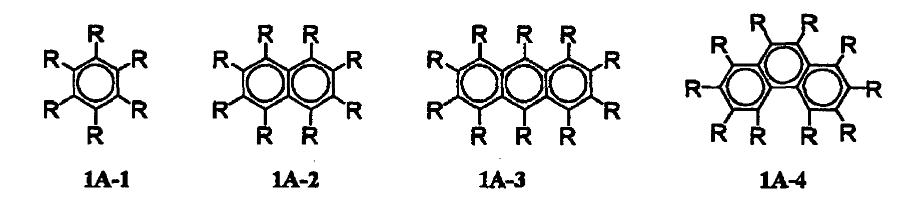

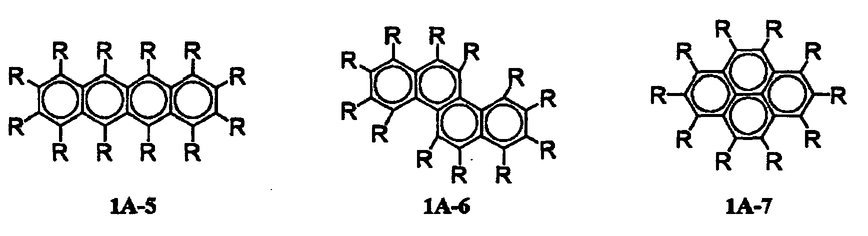

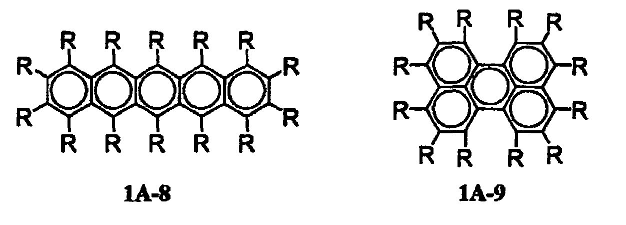

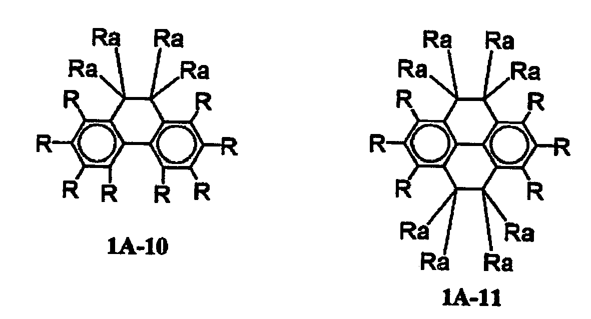

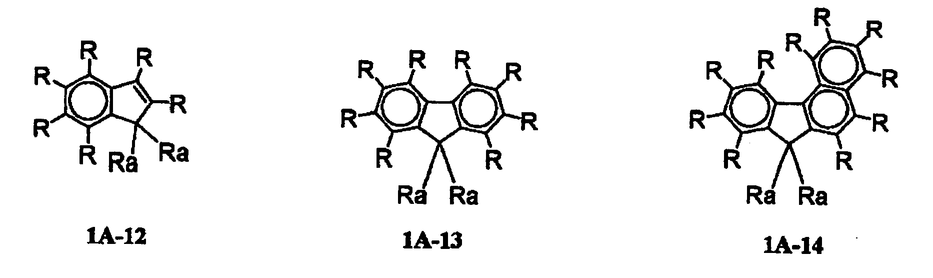

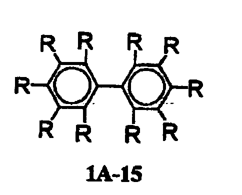

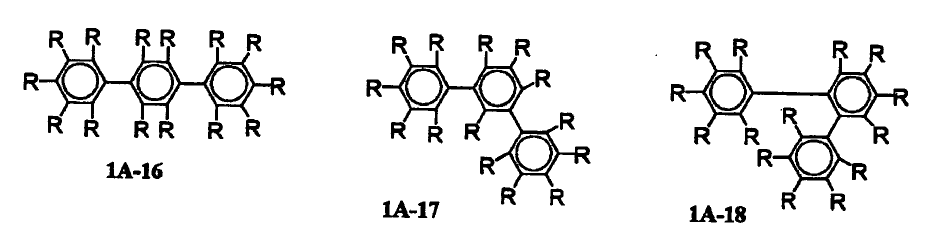

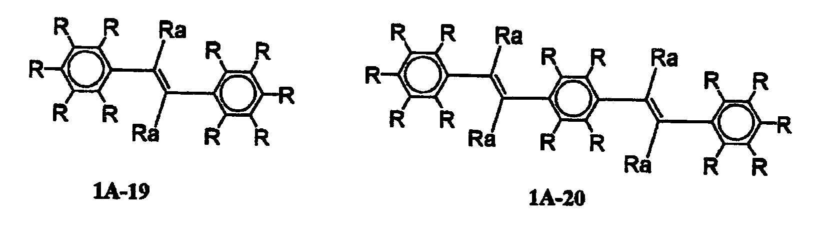

In the above formulae 1A-1 to 1A-20 exemplifying Ar¹, R represents a hydrogen atom, a valence bond or a substituent group. Any two of the R's represent a valence bond, and at least one of them represents a hydrogen atom. When there exist plural substituent groups represented by R, they may be identical or different from each other. Ra represents a hydrogen atom or a substituent group. When there exist plural substituent groups represented by Ra, they may be identical or different from each other. When two Ra's exist on a same atom, they may be combined to form an oxo or thioxo group or may be bonded together to form a ring.

The substituent groups represented by R may form, together with the substituent groups on the adjoining atoms, a 5- to 7-membered aliphatic ring or a 5- to 7-membered aromatic ring which may have a hetero-atom such as oxygen atom, sulfur atom or nitrogen atom.

Concerning the arylene groups represented by Ar¹, of those designated by the formulae 1A-1 to 1A-14, phenylene group (1A-1), naphthalene-diyl group (1A-2), dihydrophenanthrene-diyl group (1A-10), fluorene-diyl group (1A-13), benzofluorene-diyl group (1A-14), biphenylene group (1A-15), terphenylene group (1A-16 to 1A-18), stilbene-diyl group (1A-19) and distilbene-diyl group (1A-20) are preferred. Of those mentioned above, phenylene group (1A-1), naphthalene-diyl group (1A-2), dihydrophenanthrene-diyl group (1A-10), fluorene-diyl group (1A-13), benzofluorene-diyl group (1A-14), biphenylene group (1A-15) and terphenylene group (1A-16 to 1A-18) are more preferred, and phenylene group (1A-1), naphthalene-diyl group (1A-2), fluorene-diyl group (1A-13) and benzofluorene-diyl group (1A-14) are even more preferred.

The divalent heterocyclic group is an atomic group comprising a heterocyclic compound from having its two hydrogen atoms eliminated. It includes the type having a condensed ring and the type in which the independent monocyclic heterocyclic compounds or two or more of the condensed rings are bonded directly or through a group such as vinylene, and the type in which a heterocyclic compound and an aromatic hydrocarbon are combined. The divalent heterocyclic group may have a substituent. The carbon number of the portion exclusive of the substituent in the divalent heterocyclic group is usually about 4 to about 60, preferably 2 to 20.

The overall carbon number of the divalent heterocyclic group including the substituent is usually about 2 to about 100. The term "heterocyclic compound" used here means those of the organic compounds having a cyclic structure in which the elements constituting the ring comprise not only carbon atoms but also include hetero-atoms such as oxygen, sulfur, nitrogen, phosphorus and boron. Examples of the divalent heterocyclic group are shown below by the formulae 2A-1 to 2A-53, and 2A-101 to 2A-116.

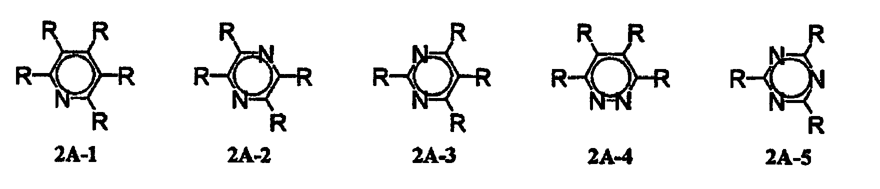

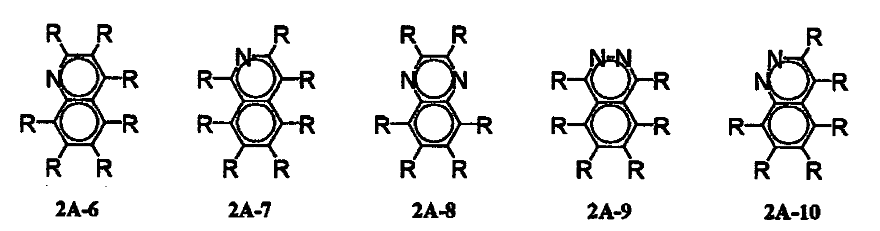

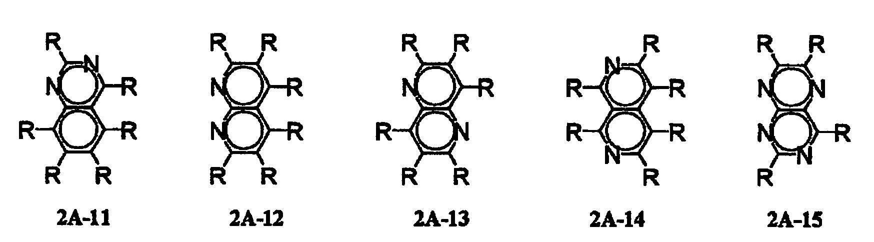

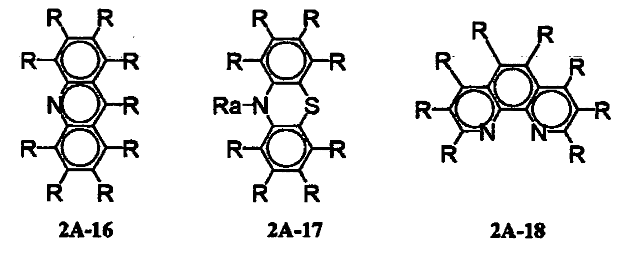

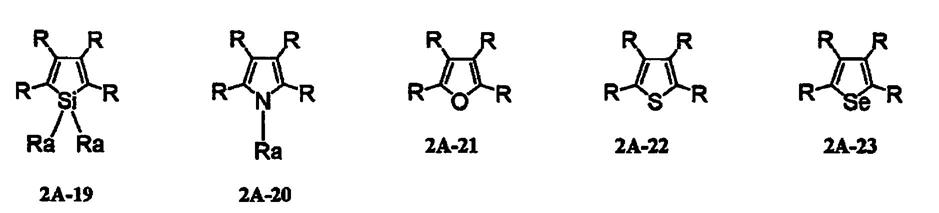

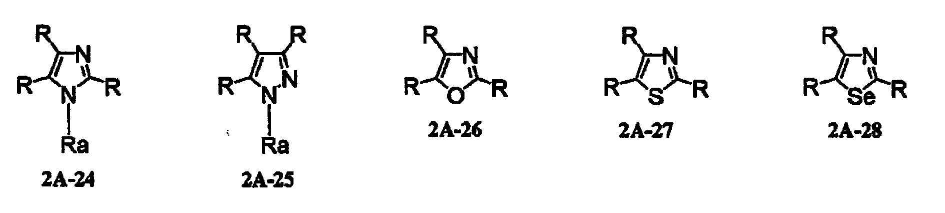

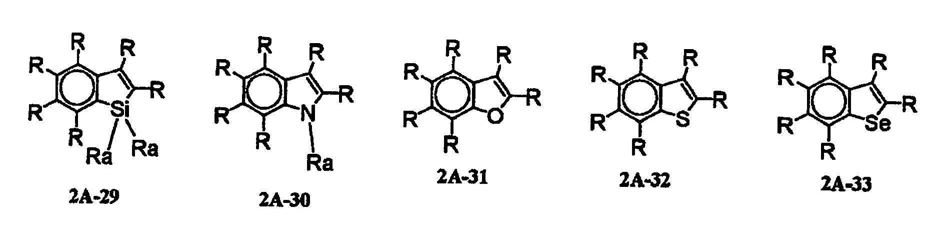

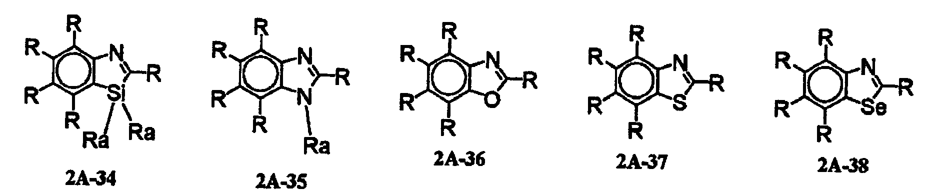

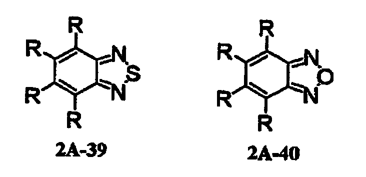

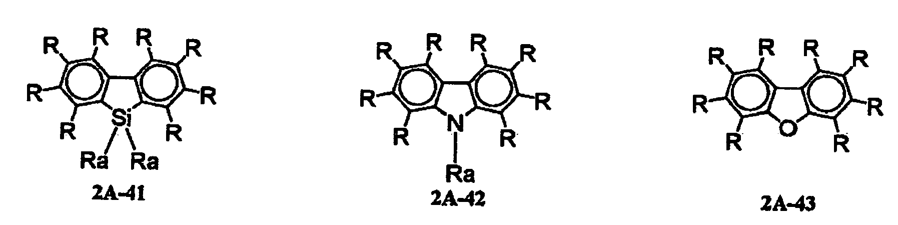

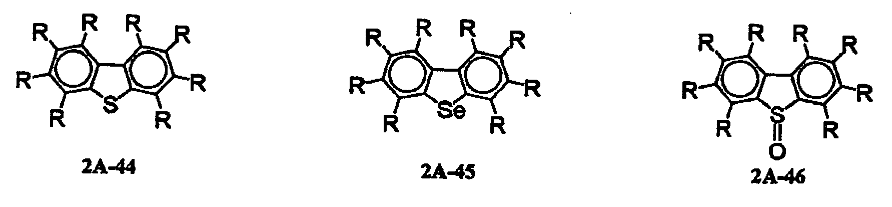

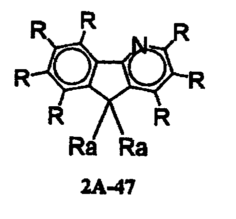

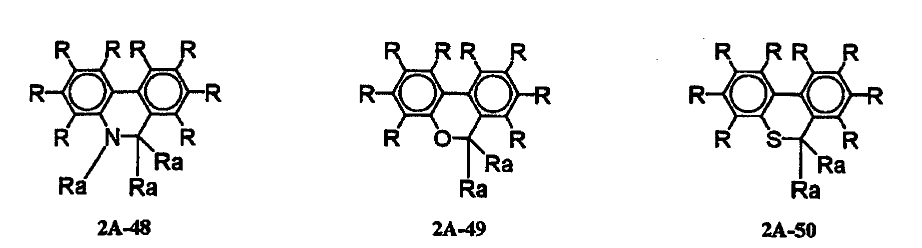

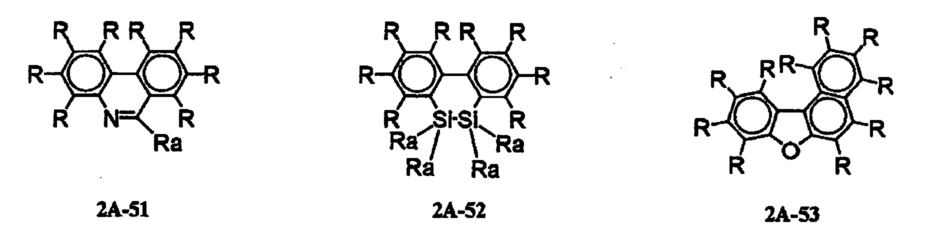

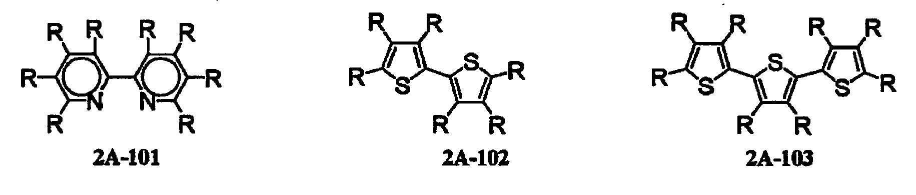

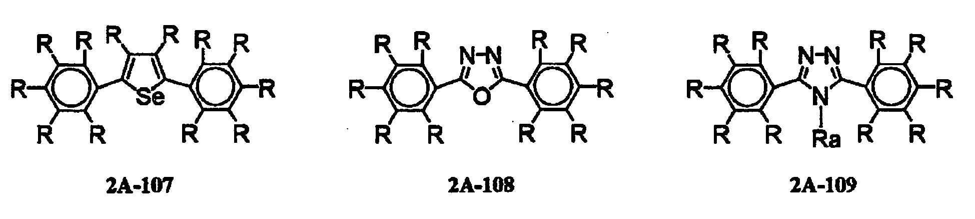

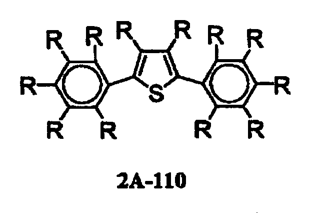

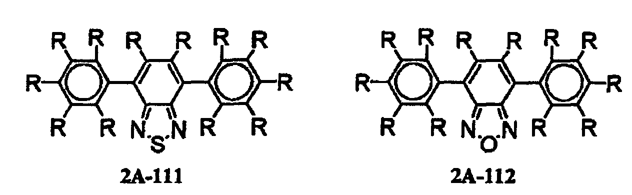

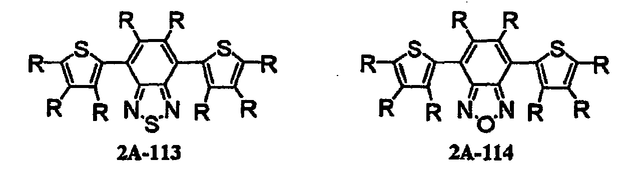

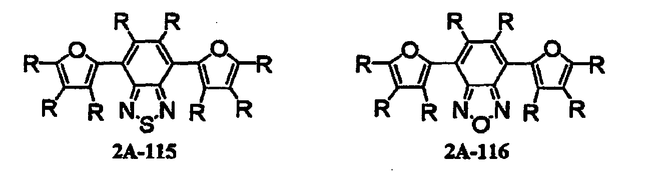

In the above-shown formulae 2A-1 to 2A-53 and 2A-101 to 2A-116 exemplifying Ar¹, R represents a hydrogen atom, a valence bond or a substituent. Any two of R's in the above formulae are valence bonds, and at least one of R's is a hydrogen atom. When there exist plural substituents represented by R, they may be identical or different from each other. Ra represents a hydrogen atom or a substituent. When there exist plural substituents represented by Ra, they may be identical or different from each other. When two Ra's exist on a same atom, they may be combined to form an oxo or thioxo group or may be bonded together to form a ring.

Also, the substituent represented by R may form, together with the substituents on the adjoining atoms, a 5- to 7-membered aliphatic ring having a hetero-atom such as oxygen atom, sulfur atom or nitrogen atom or a 5- to 7-membered aromatic ring which may have a hetero-atom such as oxygen atom, sulfur atom or nitrogen atom.

Of the divalent heterocyclic groups of Ar¹ indicated by the above-shown formulae 2A-1 to 2A-53 and 2A-101 to 2A-116, pyridine-diyl group (2A-1), quinoline-diyl group (2A-6), isoquinoline-diyl group (2A-7), quinoxaline-diyl group (2A-8), phenanthroline-diyl group (2A-18), thiophene-diyl group (2A-22), imidazole-diyl group (2A-24), oxazole-diyl group (2A-26), thiazole-diyl group (2A-27), 5-membered ring heterocyclic groups containing nitrogen, sulfur or oxygen as hetero-atom and having their benzene ring condensed (2A-30 to 2A-32 and 2A-34 to 2A-40), heterocylic groups having a fluorine-like skeleton containing silicon, nitrogen, oxygen or sulfur as hetero-atom (2A-41 to 2A-44, 2A-46 and 2A-47), heterocyclic groups having a condensed ring structure indicated by the formulae 2A-48 to 2A-53, diazaphenylene group (2A-101), compound groups having phenyl group and thienyl group bonded at the 2,5-position of a 5-membered ring heterocyclic group containing nitrogen, oxygen or sulfur as hetero-atom (2A-103, 2A-105, 2A-106, and 2A-108 to 2A-110), and the compound groups having phenyl group and thienyl group bonded to a 5-membered ring heterocyclic group containing nitrogen, oxygen or sulfur as hetero-atom and having its benzene ring condensed (2A-111 to 2A-116) are preferred. Of those mentioned above, pyridine-diyl group (2A-1), quinoline-diyl group (2A-6), isoquinoline-diyl group (2A-7), quinoxaline-diyl group (2A-8), phenanthroline-diyl group (2A-18), heterocyclic groups having a fluorene-like skeleton containing silicon, nitrogen, oxygen or sulfur as hetero-atom (2A-41 to 2A-44, 2A-46 and 2A-47), heterocyclic groups having a condensed ring structure indicated by the formulae 2A-48 to 2A-53, diazaphenylene group (2A-101), compound groups having phenyl group bonded at the 2,5-position of a 5-membered ring heterocyclic group containing nitrogen, oxygen or sulfur as hetero-atom (2A-103, 2A-105, 2A-106, and 2A-108 to 2A-110), and compound groups having phenyl group bonded to a 5-membered ring heterocyclic group containing nitrogen, oxygen or sulfur as hetero-atom and having its benzene ring condensed (2A-111 to 2A-116) are more preferred. The heterocyclic groups having a fluorene-like skeleton containing silicon, nitrogen, oxygen or sulfur as hetero-atom (2A-41 to 2A-44, 2A-46 and 2A-47), heterocyclic groups having a condensed ring structure indicated by the formulae 2A-48 to 2A-53, compound groups having phenyl group bonded to the 2,5-position of a 5-membered ring heterocyclic group containing nitrogen, oxygen or sulfur as hetero-atom (2A-103, 2A-105, 2A-106, and 2A-108 to 2A-110), and compound groups having phenyl group bonded to a 5-membered ring heterocyclic group having its benzene ring condensed and containing nitrogen, oxygen or sulfur as hetero-atom (2A-111 to 2A-116) are even more preferred.

"Divalent aromatic amine group" is an atomic group which is left after elimination of two hydrogen atoms from an aromatic amine. This divalent aromatic amine group may have a substituent. The carbon number of the portion exclusive of the substituent in the divalent aromatic amine group is usually about 4 to about 60. Examples of the divalent aromatic amine group are the groups represented by the following general formula (1-2): 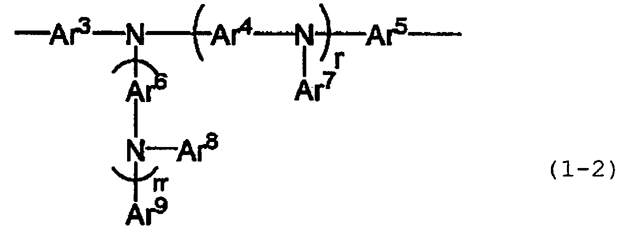 (wherein Ar³, Ar⁴, Ar⁵ and Ar⁶ represent independently an arylene group or a divalent heterocyclic group; Ar⁷, Ar⁸ and Ar⁹ represent independently an aryl gjroup or a monovalent heterocyclic group; each of Ar³, Ar⁴, Ar⁵, Ar⁶, Ar⁷, Ar⁸ and Ar⁹ may have a substituent; r and rr are independently 0 or 1.)

More specifically, the groups represented by the following formulae 3A-1 to 3A-8 can be cited as examples of the divalent aromatic amine group:

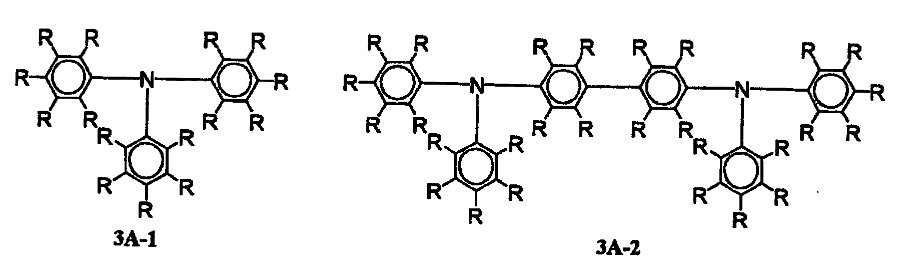

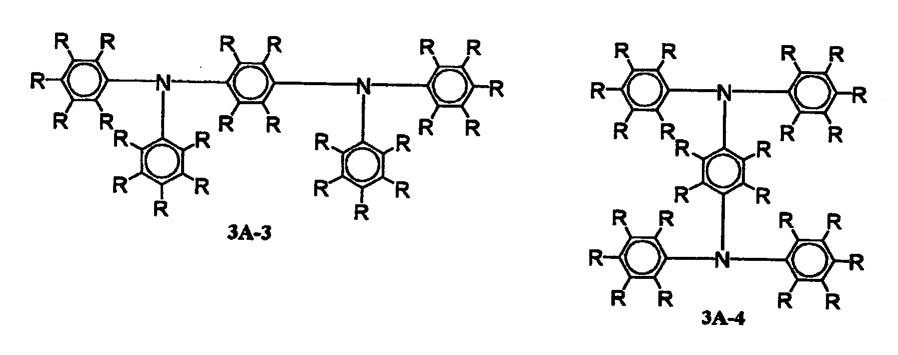

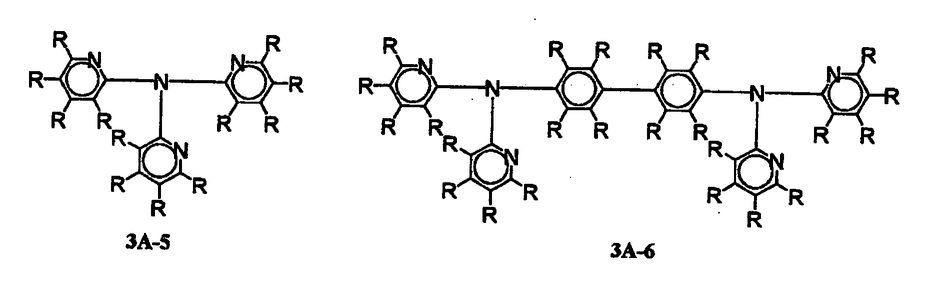

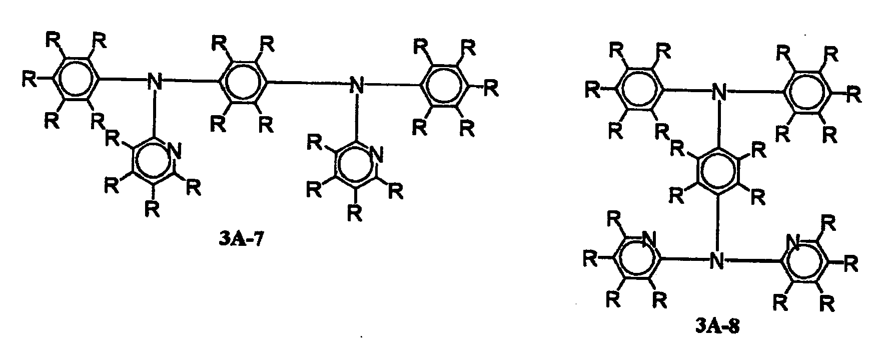

In the above-shown formulae 3A-1 to 3A-8 of Ar¹, R represents a hydrogen atom, a valence bond or a substituent. Any two of R's are the valence bonds, and at least one of R's is a hydrogen atom. When there exist plural substituents represented by R, they may be identical or different from each other.

As for the divalent aromatic amine groups represented by Ar¹, of those designated by the above-shown formulae 3A-1 to 3A-8, the ones designated by 3A-1 to 3A-4 are preferred, of which the ones designated by 3A-1 to 3A-3 are more preferred, and the ones designated by 3A-2 and 3A-3 are even more preferred.

The substituent represented by R may form, together with the substituents on the adjoining atoms, a 5- to 7-membered aliphatic ring having a hetero atom such as oxygen atom, sulfur atom or nitrogen atom, or a 5- to 7-membered aromatic ring which may have a hetero atom such as oxygen atom, sulfur atom or nitrogen atom.

As the group represented by Ar¹, of the arylene group, divalent heterocyclic group and divalent aromatic amine group, arylene group and divalent heterocyclic group are preferred, with arylene group being more preferred.

The substituents represented by R or Ra are not specifically defined as far as they do not substantially hinder the reaction in the step A and step B in the process of the present invention. Exemplary of such substituents are alkyl group, aryl group, aralkyl group, monovalent heterocyclic group, arylalkenyl group, arylalkynyl group, alkoxy group, aryloxy group, aralkyloxy group, alkylthio group, arylthio group, aralkylthio group, substituted amino group, substituted silyl group, sulfonic group, phosphonoic group, cyano group, and nitro group.

The alkyl groups represented by R or Ra may be either linear, branched or cyclic in molecular structure, and their carbon number is usually about 1 to about 20, preferably 3 to 20. Examples of such alkyl groups include methyl, ethyl, propyl, isopropyl, n-butyl, isobutyl, s-butyl, t-butyl, pentyl, isopentyl, hexyl, cyclohexyl, heptyl, octyl, 2-ethylhexyl, nonyl, decyl, 3,7-dimethyloctyl, dodecyl and octadecyl.

In view of solubility in the organic solvents and ease of synthesis, or for the reason of good balance between product characteristics and heat resistance in case of using the polymer obtained according to the process of this invention for polymer LED, the following groups are preferred: methyl, ethyl, propyl, isopropyl, n-butyl, isobutyl, s-butyl, t-butyl, pentyl, isopentyl, hexyl, cyclohexyl, heptyl, cyclohexylmethyl, octyl, 2-ethylhexyl, 2-cyclohexylethyl, nonyl, decyl, 3,7-dimethyloctyl and dodecyl. Of these groups, methyl, ethyl, propyl, isopropyl, butyl, isobutyl, s-butyl, t-butyl, pentyl, isopentyl, hexyl, cyclohexyl, heptyl, octyl, 2-ethylhexyl, nonyl, decyl and 3.7-dimethylocyl are more preferred, and propyl, isopropyl, butyl, isobutyl, s-butyl, t-butyl, pentyl, isopentyl, hexyl, cyclohexyl, heptyl, octyl, 2-ethylhexyl, nonyl, decyl and 3.7-dimethylocyl are even more preferred.

Aryl group is an atomic group comprising an aromatic hydrocarbon from which one hydrogen atom on the aromatic ring has been eliminated. It may have a condensed ring. Aryl group has a carbon number of usually about 6 to about 60, preferably 7 to 48, and its examples include phenyl, C₁-C₁₂ alkylphenyl, 1-naphthyl, 2-naphthyl, 1-anthracenyl, 2-anthracenyl and 9-anthracenyl. ("C₁-C₁₂" indicates that the carbon number is 1 to 12, and this designation applies in the following description.)

In view of solubility in the organic solvents and ease of synthesis, or for the reason of good balance between product characteristics and heat resistance in case of using the polymer obtained from the process of this invention for polymer LED, C₁-C₁₂ alkylphenyl groups are preferred.

Examples of such C₁-C₁₂ alkylphenyl groups are methylphenyl, ethylphenyl, dimethylphenyl, dimethyl-t-butylphenyl, propylphenyl, mesityl, methylethylphenyl, isopropylphenyl, n-butylphenyl, isobutylphenyl, s-butylphenyl, t-butylphenyl, pentylphenyl, isopentylphenyl, hexylphenyl, heptylphenyl, octylphenyl, nonylphenyl, decylphenyl, 3,7-dimethyloctylphenyl, and dodecylphenyl. Of these groups, dimethylphenyl, dimethyl-t-butylphenyl, propylphenyl, mesityl, methylethylphenyl, isopropylphenyl, n-butylphenyl, isobutylphenyl, s-butylphenyl, t-butylphenyl, pentylphenyl, isopentylphenyl, hexylphenyl, heptylphenyl, octylphenyl, nonylphenyl, decylphenyl, 3,7-dimethyloctylphenyl and dodecylphenyl are preferred.

Aralkyl group is the one whose carbon number is usually about 7 to about 60, preferably 7 to 48. Examples thereof are phenyl-C₁-C₁₂ alkyl, C₁-C₁₂ alkylphenyl-C₁-C₁₂ alkyl, 1-naphthyl-C₁-C₁₂ alkyl, and 2-naphthyl-C₁-C₁₂ alkyl.

In view of solubility in the organic solvents and ease of synthesis, or for the reason of good balance between product characteristics and heat resistance in case of using the polymer obtained according to the process of this invention for polymer LED, C₁-C₁₂ alkylphenyl-C₁-C₁₂ alkyl is preferred.

Monovalent heterocyclic group is an atomic group which is left after elimination of one hydrogen atom from a heterocyclic compound, and its carbon number is usually about 4 to about 60, preferably 4 to 20. The carbon number of the heterocyclic group does not include the carbon number of the substituent. The "heterocyclic compounds" referred to herein mean those of the organic compounds having a cyclic structure in which the elements constituting the ring comprise not only a carbon atom but also a hetero-atom such as oxygen, sulfur, nitrogen, phosphorus or boron. Examples of the monovalent heterocyclic group are thienyl, C₁-C₁₂ alkylthienyl, pyrolyl, furyl, pyridyl, C₁-C₁₂ alkylpyridyl, piperidyl, quinolyl and isoquinolyl.

In view of solubility in the organic solvents and ease of synthesis, or for the reason of good balance between product characteristics and heat resistance in case of using the polymer of this invention for polymer LED, thienyl, C₁-C₁₂ alkylthienyl, pyridyl and C₁-C₁₂ alkylpyridyl are preferred.

Arylalkenyl group has a carbon number of usually about 8 to about 60 and includes as its examples phenyl-C₂-C₁₂ alkenyl, C₁-C₁₂ alkylphenyl-C₂-C₁₂ alkenyl, 1-naphthyl-C₂-C₁₂ alkenyl, and 2-naphthyl-C₂-C₁₂ alkenyl.

In view of solubility in the organic solvents and ease of synthesis, or for the reason of good balance between product characteristics and heat resistance in case of using the polymer of this invention for polymer LED, C₁-C₁₂ alkylphenyl-C₂-C₁₂ alkenyl is preferred.

Arylalkynyl group is usually about 8 and about 60 in carbon number and its examples are phenyl-C₂-C₁₂ alkynyl, C₁-C₁₂ alkylphenyl-C₂-C₁₂ alkynyl, 1-naphthyl-C₂-C₁₂ alkynyl, and 2-naphthyl-C₂-C₁₂ alkynyl.

In view of solubility in the organic solvents and ease of synthesis, or for the reason of good balance between product characteristics and heat resistance in case of using the polymer of this invention for polymer LED, C₁-C₁₂ alkylphenyl-C₂-C₁₂ alkynyl is preferred.

Alkoxyl group may be either linear, branched or cyclic in its molecular structure, and its carbon number is usually about 1 to about 20, preferably 3 to 20. Examples of this group are methoxy, ethoxy, propyloxy, isopropyloxy, n-butoxy, isobutoxy, t-butoxy, pentyloxy, hexyloxy, cyclohexyloxy, heptyloxy, octyloxy, 2-ethylhexyloxy, nonyloxy, decyloxy, 3,7-dimethyloctyloxy and dodecyloxy.

In view of solubility in the organic solvents and ease of synthesis, or for the reason of good balance between product characteristics and heat resistance in use of the polymer of this invention for polymer LED, pentyloxy, hexyloxy, octyloxy, 2-ethylhexyloxy, decyloxy and 3,7-dimethyloctyloxy are preferred.

Aryloxy group ranges from usually about 6 to about 60, preferably 7 to 48 in carbon number, and its examples are phenoxy, C₁-C₁₂ alkylphenoxy, 1-naphthyloxy and 2-naphthyloxy.

In view of solubility in the organic solvents and ease of synthesis, or for the reason of good balance between product characteristics and heat resistance in case of using the polymer of this invention for polymer LED, C₁-C₁₂ alkylphenoxy is preferred.

Exemplary of the C₁-C₁₂ alkylphenoxy group are methylphenoxy, ethylphenoxy, dimethylphenoxy, propylphenoxy, 1,3,5-trimethylphenoxy, methylethylphenoxy, isopropylphenoxy, n-butylphenoxy, isobutylphenoxy, t-butylphenoxy, pentylphenoxy, isopentylphenoxy, hexylphenoxy, heptylphenoxy, octylphenoxy, nonylphenoxy, decylphenoxy, and dodecylphenoxy.

Aralkyloxy group is of a carbon number of usually about 7 to about 60, preferably 7 to 48, and its examples are phenyl-C₁-C₁₂ alkoxy, C₁-C₁₂ alkylphenyl-C₁-C₁₂ alkoxy, 1-naphthyl-C₁-C₁₂ alkoxy and 2-naphthyl-C₁-C₁₂ alkoxy, more specifically phenylmethoxy, phenyl-n-butoxy, phenylpentyloxy, phenylhexyloxy, phenylheptyloxy and phenyloctyloxy.

In view of solubility in the organic solvents and ease of synthesis, or for the reason of balance between product characteristics and heat resistance in case of using the polymer of this invention for polymer LED, C₁-C₁₂ alkylphenyl-C₁-C₁₂ alkoxy is preferred.

Alkylthio group may be either linear, branched or cyclic, with its carbon number being usually about 1 to about 20, preferably 3 to 20, and its examples are methylthio, ethylthio, propylthio, isopropylthio, n-butylthio, isobutylthio, t-butylthio, pentylthio, hexylthio, cyclohexylthio, heptylthio, octylthio, 2-ethylhexylthio, nonylthio, decylthio, 3,7-dimethyloctylthio and dodecylthio.

In view of solubility in the organic solvents and ease of synthesis, or for the reason of good balance between product characteristics and heat resistance in case of using the polymer of this invention for polymer LED, pentylthio, hexylthio, octylthio, 2-ethylhexylthio, decylthio and 3,7-dimethyloctylthio are preferred.

Arylthio group is usually about 3 to about 60 in carbon number, and its examples are phenylthio, C₁-C₁₂ alkylphenylthio, 1-naphthylthio and 2-naphthylthio.

In view of solubility in the organic solvents and ease of synthesis, or for the reason of good balance between product characteristics and heat resistance in case of using the polymer of this invention for polymer LED, C₁-C₁₂ alkylphenylthio is preferred.

Aralkylthio group is of a carbon number of usually about 7 to about 60, preferably 7 to 48, and its examples include phenyl-C₁-C₁₂ alkylthio, C₁-C₁₂ alkylphenyl-C₁-C₁₂ alkylthio, 1-naphthyl-C₁-C₁₂ alkylthio and 2-naphthyl-C₁-C₁₂ alkylthio.

In view of solubility in the organic solvents and ease of synthesis, or for the reason of good balance between product characteristics and heat resistance in case of using the polymer of this invention for polymer LED, C₁-C₁₂ alkylphenyl-C₁-C₁₂ alkylthio is preferred.

Substituted amino group is, for instance, an amino group which has been substituted with one or two groups selected from alkyl, aryl, arylalkyl and monovalent heterocyclic, with its carbon number being usually about 1 to about 60, preferably 2 to 48.

Exemplary of this substituted amino group are methylamino, dimethylamino, ethylamino, diethylamino, propylamino, dipropylamino, isopropylamino, diisopropylamino, n-butylamino, isobutylamino, t-butylamino, pentylamino, hexylamino, cyclohexylamino, heptylamino, octylamino, 2-ethylhexylamino, nonylamino, decylamino, 3,7-dimethyloctylamino, dodecylamino, cyclopentylamino, dicyclopentylamino, cyclohexylamino, dicyclohexylamino, pyrrolidyl, piperidyl, diphenylamino, (C₁-C₁₂ alkylphenyl)amino, di(C₁-C₁₂ alkylphenyl)amino, 1-naphthylamino, 2-naphthylamino, pyridylamino, pyridazinylamino, pyrimidylamino, pyrazinylamino, triazylamino, phenyl-C₁-C₁₂ alkylamino, C₁-C₁₂ alkylphenyl-C₁-C₁₂ alkylamino, di(C₁-C₁₂ alkylphenyl-C₁-C₁₂ alkyl)amino, 1-naphthyl-C₁-C₁₂ alkylamino, and 2-naphthyl-C₁-C₁₂ alkylamino.

In view of solubility in organic solvents and ease of synthesis, or for the reason of good balance between product characteristics and heat resistance in case of using the polymer of this invention for polymer LED, di-substituted amino groups such as dimethylamino, diethylamino, diphenylamino and di(C₁-C₁₂ alkylphenyl)amino are preferred. Diarylamino groups such as diphenylamino and di(C₁-C₁₂ alkylphenyl)amino are more preferred.

The substituted silyl group may be, for instance, a silyl group which has been substituted with one, two or three substituent groups selected frm alkyl, aryl, arylalkyl and monovalent heterocyclic groups. The carbon number of this substituted silyl group is usually about 1 to about 60, preferably 3 to 48.

Examples of this group are trimethylsilyl, triethylsilyl, tripropylsilyl, triisopropylsilyl, dimethylisopropylsilyl, diethylisopropylsilyl, t-butylsilyldimethylsilyl, pentyldimethylsilyl, hexyldimethylsilyl, heptyldimethylsilyl, octyldimethylsilyl, 2-ethylhexyl-dimethylsilyl, nonyldimethylsilyl, decyldimethylsilyl, 3,7-dimethyloctyl-dimethylsilyl, dodecyldimethylsilyl, phenyl-C₁-C₁₂ alkylsilyl, C₁-C₁₂ alkylphenyl-C₁-C₁₂ alkylsilyl, 1-naphthyl-C₁-C₁₂ alkylsilyl, 2-naphthyl-C₁-C₁₂ alkylsilyl, phenyl-C₁-C₁₂ alkyldimethylsilyl, triphenylsilyl, tri-p-methylphenylsilyl, tribenzylsilyl, diphenylmethylsilyl, t-butyldiphenylsilyl, and dimethylphenylsilyl.

In case the substituent represented by R or Ra contains an aryl group or a monovalent heterocyclic group, the hydrogen atom on such an aryl group or monovalent heterocyclic group may be substituted with an aryl, aralkyl, monovalent heterocyclic, arylalkenyl, arylalkynyl, alkoxy, aryloxy, aralkyloxy, alkylthio, arylthio, aralkylthio, substituted amino, substituted silyl, sulfonic, phosphonoic, cyano or nitro group. Of these substitute groups, aryl, aralkyl, monovalent heterocyclic, alkoxy, aryloxy, aralkyloxy, alkylthio, arylthio, aralkylthio, substituted amino, substituted silyl, phosphonic, phosphonoic, cyano and nitro groups are preferred. Among them, alkyl, aryl, aralkyl, monovalent heterocyclic, alkoxy, aryloxy, aralkyloxy, alkylthio, arylthio, aralkyllthio and substituted amino groups are more preferred, and alkoxy and alkythio groups are even more preferred.

More specific examples of the said substituted groups are the groups having C₁-C₁₂ alkoxy substitutents such as C₁-C₁₂ alkoxyphenyl, C₁-C₁₂ alkoxyphenyl-C₁-C₁₂ alkyl, C₁-C₁₂ alkoxyphenyl-C₂-C₁₂ alkenyl, C₁-C₁₂ alkoxyphenyl-C₂-C₁₂ alkynyl, C₁-C₁₂ alkoxyphenoxy, C₁-C₁₂ alkoxyphenyl-C₁-C₁₂ alkoxy, C₁-C₁₂ alkoxyphenylthio, C₁-C₁₂ alkoxyphenyl-C₁-C₁₂ alkylthio, C₁-C₁₂ alkoxyphenylamino, di (C₁-C₁₂ alkoxyphenyl)amino, C₁-C₁₂ alkoxyphenyl-C₁-C₁₂ alkylamino, di (C₁-C₁₂ alkoxyphenyl-C₁-C₁₂ alkyl)amino, and C₁-C₁₂ alkoxyphenyl-C₁-C₁₂ alkylsilyl. Examples of the C₁-C₁₂ alkoxyl groups are methoxy, ethoxy, propyloxy, isopropyloxy, n-butoxy, isobutoxy, s-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, and dodecyloxy.

In case the substituent represented by R or Ra has an alkylene chain, any -CH₂- group in this alkylene chain may be substituted with a divalent hetero-atom such as oxygen, sulfur or nitrogen, a divalent group containing a hetero-atom, or a divalent group comprising a combination of two or more of them. As examples of the said divalent hetero-atom or the divalent group containing a hetero-atom, the groups represented by the following formulae r-1 to r-9 can be refered to: 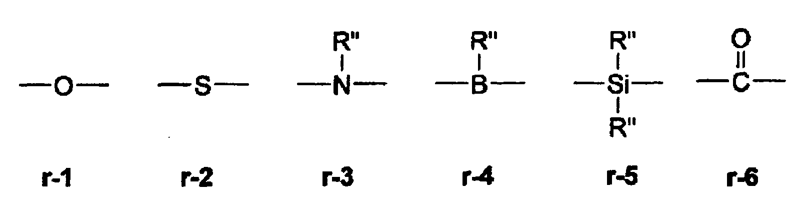 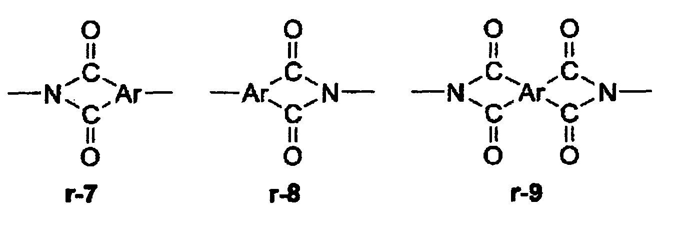 (wherein R" represents a substituent group selected from hydrogen atom, alkyl group, aryl group and monovalent heterocyclic group; and Ar represents a hydrocarbon group with a carbon number of 6 to 60.)

Examples of the divalent group comprising a combination of two or more of the said divalent hetero-atom or divalent group having a hetero-atom are the groups represented by the following formulae rr-1 to rr-4: 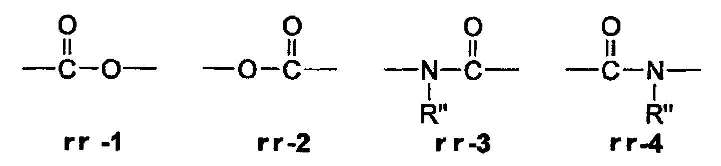 (wherein R" has the aforesaid significance).

Of the groups represented by the above-shown formulae r-1 to r-9, and rr-1 to rr-4, those represented by the formulae r-1, r-2, r-3, r-5 and r-6 are preferred, with those represented by the formulae r-1 and r-2 being more preferred and those represented by the formula r-1 even more preferred. Typical examples of such groups are methoxymethyloxy and 2-methoxyethyloxy groups.

Preferred examples of the substituent represented by R in the group represented by Ar¹ are alkyl, aryl, aralkyl, monovalent heterocyclic, alkoxy, aryloxy, aralkyloxy, alkylthio, arylthio, aralkylthio, substituted amino, substituted silyl, sulfonic, phosphonoic, cyano and nitro groups. Of these groups, alkyl, aryl, aralkyl, monovalent heterocyclic, alkoxy, aryloxy, aralkylthio, alkylthio, arylthio, aralkylthio and substituted amino groups are more preferred, and alkyl, alkoxy and alkylthio groups are even more preferred, with alkyl group being the most preferred.

As the substituent represented by Ra in the group represented by Ar¹, alkyl, aryl, aralkyl, monovalent heterocyclic, alkoxy, aryloxy, aralkyloxy, alkylthio, arylthio, aralkylthio, substituted amino, substituted silyl, oxy and thioxy groups are preferred, of which alkyl, alkoxy, alkylthio, alkylsilyl, oxy and thioxy groups are more preferred, and alkyl and alkoxy groups are even more preferred, with alkyl group being the most preferred.

We will now describe the process for producing a polymer having repeating units having a characteristic group(s) X represented by the above-shown formula (2) by using as a starting material a polymer having repeating units represented by the above-shown formula (1) and converting the C-H bond(s) on the aromatic ring.

In the repeating units represented by the formula (2) in the present invention, Ar² represents an arylene group, heterocyclic group or aromatic amine group having a valence of n + 2. Ar² has n characteristic groups X on the aromatic ring and may have a substitutent.

In the formula (2), n is an integer of 1 to 4, preferably 1 or 2, more preferably 1.

Examples of the arylene group having a valence of n + 2 are the arylene groups represented by the above-shown formulae 1A-1 to 1A-20.

In the formulae 1A-1 to 1A-20 designating Ar², R represents a hydrogen atom, a characteristic group X, a valence bond or a substituent. Any two of R's in the formulae represent a valence bond and one to n of R's indicates a characteristic group X. When there exist plural substituents represented by R, they may be identical or different from each other. When two Ra's exist on a same atom, they may be combined together to form an oxy or thioxo group or may be bonded to each other to form a ring.

As the heterocyclic group with a valence of n + 2 represented by Ar², there can be cited the heterocyclic groups represented by the above-shown formulae 2A-1 to 2A-53 and 2A-101 to 2A-116.

In the formulae 2A-1 to 2A-53 and 2A-101 to 2A-116 which represent Ar², R represents a hydrogen atom, a characteristic group X, a valence bond or a substituent. Any two of R's in the formulae represent a valence bond, and one to n of R's indicates a characteristic group X. When there exist plural substitutents represented by R, they may be identical or different from each other. Ra represents a hydrogen atom or a substituent. When there exist plural substituents represented by Ra, they may be identical or different from each other. When two Ra's exist on a same atom, they may be combined together to form an oxo or thioxo group or may be bonded to each other to form a ring.

As the aromatic amine group with a valence of n + 2 represented by Ar², the aromatic amine groups represented by the above-shown formulae 3A-1 to 3A-8 can be cited as examples.

In the formulae 3A-1 to 3A-8 representing Ar², R represents a hydrogen atom, a characteristic group X, a valence bond or a substitutent. Any two of R's in the formulae represent a valence bond, and one to n of R's designates a characteristic group X. When there exist plural substitutents represented by R, they may be identical or different from each other.

The substitutent represented by R may form, together with the substitutents on the adjoining atoms, a 5- to 7-membered aliphatic ring having a hetero-atom such as oxygen atom, sulfur atom or nitrogen atom, or a 5- to 7-membered aromatic ring which may have a hetero-atom such as oxygen atom, sulfur atom or nitrogen atom.

The substituents represented by R or Ra are not specifically defined as far as they do not substantially hinder the reaction in the step A and step B in the process of the present invention, but there may be cited as examples thereof the groups same as the substituents which may be possessed by the repeating units represented by Ar¹ in the formula (1).

The reaction for converting C-H bonds on the aromatic ring is not specifically defined as far as it won't substantially cause decomposition of the polymer having repeating units represented by the formula (1). This reaction may be, for instance, an aromatic electrophilic substitution reaction or an aromatic oxidation reaction, the former being preferred because of high degree of freedom of the introduced characteristic group. More preferred examples of the type of the reaction for converting C-H bonds on the aromatic ring are shown in Table 1 below.

**Table 1**

| Aromatic C-H bond conversion reactions | Groups formed |
|---|---|
| Halogenation | -Cl, -Br, -I |
| Nitration | -NO₂ |
| Friedel-Crafts alkylation | Alkyl group |
| Halomethylation | -CH₂Cl, -CH₂Br, -CH₂I |
| Friedel-Crafts acylation | Acyl group |
| Gattermann aldehyde synthesis | -CHO |
| Vilsmeier formylation | -CHO |

The reaction conditions will be described in further detail below. The halogenation reaction is carried out using a halogenating agent such as bromine, chlorine, iodine, iodine monochloride, N-chlorosuccinimide or N-bromosuccinimide in an amount equal to that of the halogen group to be introduced or in an excess amount not exceeding 10 equivalents. The reaction may be carried out by adding 0.01 to 50 equivalents of an acid such as acetic acid, sulfuric acid, trifluoroacetic acid or trifluoromethanesulfonic acid depending on the reactivity. As the solvent, an organic solvent such as chloroform, dichloromethane, 1,2-dichloroethane, N,N-dimethylformamide or tetrahydrofuran can be used advantageously, but an acid such as acetic acid or sulfuric acid may be used as solvent. The reaction can be let proceed at a temperature of usually 0 to 100°C. The reaction time is, for instance, 5 minutes to 100 hours, but any time will do as far as the reaction is allowed to proceed as desired. Since there is no need of standing for a long time after the completion of the reaction, the preferred reaction time is from 10 minutes to 50 hours. As for the concentration in carrying out the reaction, it should be noted that a too low concentration will worsen the reaction efficiency while a too high concentration may cause precipitation of the polymer to make it difficult to control the reaction. So, it should be selected properly within the range from about 0.01 wt% to the maximum concentration for dissolution. Usually, the concentration is in the range of 0.1 to 30 wt%. Regarding the halogenation method, reference is made, for instance, to Polymer, Vol. 30, p. 1137 (1989), and JP-A-2002-241493.

The nitration reaction is carried out properly at a temperature of from 0°C to boiling point using a nitrating reagent such as mixed acid, concentrated nitric acid or concentrated nitro-acetic acid.

The Friedel-Crafts alkylation, halomethylation and Friedel-Crafts acylataion reaction are carried out properly by reacting an alkylating reagent such as alkyl halide, terminal alkene or alcohol, formaldehyde and a halomethylating reagent such as hydrogen chloride or an acylating reagent such as an acid chloride, acid anhydride or carboxylic acid in the presence of an acid catalyst such as AlCl₃, FeCl₃, BF₃ or ZnCl₂ at a temperature of from room temperature to around 200°C. These reactions are described in, for instance, Organic Reactions, Vol. 2, p.114 (1944).

In the Gattermann aldehyde synthesis, formylation is carried out by acting, for instance, hydrogen cyanide, Zn(CN)₂, triazine or the like with hydrogen chloride or the like in the presence of a Lewis acid such as AlCl₃. This reaction is described in, for instance, Organic Reactions, Vol. 9, p. 37 (1957), and Chemical Review, Vol. 63, p. 526 (1963).

In the Vilsmeier formylation reacton, formylation can be accomplished by properly reacting 1 to 5 equivalents of POCl₃ in N,N-dimethylformamide at a temperature of from around -20°C to around 40°C. This reaction is described in, for instance, Shin Jikken Kagaku Koza (Lectures on New Experimental Chemistry), Vol. 14, p. 688 (1977).

The step (A) includes the reactions for converting the groups introduced by the respective reactions described above further into the characteristic groups by the pertinent reactions. Various known functional conversion reactions can be used for the said converting reactions, with some of the known conversion reactions being shown in Table 2 below.

**Table 2**

| Groups to be converted | Conversion reaction | Groups formed |
|---|---|---|
| -NO₂ | Reducing reaction | -NH₂ |
| -NH₂ | Diazotization reaction | Diazonium salt |
| Diazonium salt | Sandmeyer halogenation | Halogen atoms (-F, -Cl, -Br, -I) |
| Diazonium Salt | Oxidation | -OH |
| -OH | Sulfonation | -OSO₂Q¹ |
| Halogen atom | Metallization | -Z¹(Z²)m, -Sn(Q³)₃ |
| -Z¹(Z²)m | Boration | -B(OQ²)₂ |
| -Z¹(Z²)m | Oxidation hydrolysis | -OH |
| -Z¹(Z²)m | Formylation | -CHO |
| Methyl group | Halomethylation | Halomethyl group (-CH₂Cl, -CH₂Br, -CH₂I) |
| Halomethyl group | Iridation, conversion to Horner reagent | -CHQ⁴-P⁺(Q⁵)₃Z⁴, -CHQ⁶-P(=O)(OQ⁷)₂ |

A halogenation reaction is preferred for the conversion of C-H bond on the aromatic ring in view of reactivity and ease of control of the introduction rate.

After the end of the reaction, the reaction solution may be used as it is for the next reaction, but the polymer obtained after the reaction may be subjected to the ordinary separating, purifying, drying and other treatments such as pickling, alkali cleaning, neutralization, water washing, organic solvent cleaning, reprecipitation, centrifuging, extraction, column chromatography, etc., as occasion demands. For the improvement of yield of the next reaction, it is preferable to conduct separation, purification and drying.

In the repeating units of the formula (2) in the step A in the process of the present invention, the characteristic group X may be, for instance, a halogen atom, -OSO₂Q¹, -B(OQ²)₂, -Sn(Q³)₃, Z¹(Z²)m, -OH, -CH₂Z³, -CHQ⁴-P⁺(Q⁵)₃Z⁴, -CHQ⁶-P(=O) (OQ⁷)₂ or -C(=O) Q⁸.

In the above formulae, Q¹ is a hydrocarbon group, and Q² is a hydrogen atom or a hydrocarbon group. Two Q²'s may be identical or different from each other and may be bonded to each other to form a ring. Q³ is a hydrocarbon group, and three Q³'s may be identical or different from each other. Q⁴ is a hydrogen atom or a hydrocarbon group, and Q⁵ is a hydrocarbon group. Three Q⁵'s may be identical or different from each other. Q⁶ is a hydrogen atom or a hydrocarbon group. Q⁷ is a hydrocarbon group, and two Q⁷'s may be identical or different from each other. Q⁸ is a hydrogen atom or a hydrocarbon group. Z¹ is a metal atom or a metal ion, Z² is a counter anion, m is an integer of 0 or greater, Z³ is a halogen atom or a cyano group, and Z⁴ is a monovalent counter anion.

The reactions mentioned in Table 2 are explained in further detail.

It is known that -NO₂ group can be reduced to -NH₂ group by acting a metal such as zinc, iron or tin with an acid such as hydrochloric acid.

It is also known that -NH₂ group can be turned into a diazonium salt by, for instance, diazotizing this group with nitrous acid purified by acting NaNO₂ with an acid such as hydrochloric acid.

It is known that the diazonium salt can be converted into a halogen atom by, for instance, acting hydrochloric acid, hydrobromic acid or the like in the presence of copper halide (I) through a Sandmeyer reaction. This reaction is described in, for instance, Organic Synthesis, Collective Volume, Vol. 3, p. 185 (1955), and Organic Synthesis Collective Volume, Vol. 5, p. 133 (1973). It is known that the diazonium salt can be converted into -OH group by heating it in the presence of water under an acidic condition.

Concerning the reaction for converting a halogen atom into -Z¹(Z²)m group, it is known that this halogen atom can be lithionized by a lithionizing reagent such as n-alkyllithium. It is also known that this halogen atom can be converted into a magnesium halide group, zinc halide group or such by a metallizing reaction in which metallic magnesium, zinc or the like is acted, or a Grignard conversion reaction using isopropyl(i-Pr)MgCl. This reaction is described in, for instance, Angew. Chem. Int. Ed. Vol. 37, p. 1701 (1988). The Grignard reaction is discussed in, for instance, Bulletin of Chemical Society of Japan, Vo. 51, p. 2091 (1978), and Chemical Letters, p. 353 (1977).

It is further known that the halogen atom can be converted into a group represented by -Sn(Q³)₃ by acting hexaalkyldistannane in the presence of a palladium catalyst. This reaction is reviewed in, for instance, Angew. Chem. Int. Ed. Vol. 25, p. 508 (1986).

It is known that a group represented by -Z¹(Z²)m, such as -Li, -MgCl or -MgBr group, can be transformed into -B(OH)₂ group by, for instance, hydrolyzing it by acting trimethoxyboran. It is also known that this -Z¹(Z²)m group can be turned into a boric ester group by acting isopropoxypinacolboran. This reaction is described in, for instance, Journal of American Chemical Society, Vol. 126, p. 7041 (2004).

It is known that the -Z¹(Z²)m group such as -Li, -MgCl or -MgBr can be also converted into -OH group by, for instance, conducting oxidative destruction with hydrogen peroxide after acting trialkoxyboran.

It is also known that this -Z¹(Z²)m group can be converted into -CHO group by, for instance, acting DMF or N-formylpiperidine. This reaction is mentioned in, for instance, Synthesis, p. 228 (1984).

It is known that a methyl group can be converted into a halomethyl group such as -CH₂Cl or -CH₂Br by acting SOCl₂, SOBr₂ or the like, and it is also known that a halomethyl group can be turned into a group represented by -CHQ⁴-P⁺(Q⁵)₃Z⁴ by acting triphenylphosphine. It can be also rendered into a group represented by -CHQ⁶-P(=O)(OQ⁷)₂ by acting trialkyl phosphite or the like through an Arbuzov reaction.

Regarding the characteristic group X in the repeating units of the above-shown formula (2), this group can be, for instance, a halogen atom, the preferred examples thereof being fluorine atom, chlorine atom, bromine atom and iodine atom, of which chlorine atom and bromine atom are more preferred, with bromine atom being the most preferred.

As the hydrocarbon group among the groups represented by Q¹, Q², Q³, Q⁴, Q⁵, Q⁶, Q⁷ and Q⁸ in the above-shown formulae, the following can be cited as examples: alkyl groups with a carbon number of around 1 to around 50 such as methyl, ethyl, propyl, isopropyl, n-butyl, isobutyl, t-butyl, pentyl, hexyl, nonyl, dodecyl, pentadecyl, octadecyl and dococyl; cyclic saturated hydrocarbon groups with a carbon number of around 3 to around 50 such as cyclopropyl, cyclobutyl, cyclobutyl, cyclopentyl, cyclohexyl, cyclononyl, cyclododecyl, norbonyl and adamantly; alkenyl groups with a carbon number of around 2 to around 50 such as ethenyl, propenyl, 3-butenyl, 2-butenyl, 2-pentenyl, 2-hexenyl, 2-noneyl and 2-dodecenyl; aryl groups with a carbon number of around 6 to around 50 such as phenyl, 1-naphthyl, 2-naphthyl, 2-methylphenyl, 3-methylphenyl, 4-methylphenyl, 4-ethylphenyl, 4-propylphenyl, 4-isopropylphenyl, 4-butylphenyl, 4-t-butylphenyl, 4-hexylphenyl, 4-cyclohexylphenyl, 4-adamantylphenyl and 4-phenylphenyl; and aralkyl groups with a carbon number of around 7 to around 50 such as phenylmethyl, 1-phenyleneethyl, 2-phenylethyl, 1-phenyl-1-propyl, 1-phenyl-2-propyl, 2-phenyl-2-propyl, 1-phenyl-3-propyl, 1-phenyl-4-butyl, 1-phenyl-5-pentyl, and 1-phenyl-6-hexyl. These hydrocarbon groups are preferably those with a carbon number of 1 to 20. Those with a carbon number of 1 to 12 are more preferred, and those with a carbon number of 1 to 8 are even more preferred. These hydrocarbon groups may have a substituent.

Q¹ in the formula -OSO₂Q¹ designates a hydrocarbon group which may have a substitutent. As such a hydrocarbon group, can be cited.

Examples of the groups represented by -OSO₂Q¹ are alkyl sulfonate groups such as methane sulfonate, ethane sulfonate and trifluoromethane sulfonate, aryl sulfonate groups such as benzene sulfonate, p-toluene sulfonate, p-nitrobenzene sulfonate and o-nitrobenzene sulfonaate, and arylalkyl sulfonate groups such as benzil sulfonate. Of these groups, trifluoromethane sulfonate, benzene sulfonate, p-toluene sulfonate and p-nitrobenzene sulfonate are preferred, and trifluoromethane sulfonate is more preferred.

Q² in the formula -B(OQ²)₂ is a hydrogen atom or a hydrocarbon group which may have a substituent. Two Q²'s may be identical or different from each other, and may be bonded to each other to form a ring. The above-mentioned hydrocarbon groups can be cited as examples of Q². Of these hydrocarbon groups, alkyl is preferred, and methyl, ethyl, propyl, isopropyl, n-butyl, isobutyl, pentyl, hexyl and nonyl are more preferred, with methyl, ethyl, propyl, n-butyl, pentyl and hexyl being even more preferred. In case two Q²'s are bonded to form a ring, the bifunctional hydrocarbon group comprising these two Q²'s is preferably selected from 1,2-ethylene, 1,1,2,2-tetramethyl-1,2-ethylene, 1,3-propylene, 2,2-dimethyl-1,3-propylene and 1,2-phenylene. Amino group can be cited as an example of the substituent.

Examples of the groups represented by -B(OQ²)₂ include those designated by the following formulae:

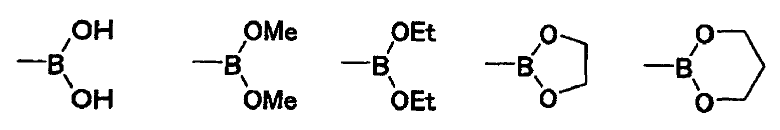

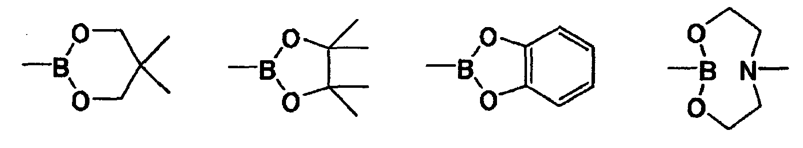

Q³ in the formula -Sn(Q³)₃ represents a hydrocarbon group which may have a substituent, and three Q³'s may be identical or different from each other. The above-shown hydrocarbon groups can be cited as examples of Q³, of which alkyl is preferred, and methyl, ethyl, propyl, isopropyl, n-butyl, isobutyl, pentyl, hexyl and nonyl are more preferred. Methyl, ethyl, propyl, n-butyl, pentyl and hexyl are even more preferred. Amino group and alkoxyl group can be cited as examples of the substituent.

Examples of the groups represented by -Sn(Q³)₃ are tri(n-butyl)tin group and triphenyltin group.

Z¹ in the formula Z¹(Z²)m is a metal atom or a metal ion, Z² is a counter anion, and m is an integer of 0 or greater. Examples of the metal atoms or metal ions represented by this formula are the atoms or ions of Li, Na, K, Rb, Cs, Be, Mg, Ca, Sr, Ba, Al, Ga, In, Tl, Pb, Sc, Ti, V, Cr, Mn, Fe, Co, Ni, Cu, Zn, Y, Zr, Nb, Mo, Tc, Ru, Rh, Ag, Cd, La, Ce, Sm, Eu, Hf, Ta, W, Re, Os, Ir, Pt, Au and Hg. Of these metals, Li, Na, K, Rb, Cs, Be, Mg, Ca, Sr, Ba, Al, Ga, In, Tl, Pb, Sc, Ti, Cu, Zn, Y, Zr, Ag and Hg are preferred, and Li, Na, K, Rb, Cs, Be, Mg, Ca, In, Tl, Pb, Cu, Zn, ZSr, Ag and Hg are more preferred. Li, Na, K, Mg, Ca, cu and Zn are even more preferred.

Conjugated bases of Brønsted acid are usually used as Z². Examples of such conjugated bases are fluoride ion, chloride ion, bromide ion, iodide ion, sulfate ion, nitrate ion, carbonate ion, perchloride ion, tetrafluoroborate ion, hexafluorophosphite ion, methanesulfonate ion, trifluoromethanesulfonate ion, toluenesulfonate ion, acetate ion, trifluoroacetate ion, propionate ion, benzoate ion, hydroxide ion, oxide ion, methoxide ion, and ethoxide ion. Preferred among them are chloride ion, bromide ion, iodide ion, sulfate ion, nitrate ion, carbonate ion, methanesulfonate ion, trifluoromethanesulfonate ion, toluenesulfonate ion, acetate ion, trifluoroacetate ion, propionate ion, and benzoate ion. More preferred are chloride ion, bromide ion, iodide ion, methanesulfonate ion, trifluoromethanesulfonate ion, toluenesulfonate ion, acetate ion, trifluoroacetate ion, propionate ion, and benzoate ion. Even more preferred are chloride ion, bromide ion, iodide ion, methanesulfonate ion, trifluoromethanesulfonate ion, acetate ion, and trifluoroacetate ion.

In the formula Z¹(Z²)m, m is an integer which is decided so that the aromatic compound represented by the above-shown general formula (1) will become electrically neutral. In case the characteristic group X is Z¹(Z²)m, that is, when the repeating units represented by the above-shown general formula (2) are defined by the following formula (2-2): 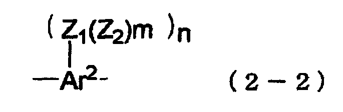 preferably the portion of Z¹(Z²)m is assumed to have a valence of + 1 and the portion indicated by the following formula (2-3):

[-Ar²-] (2-3)

is assumed to have a valence of - 1 while also assuming that the portion of Z¹(Z²) m and the remaining portion are ion bonded.

As the atomic groups represented by the formula Z¹(Z²)m, zinc halide groups, alkaline metal atoms and halogenated alkaline earth metal groups can be cited as examples. Examples of the zinc halide groups are zinc chloride group, zinc bromide group and zinc iodide group, the first mentioned two being preferred. Examples of the alkaline metal atoms are lithium atom, sodium atom, potassium atom, etc., of which lithium atom and sodium atom are preferred. Examples of the halogenated alkaline earth metal groups are magnesium chloride group, magnesium bromide group, magnesium iodide group, calcium chloride group, calcium bromide group, and calcium iodide group, of which magnesium chloride group, magnesium bromide group and magnesium iodide group are preferred.

Z³ in the formula -CH₂Z³ represents a halogen atom or a cyano group. Examples of the halogen atoms represented by Z³ are chlorine atom, bromine atom and iodine atom, of which chlorine atom and bromine atom are preferred.

Q⁴ in the formula -CHQ⁴-P⁺(Q⁵)₃Z⁴ is a hydrogen atom or a hydrocarbon group. The above-mentioned hydrocarbon groups can be cited as examples of the hydrocarbon group represented by Z⁴, with methyl, ethyl, propyl, n-butyl, hexyl and octyl being preferred. Q⁵ is a hydrocarbon group which may have a substituent, and three Q^{5'}s may be identical or different from each other. As examples of this hydrocarbon group, there can be cited the same hydrocarbon groups as mentioned abvoe, with methyl, ethyl, propyl, n-butyl and phenyl being preferred. Z⁴ represents a monovalent counter anion. Usually a conjugated base of a Brφnsted acid is used as such a counter anion, the examples thereof being fluoride ion, chloride ion, bromide ion, iodide ion, sulfate ion, nitrate ion, carbonate ion, perchlorate ion, tetrafluoroborate ion, hexafluorophosphite ion, methanesulfonate ion, trifluoromethanesulfonate ion, toluenesulfonate ion, acetate ion, trifluoroacetatte ion, propionate ion, benzoate ion, hydroxide ion, oxide ion, methoxide ion, and ethoxide ion, of which chloride ion, bromide ion, iodide ion, tetrafluoroborate ion and trifluoromethanesulfonate ion are preferred, and chloride ion and bromide ion are more preferred. The following can be presented as examples of the groups represented by the formula -CHQ⁴-P⁺(Q⁵)₃Z⁴:

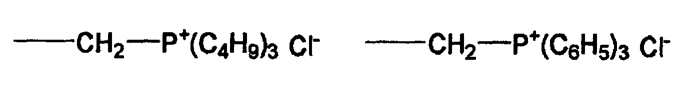

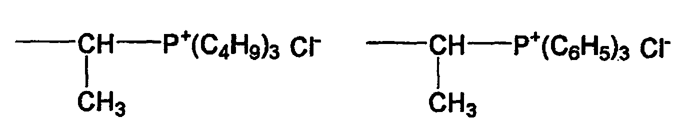

-CH₂-P⁺(C₄H₉)₃ Br⁻ -CH₂-P⁺(C₆H₅)₃ Br⁻

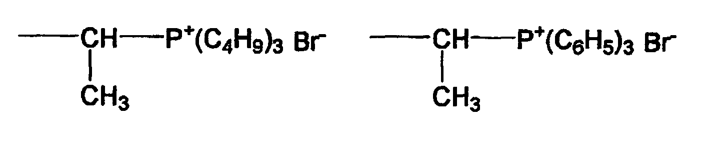

Q⁶ in the formula -CHQ⁶-P(=O) (OQ⁷)₂ is a hydrogen atom or a hydrocarbon group. The above-mentioned hydrocarbon groups can be cited as examples of the hydrocarbon group represented by Q⁶. Of these hydrocarbon groups, methyl, ethyl, propyl, n-butyl, hexyl and octyl are preferred. Q⁷ is a hydrocarbon group which may have a substituent. Two Q⁷ may be identical or different from each other. As examples of this hydrocarbon group, the aforementioned ones can be cited, of which methyl, ethyl, propyl, n-butyl and phenyl groups are preferred.

Q⁸ in the formula -C(=O)Q⁸ is a hydrogen atom or a hydrocarbon group, the examples thereof being the aforementioned ones, of which methyl, ethyl, propyl, n-butyl, hexyl, octyl, phenyl and benzyl are preferred. Examples of the group represented by -C(=O)Q⁸ are formyl, acetyl, benzoyl and benzylcarbonyl, of which formyl and benzoyl are preferred.

The characteristic group X in the polymer having repeating units with a characteristic group X produced in the step (A) in the process of the present invention is not specifically defined as far as it reacts with the characteristic group Y in the step (B). However, in view of ease of synthesis, this characteristic group X is preferably selected from a halogen atom, -OSO₂Q¹, -B(OQ²)₂, Z¹(Z²)m, -CH₂Z³, -CHQ⁴-P⁺(Q⁵)₃Z⁴, -CHQ⁶-P (=O) (OQ⁷) and -C(=O)Q⁸. For the reactivity at the time of introduction and ease of control of the introduction rate, a halogen atom and the groups derived therefrom such as -OSO₂Q¹, -B(OQ²)₂, -Sn(Q³)₃, Z¹(Z²)m, -OH and -C(=O)Q⁸ are preferred. From the viewpoint of reactivity in the step B, halogen atom, -OSO₂Q¹, -B(OQ²)₂, -Sn(Q³)₃, Z¹(Z²)ₘ and -CHO are more preferred, with halogen atom being the most preferred.

The polymer having repeating units with a characteristic group(s) produced in the step (A) of the present invention is not designated in its molecular weight, but in view of solubility in the organic solvents in the reaction, it is preferable that typically the polystyrene-reduced number-average molecular weight (Mn) of the polymer is in the range of 10³ to 10⁸, more preferably 5 x 10³ to 5 x 10⁷.

Regarding the polymer having repeating units with a characteristic group(s) X produced in the step (A) in the process of the present invention, the total of the repeating units represented by the formula (2) is preferably 0.5 to 100 mol%, more preferably 2 to 100 mol% of the overall repeating units.

Also regarding this polymer, it is preferable that the total of the repeating units represented by the formula (2) and those represented by the formula (1) is 50 mol% or more of the overall repeating units possessed by the polymer, and that the repeating units represented by the formula (2) are 2 to 90 mol% of the total of the repeating units represented by the formula (2) and those represented by the formula (1).

The above polymer may have the repeating units other than those represented by the formulae (1) and (2). Also, the repeating units may be bonded at the vinylene or nonconjugated portion. Such a vinylene or nonconjugated portion may be contained in the repeating units. The bond structure having a nonconjugated portion may be, for instance, any of those shown below by the formulae X-1 to X-15, or a combination of any of them with a vinylene group, or a combination of two or more of those shown below: 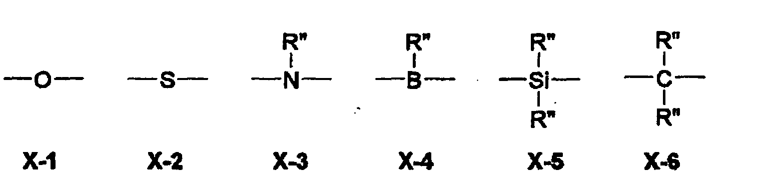 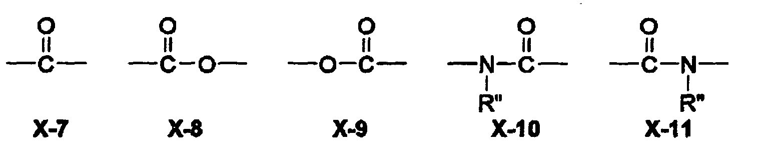 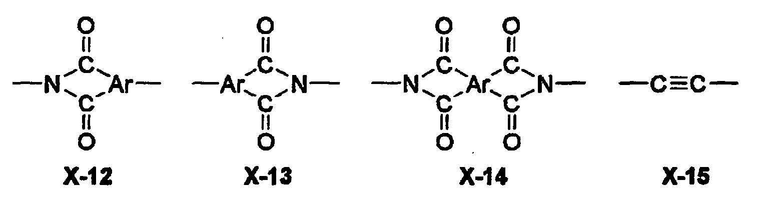 (wherein R" and Ar have the same meaning as defined above).

Among the linking groups having a nonconjugated portion indicated by any of the above-shown formulae X-1 to X-15, those indicated by X-3, X-5, X-6 and X-12 to X-15 are preferred, those indicated by X-3, X-5, X-6 and X-12 to X-14 are more preferred, and those indicated by X-3, X-5 and X-6 are even more preferred.

In the polymer having repeating units with a characteristic group(s) X produced in the step (A) in the process of the present invention, the ratio of the total number of the bonding groups having vinylene and said nonconjugated portion, which are contained beside the repeating units represented by the formulae (1) and (2), is preferably 30% or less, more preferably 20% or less, even more preferably 10% or less of the total number of the whole repeating units. Most preferably, the polymer has no linking group containing vinylene and nonconjugated portion.

The polymer having repeating units with a characteristic group X produced in the step (A) in the process of the present invention may be a random, block or graft copolymer, or may be a polymer having an intermediate structure, for example, a block-oriented random copolymer. It also includes the type of polymers in which the backbone is branched and which have three or more terminals, and dendrimers.

Now the step (B) in the process of the present invention is explained.

The step (B) in the process of the present invention is a step in which the polymer having the characteristic group X produced in the step (A) is reacted with a compound having a characteristic group Y which reacts with the characteristic group X to form a bond.

As the compound having a characteristic group Y used in the step (B), there can be presented as examples the low-molecular weight compounds, oligomers, polymers, dendrimers and the compounds having a metal complex structure. Preferred of these compounds are those represented by the following formulae (3), (4) and (5):

Y-G-A¹ (3)

(wherein Y has the same meaning as defined above; G represents a C₁-C₂₀ alkyl chain which may have a direct bond or a linear or branched structure or a cyclic structure; and A¹ represents a monovalent organic group which has therein no characteristic group which reacts substantially with the characteristic groups X and Y to form a bond).

Y-G-A²-X² (4)

(wherein Y and G have the same meaning as defined above; X² represents a characteristic group which reacts with the characteristic group Y to form a bond, with its definition being the same as that of the characteristic group X; X and X² may be identical or different from each other; and A² represents a divalent organic group which has therein no characteristic group which reacts substantially with the characteristic groups X, Y and X² to form a bond).

Y-G-A³-G-Y (5)

(wherein Y and G have independently the same meaning as defined above; and A³ represents a divalent organic group which has therein no characteristic group which reacts substantially with the characteristic groups X and Y to form a bond).

Examples of the monovalent organic groups represented by A¹ in the above formula (3) are aryl group, monovalent heterocyclic group, monovalent aromatic amine group, monovalent aromatic oligomer group which may have a liner or branched structdure, monovalent aromatic polymer group which may have a linear or branched structure, and aromatic dendrimer group.

In the above formulae (4) and (5), the divalent organic groups represented by A² and A³ include, for instance, arylene group, divalent heterocyclic group, divalent aromatic amine group, divalent aromatic oligomer group which may have a linear or branched structure, and divalent aromatic polymer group which may have a linear or branched structure.

G's represent independently a direct bond or a C₁-C₂₀ alkyl chain which may have a linear or branched structure or may have a cyclic structure. Examples of such C₁-C₂₀ alkyl chain are methylene, ethylene, propyl-1,3-diyl, butyl-1,4-diyl, pentyl-1,5-diyl, hexyl-1,6-diyl, octyl-1,8-diyl, decyl-1,10-diyl, octadecyl-1,18-diyl, butyl-2,3-diyl, 3,7-dimethyloctyl-1,8-diyl, cyclohexyl-1,4-diyl, and cyclohexyl-1,4-dimethyl-1',1"-diyl. In case G represents an alkyl chain, it may be cut off by a group having a hetero-atom. This hetero-atom is, for instance, oxygen atom, sulfur atom or nitrogen atom. The groups shown above by the formulae X-1 to X-10 may be presented as examples of the groups having a hetero-atom.

As the group having a hetero-atom which cuts off the alkyl chain, the groups indicated by the formulae X-1 to X-5 are preferred, those indicated by the formulae X-1 to X-3 and X-5 are more preferred, and those indicated by the formulae X-1 and X-2 are even more preferred.

G represents a direct bond or a C₁-C₂₀ alkyl chain which may have a linear or branched structure, or may have a cyclic structure. It is preferably a direct bond or a linear alkyl chain, the former being more preferred.

In the divalent organic groups represented by A² and A³, arylene group is an atomic group comprising an aromatic hydrocarbon with its two hydrogen atoms eliminated. It includes the groups having a condensed ring and those in which the indepenedent benzene rings or two or more condensed rings are bonded directly or through a group such as vinylene. The arylene group may have a substituent. Examples of the substituent which the arylene group may possess are alkyl, aryl, aralkyl, monovalent heterocyclic, arylalkenyl, arylalkynyl, alkoxy, aryloxy, aralkyloxy, alkylthio, arylthio, aralkylthio, arylamino, hydrocarbonsilyl, cyano and nitro groups. The carbon number of the portion exclusive of the substituent in the arylene group is ususlly about 6 to about 60, preferably 6 to 20. The total carbon number including the substituent of the arylene group is usually about 6 to about 100. The arylene group may be of a structure such as shown above by the formulae 1A-1 to 1A-20. Regarding the arylene groups represented by A² and A³, R in the above-shown formulae 1A-1 to 1A-20 represents a hydrogen atom, a valence bond or a substituent. Any two of R's designate a valence bond. When there exist plural substituents represented by R, they may be identical or different from each other, and may form, together with the substituents on the adjoining atoms, a 5- to 7-membered aliphatic ring or 5- to 7-membered aromatic ring which may have a hetero-atom such as oxygen atom, sulfur atom or nitrogen atom. Ra represents a hydrogen atom or a substituent. When there exist plural substituents represented by Ra, they may be identical or different from each other. In case two Ra's exist on a same atom, they may be combined together to form an oxo or thioxo group, or may be bonded to each other to form a ring.

Regarding the arylene groups represented by A¹, of those indicated by the above-shown formulae 1A-1 to 1A-14, phenylene (1A-1), naphthalene-diyl (1A-2), fluorene-diyl (1A-13), benzofluorene-diyl (1A-14), biphenylene (1A-15), terphenylene (1A-16 to 1A-18), stilbene -diyl (1A-19) and distilbene-diyl (1A-20) are preferred, of which phenylene (1A-1), naphthalene-diyl (1A-2), fluorene-diyl (1A-13) and benzofluorene-diyl (1A-14) are more preferred.

In the divalent organic groups represented by A² and A³, the divalent heterocyclic group is an atomic group comprising a heterocyclic compound having its two hydrogen atoms eliminated. It includes the groups having a condensed ring and those in which the independent monocyclic heterocyclic compounds or two or more condensed rings are bonded directly or through a group such as vinylene. It also includes the groups having a heterocyclic compound combined with an aromatic hydrocarbon. The divalent heterocyclic group may have a substituent. Examples of the substituents which the divalent heterocyclic group may have are alkyl, aryl, aralkyl, monovalent heterocyclic, arylalkenyl, arylalkynyl, alkoxy, aryloxy, aralkyloxy, alkylthio, arylthio, aralkylthio, arylamino, hydrocarbonsilyl, cyano and nitro groups. The carbon number of the portion exclusive of the substituent in the divalent heterocyclic group is usually about 4 to about 60, preferably 2 to 20. The total carbon number including the substituent of the divalent heterocyclic group is usually about 2 to about 100. Here, "heterocyclic compound" refers to those of the organic compounds having a cyclic structure in which the elements constituting the ring are not only the carbon atoms but also include in the ring a hetero-atom such as oxygen, sulfur, nitrogen, phosphorus, boron or the like. The divalent heterocyclic groups are, for instance, of the structures indicated by the above-shown formulae 2A-1 to 2A-68 and the following formulae 4A-1 to 4A-4.

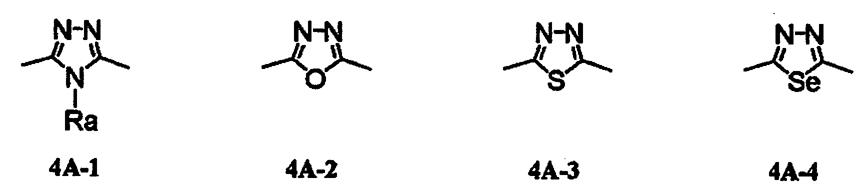

Here, regarding the monovalent heterocyclic groups represented by A² and A³, R in the formula 2A-1 to 2A-68 represents a hydrogen atom, a valence bond or a substituent. Any two of R's are a valence bond. When there exist plural substituents represented by R, they may be identical or different from each other, and may form, together with the substituents on the adjoining atoms, a 5- to 7-membered aliphatic ring having a hetero-atom such as oxygen atom, sulfur atom or nitrogen atom, or a 5- to 7-membered aromatic ring which may have a hetero-atom such as oxygen atom, sulfur atom or nitrogen atom. When two Ra's exist on a same atom, they may be combined to form an oxo or thioxo group or may be bonded to each other to form a ring. Ra represents a hydrogen ataom or a substituent. When there exist plural substituents represented by Ra, they may be identical or different from each other.

In the divalent organic groups represented by A² and A³, "divalent aromatic amine group" is an atomic group which is left after elimination of two hydrogen atoms from an aromatic amine. This divalent aromatic amine group may have a substituent. Examples of the substituents that may be possessed by this group are alkyl, aryl, aralkyl, monovalent heterocyclic, arylalkenyl, arylalkynyl, alkoxy, aryloxy, aralkyloxy, alkylthio, arylthio, aralkylthio, arylamino, hydrocarbonsilyl, cyano and nitro groups. The carbon number of the portion exclusive of the substituent in the divalent aromatic amine group is usually about 4 to about 60. As examples of the divalent aromatic amine group, there can be cited, for instance, the groups shown above by the general formula (1-2), more specifically those indicated by the formulae 3A-1 to 3A-8. In the formulae 3A-1 to 3A-8 of the groups represented by A² and A³, R designates a hydrogen atom, a valence bond or a substituent. Any two of R's represent a valence bond. When there exist plural substituents represented by R, they may be identical or different from each other, and may form, together with the substituents on the adjoining atoms, a 5- to 7-membered aliphatic ring having a hetero-atom such as oxygen atom, sulfur atom or nitrogen atom, or a 5- to 7-membered aromatic ring which may have a hetero-atom such as oxygen atom, sulfur atom or nitrogen atom.

In the divalent organic groups represented by A² and A³, the divalent aromatic oligomer groups which may have a linear or branched structure and the divalent aromatic polymer groups which may have a linear or branched structure include, for example, arylene groups, divalent heterocyclic groups, and the groups in which two or more of divalent aromatic amine groups are bonded directly or with the interposition of a divalent linking group or a p-valent branched group.

Here, k is an integer of 3 to 6.

As examples of the divalent linking groups, there can be cited C₁-C₂₀ alkyl chains which may have a linear or branched structure or may also have a cyclic structure and which are represented by G mentioned above, the groups indicated by the formulae X-1 to X-15, combinations of these groups with a vinylene group, and combinations of two or more of said groups X-1 to X-15. Here, R" and Ar have the same meaning as defined above.

As the divalent linking group, a C₁-C₂₀ alkyl chain which may have a linear or branched structure or may also have a cyclic structure, represented by G, is preferred, a linear alkyl chain is more preferred, and a linear C₁-C₈ alkyl chain is even more preferred.

Exemplary of the p-valent branched groups are the groups designated by the above-shown formulae 1A-1 to 1A-20, 2A-1 to 2A-68, and 3A-1 to 3A-8 in which R represents a hydrogen atom, a valence bond or a substituent, and any p of R's designate a valence bond. When there exist plural substituents represented by R, they may be identical or different from each other, and may form, together with the substituents on the adjoining atoms, a 5- to 7-membered alipharic ring having a hetero-atom such as oxygen atom, sulfur atom or nitrogen atom, or a 5- to 7-membered aromatic ring which may have a hetero-atom such as oxygen atom, sulfur atom or nitrogen atom. Ra represents a hydrogen atom or a substituent. When there exist plural substituents represented by Ra, they may be identical or different from each other. When two Ra's exist on a same atom, they may be combined to form an oxo or thioxo group, or may be bonded to each other to form a ring.

Regarding the divalent organic groups represented by A² and A³, as the divalent aromatic oligomer groups which may have a linear or branched structure and the divalent aromatic polymer groups which may have a linear or branched structure, those in which two or more of arylene group, divalent heterocyclic group and divalent aromatic amine group are directly bonded are preferred.

As for the definition and examples of the monovalent organic groups represented by A¹, they are defined and exemplified as the ones in which one hydrogen atom is bonded to the divalent organic groups represented by A² and A³ mentioned above.

Regarding the compounds having a characteristic group Y represented by the formulae (3), (4) and (5), there may be used only one type of the compounds represented by these formulae or one or more types of these compounds selected independently. In case of using a compound of the formula (4), it is preferably used in combinatioin with a compound of the formula (3).

From the viewpoint of production of a polymer having a more intricate structure, in case of using a compound having a characteristic group Y represented by the formula (5), it is suggested to use with it a compound represented by the following formula (6):

X³-A⁴-X⁴ (6)

(wherein X³ and X⁴ represent independently a characteristic group which reacts with the characteristic group Y to form a bond, and their definition is the same as given with X above; X, X³ and X⁴ may be identical or different from each other; and A⁴ represents a divalent organic group which has therein no characteristic group which substantially reacts with the characteristic group X, Y, X³ or X⁴ to form a bond).

The definition and examples of the divalent organic group represented by A⁴ in the formula (6) are the same as those given with the divalent organic group represented by A³.

From the viewpoint of control of gelation by formation of a crosslinked structure, in case of using a compound having a characteristic group Y represented by the formula (5), it is suggested to use therewith a compound of the formula (3) in addition to a compound of the formula (6).

From the viewpoint of synthesizing a side chain having a branched structure, a compound represented by the following formula (7) may be used in addition to a compound of the formula (3), (4), (5) or (6): 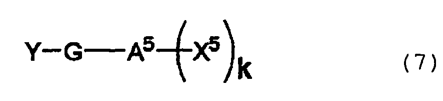 (wherein Y and G have the same significance as defined above; X⁵ represents a characteristic group which reacts with the characteristic group Y to form a bond; and A⁵ represents an organic group with a valence of k + 1 which has therein no characteristic group which substantially reacts with the characteristic group X, Y, X¹, X², X³, X⁴ or X⁵ to form a bond).

The k + 2 valent organic group represented by A⁴ in the formula (7) is defined as an atomic group which is left after elimination of k hydrogen atoms or substituents from the divalent organic group represented by A² or A³.

A compound represented by the formula (3) or (4) is preferred for inhibiting gelation of the polymer due to formation of a crosslinked structure, and a compound represented by the formula (3) is preferred for controlling the side chain structure more precisely.

The characteristic group Y is subject to no specific restrictions as far as it reacts with the characteristic group X to form a bond. Examples of the characteristic group Y are halogen atom, -OSO₂Q¹, -B(OQ²)₂, -Sn(Q³)3, Z¹(Z²)m, -OH, -CH₂Z³, -CHQ⁴-P⁺(Q⁵)₃Z⁴, -CHQ⁶-P(=O) (OQ⁷)₂, -C(=O)Q⁸, -CHQ⁹=CHQ¹⁰, -C=CH, -NHQ¹¹ and -SH (wherein Q¹ to Q⁸, Z¹ to Z⁴, and m have the same meaning as defined above; and Q⁹, Q¹⁰ and Q¹¹ each represents a hydrogen atom or a hydrocarbon group). Examples of the possible combinations of the characteristic groups X and y and the reaction methods are shown in the following Table 3.

**Table 3**

| Characteristic group (Y) | Characteristic group (X) | Reaction method | Bond formed |
|---|---|---|---|
| Halogen atom, -OSO₂Q¹ | Halogen atom, -OSO₂Q¹ | Aryl-aryl coupling reaction using Ni(O) (Yamamoto reaction) | Aryl-aryl direct bond |
| Halogen atom, -OSO₂Q1 | -B(OQ²)₂ | Suzuki coupling reaction | Aryl-aryl direct bond, Aryl-carbon single bond |
| Halogen atom, -OSO₂Q¹ | -Sn(Q³)₃ | Stille coupling reaction | Aryl-aryl direct bond |
| Halogen atom, -OSO₂Q¹ | -Z¹(Z²)m -Z¹ (Z²)m | Grignrad coupling reaction Negishi coupling reaction | Aryl-aryl direct bond, single bond |
| -C(=O)Q⁸ | -CHQ⁴-P⁺ (Q⁵)₃ Z⁴ -CHQ⁵-P (=O) (OQ⁷)₂ | Horner-Wadsworth-Emmons reaction Witting reaction | Carbon-carbon double bond |
| -C(=O)Q⁸ | -C(=O)Q⁸ | McMurry reaction | Carbon-carbon double bond |
| Halogen atom | -CHQ⁹=CHQ¹⁰, | Heck reaction | Carbon-carbon double bond |
| Halogen atom | -C≡CH | Sonogashira reaction | Carbon-carbon triple bond |
| -C(=O)Q⁸ | -CH₂Z³ | Knoevenagel reaction | Carbon-carbon double bond |
| -OH, -SH | -COOH, -COCl | Condensation | Ester bond |
| -NH | -COOH, -COCl | Condensation | Amide bond |
| -CH₂Z³ | -CH₂Z³ | Dehydrohalogenation | Carbon-carbon double bond |

As the reaction method used for the reaction of the characteristic groups X and Y, the methods comprising the aryl-aryl coupling reaction using a zero-valent nickel complex, the Wittig reaction, the reaction by the Horner-Wadsworth-Emmons method, the Knoevenagel reaction, the Zuzuki coupling reaction, the Grignard coupling reaction, the Negishi coupling reaction and the Stille coupling reaction are preferred in terms of high reactivity. Especially, the methods comprising the Wittig reaction, the reaction by the Horner-Wadsworth-Emmons method, the Knoevenagel reaction, the Suzuki coupling reaction and the Grignard coupling reaction are preferred for easy control of the reaction system.

In the process of the present invention, the type of the bond formed by the reaction of the characteristic groups X and Y is not specifically defined; it may be, for instance, covalent bond, ionic bond or coordinate bond. In the case of ionic bond for instance, when the polymer having repeating units with a characteristic group X possesses a carboxyl group, sulfonic group or phosphoric residue as a reaction activating group, the said group and an organic amine will be bonded by ionic bond to form a salt. In the case of coordinate bond, a method comprising formation of a metal complex may be suggested. For instance, in case a polymer having repeating units with a characteristic group X has a group which functions as a ligand as the characteristic group X, the said group and the metal compound may be bonded by coordinate bond. The type of covalent bond conceivable in the present invention includes, for instance, direct bond, single bond, double bond, triple bond, ester bond, and amide bond. Specifically, aryl-carbon bond, carbon-carbon double bond, carbon-carbon triple bond, aryl-aryl direct bond and such are preferred, and aryl-carbon single bond and aryl-aryl direct bond are more preferred.

Q⁹ and Q¹⁰ in the formula -CHQ⁹=CHQ¹⁰ represent independently a hydrogen atom or a hydrocarbon group. As examples of the hydrocarbon group, those mentioned above are referred to, with methyl, ethyl, propyl, n-butyl, hexyl, octyl and phenyl groups being preferred.

Q¹¹ in the formula -NHQ¹¹ is a hydrogen atom or a hydrocarbon group. Examples of the hydrocarbon groups represented by Q¹¹ are those mentioned above, with methyl, ethyl, propyl, n-butyl, hexyl, octyl and phenyl groups being preferred.

In case the polymer produced in the step (B) of the present invention has a characteristic group, this polymer may be further reacted with a compound having a characteristic group which reacts with that of the said polymer.

In the process of the present invention, a polymer having repeating units with a characteristic group X represented by the formula (2) and a compound having a characteristic group represented by one of the formulae (3) to (7) may be reacted by mixing them all together or, if necessary, by mixing them portionwise. These compounds having a characteristic group, if necessary, may be dissolved in an organic solvent and reacted in the presence of an alkali or a suitable catalyst at a temperature above the melting point and below the boiling point of the organic solvent. The organic solvent to be used in this reaction, although variable depending on the compound and the reaction method employed, is preferably subjected to a disoxidation treatment sufficiently for controlling the side reactions and allowing the intended reaction to proceed in an inert atmosphere. It is also preferable to conduct a dehydration treatment. (This does not apply in the case of a two-phase reaction using water like the Suzuki coupling reaction.) An alkali or a suitable catalyst is added for allowing the reaction to proceed. These additives are selected properly according to the reaction method employed. Such an alkali or catalyst is preferably the one which can be dissolved sufficiently in the solvent used for the reaction. As the method for mixing an alkali or catalyst, there are available, for instance, a method in which a solution of an alkali or a catalyst is added slowly to the reaction solution while stirring it in an inert atmosphere such as argon or nitrogen atmosphere, and a method in which, contrary to the above method, the reaction solution is added slowly to a solution of an alkali or a catalyst.

The reaction conditions are described here more definitely. In the case of the Wittig reaction, Horner reaction and Knoevengel, the reaction is carried out using an alkali in an amount of one equivalent or more, preferably one to 3 equivalents to the functional group of the compound. The alkali used for the reaction is not specified; it is possible to use, for instance, metal alcoholates such as potassium-t-butoxide, sodium-t-butoxide, sodium ethylate and lithium methylate, hydride reagents such as sodium hydride, and amides such as sodiumamide. As the solvent, N,N-dimethylformamide, tetrahydrofuran, dioxane, toluene and the like can be used. As for the reaction temperature, the reaction can be let proceed usually at from room temperature to around 150°C. The reaction time is, for instance, 5 minutes to 40 hours, but any time that allows sufficient progress of polymerization can be selected. As there is no need of letting the reaction product stand for a long time after the completion of the reaction, the reaction time is preferably 10 minutes to 24 hours. As for the concentration for the reaction, it is to be noted that a too low concentration leads to a bad reaction efficiency while a too high concentration makes it difficult to control the reaction, so that the concentration is properly selected within the range from about 0.01 wt% to the maximum concentration allowing dissolution, usually the range from 0.1 to 30 wt%. About the Wittig reaction, it is described in, for instance, Organic Reactions, Vol. 14, pp. 270-490, John Wiley & Sons, Inc., 1965. Regarding the Knoevenagel, Wittig and dehydrohalogenation reactions, they are described in, for instance, Makromol. Chem., Macromol. Symp., Vol. 12, p. 229 (1987).

In the case of Heck reaction, a monomer is reacted in the presence of a base such as triethylamine by using a palladium catalyst. This reaction is carried out using a solvent having a relatively high boiling point, such as N,N-dimethylformamide or N-methylpyrrolidone, at a temperature of around 80 to around 160°C for a period of from about one to about 100 hours. The Heck reaction is described in, for instance, Polymer, Vol. 39, pp. 5241-5244 (1998).

The Suzuki reaction is carried out using a catalyst such as palladium[tetrakis(triphenylphosphine)] or palladium acetate, by adding, if necessary, a phosphinic ligand such as triphenylphosphine or tricyclohexylphosphine, also adding an inorganic base such as potassium carbonate, sodium carbonate or barium hydroxide, an organic base such as triethylamine or tetraethylammonium hydroxide, or an inorganic salt such as cesium fluoride in an amount of one equivalent or more, preferably one to 10 equivalents to the monomer. As the solvent, for instance, N,N-dimethylformamide, toluene, dimethoxyethane, tetrahydrofuran and the like can be used. By using an organic or inorganic base as an aqueous solution, it is possible to carry out the reaction under a condition forming a two-phase system with the solvent. The reaction temperature is preferably around 50 to around 160°C although it is variable depending on the solvent used. The reaction solution may be heated to a temperature close to the boiling point of the solvent and then refluxed. The reaction time is from around one to around 200 hours. The Suzuki reaction is described in, for instance, Chemical Review, Vol. 95, p. 2457 (1995), and Journal of Organometallic Chemistry, Vol. 576, p. 147 (1999).

The case where a zero-valent nickel complex was used is here explained. Regarding the way of use of a nickel complex, there are a method in which zero-valent nickel is used in the form as it is, and a method in which a nickel salt is reacted in the presence of a reducing agent to form zero-valent nickel in the system. As the zero-valent nickel complex, bis(1,5-cyclooctadiene)nickel(0), (ethylene)bis(triphenylphosphine)nickel(0), tetrakis(triphenylphosphine)nickel, etc., can be presented as examples. Among them, bis(1,5-cyclooctadiene)nickel(0) is preferred in view of versatility and low cost. Incorporation of a neutral ligand is advantageous in terms of improvement of yield. "Neutral ligand" refers to a ligand having neither anion nor cation. Examples of such a neutral ligand include nitrogeneous ligands such as 2,2'-bipyridyl, 1,10-phenanthroline, methylenebisoxazoline and N,N'-tetramethylethylenediamine; and tertiary phosphinic ligands such as triphenylphosphine, tritolylphosphine, tributylphosphine and triphenoxyphosphine. The nitrogeneous ligands are preferred in view of versatility and low cost, with 2,2'-bipyridyl being especially preferred because of high reactivity and high yield. For the improvement of polymer yield, it is especially preferable to add 2,2'-bipyridyl as a neutral ligand in the system containing bis(1,5-cyclooctadiene)nickel(0). In the method where zero-valent nickel is reacted in the system, nickel chloride, nickel acetate and the like can be used as the nickel salt. As the reducing agent, zinc, sodium hydroxide, hydrazine and its derivates, lithiumaluminum hydride and the like can be cited as examples. If necessary, ammonium iodide, lithium iodide, potassium iodide and the like may be used as additives. As the polymerization solvent, it is possible to use any type provided that it does not hinder the polymerization. Examples of such solvents are N,N-dimethylformamide, N,N-dimethylacetamide, aromatic hydrocarbon solvents and ether solvents. The "aromatic hydrocarbon solvents" mentioned here are the solvents comprising an aromatic hydrocarbon compound, the examples of such solvents being benzene, toluene, xylene, trimethylbenzene, tetramethylbenzene,butylbenzene, naphthalene and tetralin. Toluene, xylene, tetralin and tetramethylbenzene are preferred. The "ether solvents" are the solvents comprising a compound in which the hydrocarbon groups are bonded by the oxygen atoms. Examples of such ether solvents are diisopropyl ether, tetrahydrofuran, 1,4-dioxane, diphenyl ether, ethylene glycol dimethyl ether, and tert-butylmethyl ether. Of these solvents, tetrahydrofuran and 1,4-dioxane, which are the good solvents for the polymers, are preferred. These solvents may be used as a mixture. For example, the polymerization reaction is carried out in a tetrahydrofuran solvent, usually under an atmosphere of an inert gas such as argon or nitrogen, in the presence of a zero-valent nickel complex and a neutral ligand at a temperature of 60°C. The polymerization time is usually about 0.5 to abount 100 hours, but a time not exceeding 10 hours is preferred in view of production cost. The polymerization temperature is usually about 0 to about 200°C, but a temperature within the range of 20 to 100°C is preferred in view of high yield and low heating cost. About the case where a nickel catalyst is used, reference is made to, for instance, Progressive Polymer Science, Vol. 17, pp. 1153-1205, 1992.

In the case of Grignard reaction, a method can be cited in which the reaction is carried out in a solvent such as toluene, dimethoxethane, tetrahydrofurn or the like by using as catalyst, for instance, dichloronickel(bisdiphenylphosphinopropane), dichloronickel(bisdiphenylphosphinoethane), nickel(2,2'-bipyridyl)dichloride or the like. A temperature of from around -20 to aroiund 160°C is suitably used for the reaction although it is variable depending on the solvent used. The reaction solution may be heated to a temperature close to the boiling point of the solvent and then refluxed. The reaction time is from around 0.1 to around 200 hours. Regarding the Grignard reaction, it is discussed in, for instance, Bulletin of Chemical Society of Japan, Vol. 51, p. 2091 (1978), and Chemical Letters, p. 353 (1977).

The polymer produced according to the process of the present invention is usually fluorescent in a solid state, and typically its polystyrene-reduced number-average molecular weight is from 10³ to 10⁸, preferably from 5 x 10³ to 5 x 10⁷.

In case the polymer produced according to the process of the present invention is used in the field of electronic materials such as polymer LED, the polymer having repeating units represented by the above-shown formula (1) is preferably a conjugated polymer. In this polymer, the repeating units may be linked at the vinylene or nonconjugated portion within limits not impairing the fluorescent properties or charge transport of the product. Also, such a vinylene or nonconjugated portion may be contained in the repeating units. The bond structure having a nonconjugated portion may be, for instance, any of those shown by the formulae X-1 to X-15, or a combination of any of them with a vinylene group, or a combination of two or more of those shown by the above formulae. Here, R" and Ar have the same meaning as defined above.

Among the linking groups having a nonconjugated portion indicated by the above-shown formulae X-1 to X-15, those indicated by X-3, X-5, X-6 and X-12 to X-15 are preferred, those indicated by X-3, X-5, X-6 and X-12 to X-14 are more preferred, and those indicated by X-3, X-5 and X-6 are even more preferred.

In the polymer produced according to the process of the present invention, the ratio of the total number of the linking groups having a vinylene and said nonconjugated portion, which are contained beside the repeating units, is preferably 30% or less, more preferably 20% or less, even more preferably 10% or less, based on the total number of the whole repeating units. Most preferably, the polymer has no linking group which has a vinylene and nonconjugated portion.

The polymer produced according to the process of the present invention may be a random, block or graft copolymer, or may be a polymer having an intermediate structure, for example, a block-oriented random copolymer. From the viewpoint of obtaining a polymeric fluorescent substance with a high quantum yield of fluorescence, a block-oriented random copolymer or a block or graft copolymer is preferred rather than a perfect random copolymer. The polymers of the present invention also include those in which the backbone is branched and which have three or more terminals, and dendrimers.

In case the polymer obtained according to the process of the present invention is used as a fluorescent material (polymeric fluorescent substance) for polymer LED, since its purity gives influence to the fluorescent properties, it is desirable to conduct separation and purification sufficiently to fully get rid of the unreacted monomers, by-products and catalyst residue. Drying is conducted in a way to effect thorough removal of the remaining solvent. For preventing any change of quality of the polymer, drying is preferably conducted in an inert atmosphere with the light shut out. It is also advisable to carry out drying at a temperature which won't cause thermal degeneration of the polymer.

The terminal groups of the polymer produced according to the process of the present invention may be protected with a stable group because if the characteristic groups remain in the polymer, they may affect the fluorescent properties or durability of the product. Such terminal groups are preferably those having a conjugated bond continuous to the conjugated structure of the backbone. They may be of a structure bonded to an aryl group or a heterocyclic group through a vinylene group. Examples of such groups are, for instance, those shown by Formula 10 in JP-A-9-45478. The good solvents for the said polymer include chloroform, methylene chloride, dichloroethane, tetrahydrofuran, toluene, xylene, mesitylene, decalin, n-butylbenzene and dioxanes. The polymer can be dissolved in these solvents in an amount of usually 0.1 wt% or more although its amount is variable depending on the structure or molecular weight of the polymer. (II) Now the process according to the second embodiment of the present invention is explained.

The polymer used as the starting material in this process of the present invention is the one which has one or more repeating units represented by the above-shown formula (1), with the total of the repeating units of the formula (1) being 0.1 to 100 mol% of the total of the whole repeating units. The said polymer may have a repeating unit represented by the formula (1a). It may also have a linking group containing a conjugated portion represented by any of the formulae X-1 to X-11 and/or a group comprising a combination of two or more of such linking groups, in an amount of 40 mol% or less based on the total of the repeating units represented by the formulae (1) and (1a).

In the repeating units represented by the formula (1) used in the present invention, Ar¹ represents an arylene group, a divalent heterocyclic group or a divalent aromatic amine group. This group Ar¹ has at least one C-H bond on the aromatic ring. It may also have a substituent.

The arylene group mentioned above is an atomic group comprising an aromatic hydrocarbon with its two hydrogen atoms eliminated. It includes the groups having a condensed ring and those in which two or more independent benzene rings or condensed rings are bonded directly or through a group such as vinylene. The arylene group may have a substituent. The carbon number of the portion exclusive of the substituent in the arylene group is usually about 6 to about 60, preferably 6 to 20. The overall carbon number of the arylene group including the substituent is usually about 6 to about 100. Examples of the arylene group are shown below by the formulae 1A-1 to 1A-20.

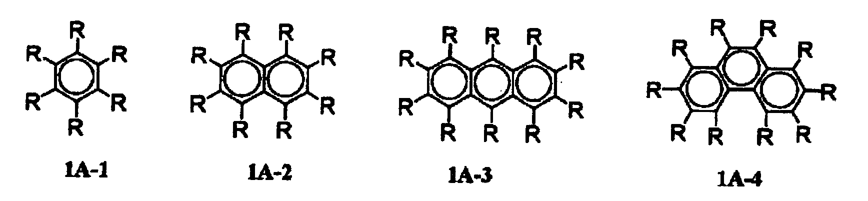

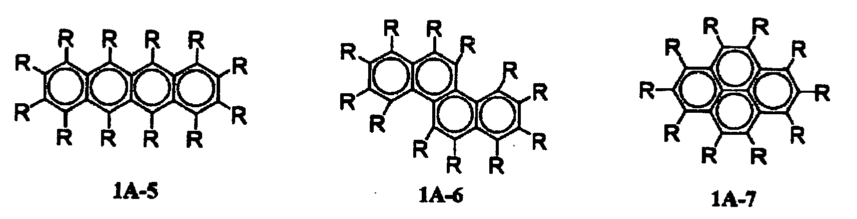

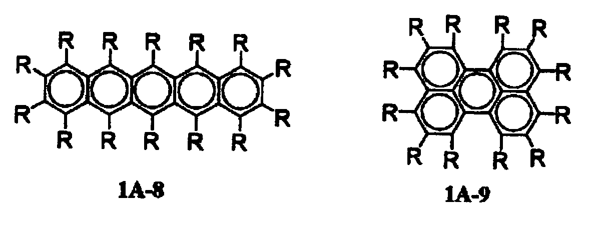

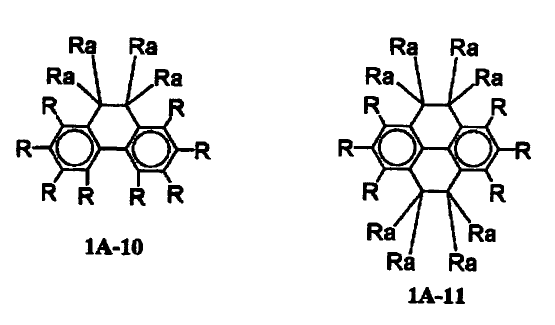

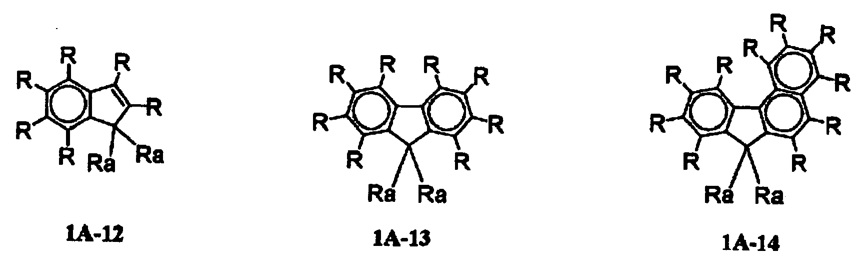

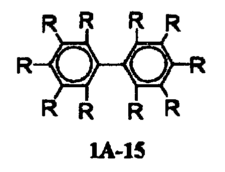

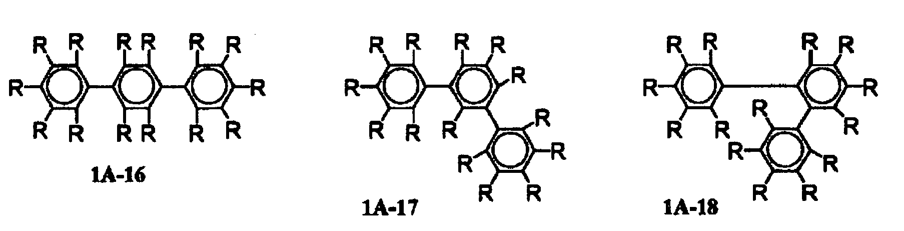

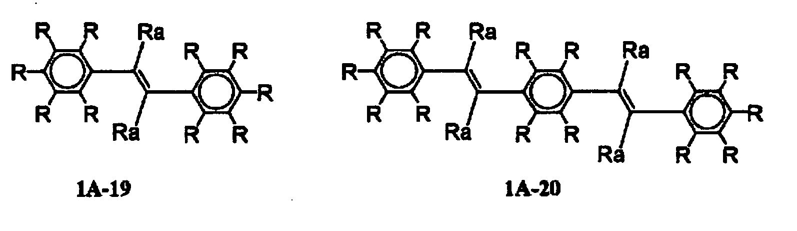

In the above-shown formulae 1A-1 to 1A-20 representing Ar¹, R designates a hydrogen atom, a valence bond or a substituent. Any two of R's are a valence bond, and at least one of R's is a hydrogen atom. When there exist plural substituents represented by R, they may be identical or different from each other. Ra represents a hydrogen atom or a substituent. When there exist plural substituents represented by Ra, they may be identical or different from each other. When two Ra's exist on a same atom, they may be combined to form an oxo or thioxo group, or may be bonded to each other to form a ring.

Also, the substituents represented by R may form, together with the substituents on the adjoining atoms, a 5- to 7-membered aliphatic group or 5- to 7-membered aromatic group which may have a hetero-atom such as oxygen atom, sulfur atom or nitrogen atom.

As the arylene group represented by Ar¹, of those indicated by the formulae 1A-1 to 1A-14, phenylene (1A-1), naphthalene-diyl (1A-2), anthracene-diyl (1A-3), dihydrophenanthrene-diyl (1A-10), fluorene-diyl (1A-13), benzofluorene-diyl (1A-14), biphenylene (1A-15), and ter-phenylene (1A-16 to 1A-18) are preferred. Of these groups, phenylene (1A-1), naphthalene-diyl (1A-2), dihydrophenanthrene-diyl (1A-10), fluorene-diyl (1A-13), benzofluorene-diyl (1A-14), biphenylene (1A-15) and ter-phenylene (1A-16 to 1A-18) are more preferred, and phenylene (1A-1), naphthalene-diyl (1A-2), fluorene-diyl (1A-13) and benzofluorene-diyl (1A-14) are even more preferred.

The divalent heterocyclic group is an atomic group comprising a heterocyclic compound from which two hydrogen atoms were expelled. It includes the type having a condensed ring, the type in which the independent monocyclic heterocyclic compounds or two or more of the condensed rings are bonded directly or through a group such as vinylene, and the type in which a heterocyclic compound and an aromatic hydrocarbon are combined. The divalent heterocyclic group may have a substituent. The carbon number of the portion exclusive of the substituent in the divalent heterocyclic group is usually about 4 to about 60, preferably 2 to 20. The overall carbon number of the divalent heterocyclic group including the substituent is usually about 2 to about 100. The term "heterocyclic compound" used here means those of the organic compounds having a cyclic structure in which the elements constituting the ring comprise not only carbon atoms but also include hetero-atoms such as oxygen, sulfur, nitrogen, phosphorus and boron. Examples of the divalent heterocyclic group are shown below by the formulae 2A-1 to 2A-53, and 2A-101 to 2A-116.

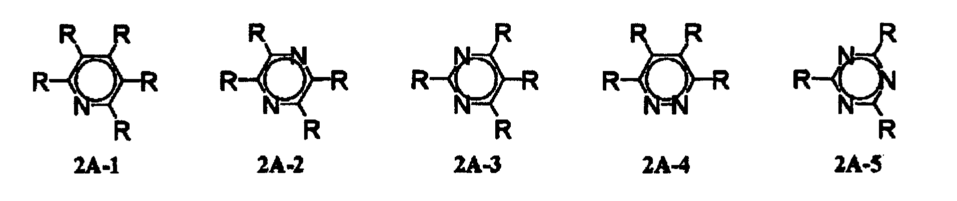

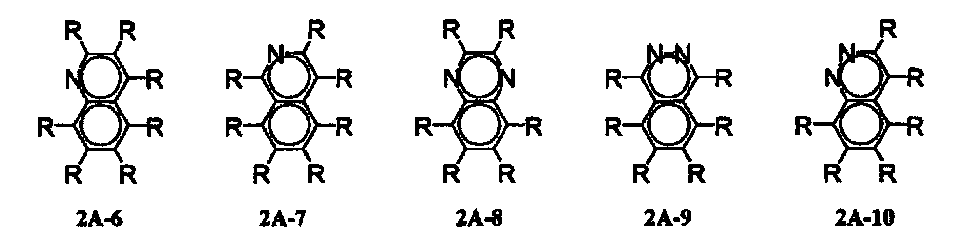

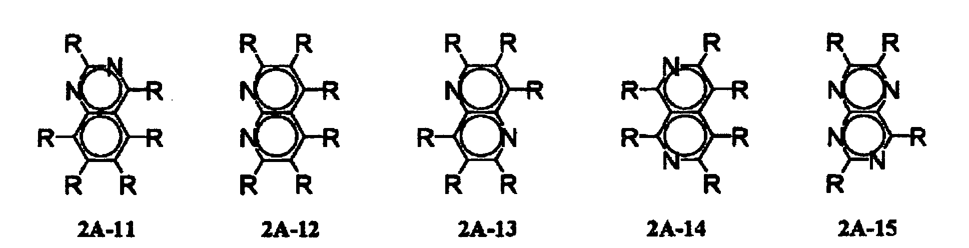

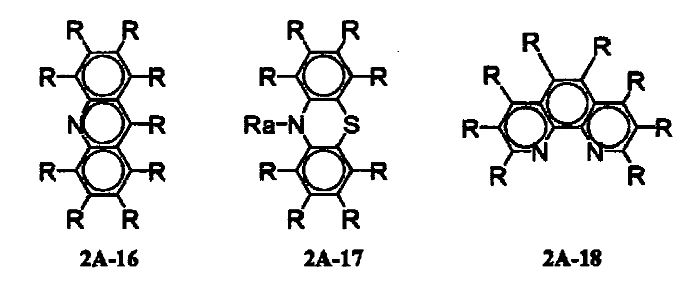

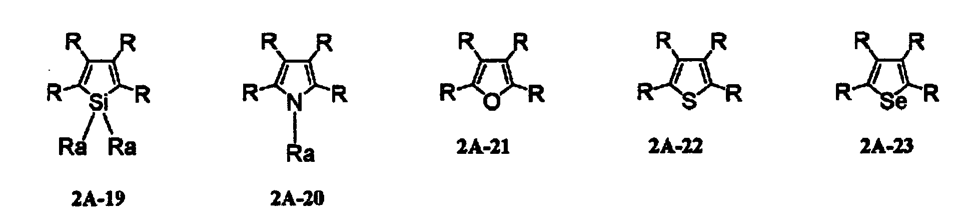

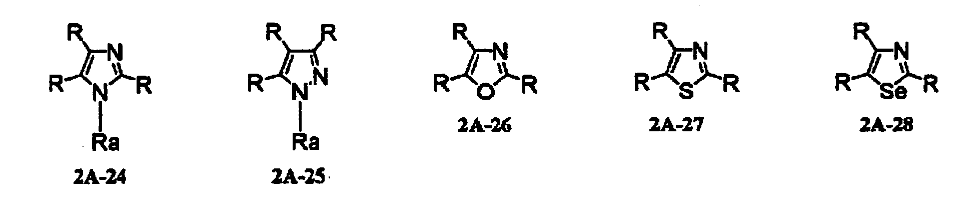

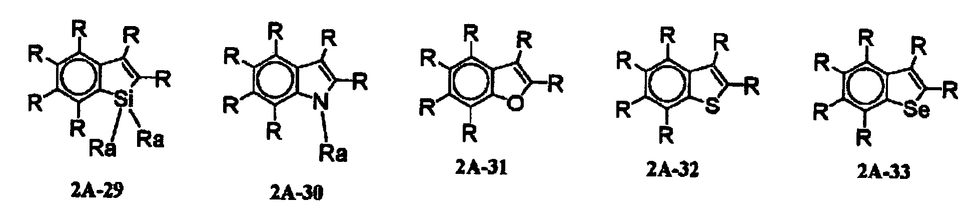

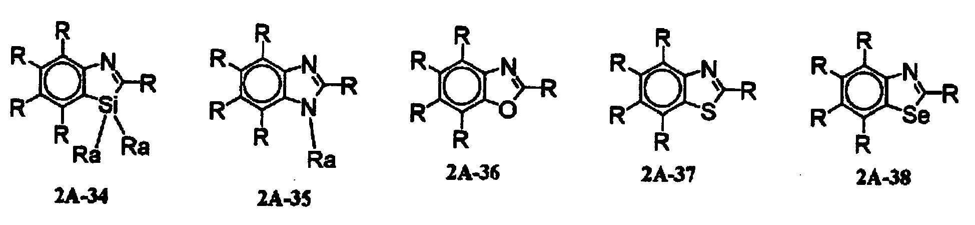

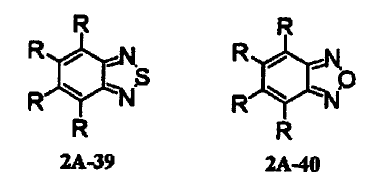

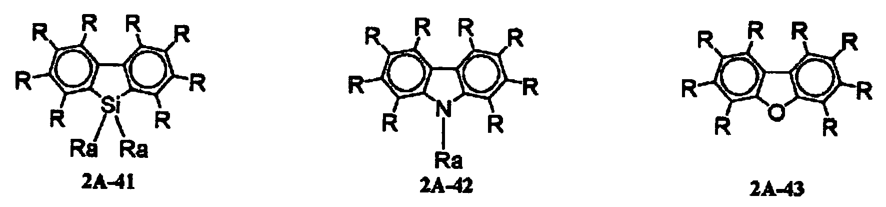

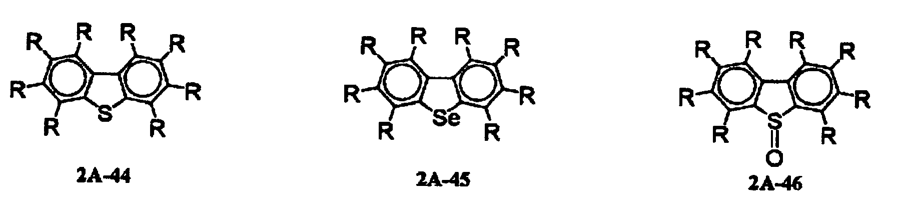

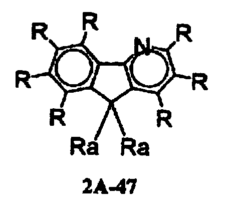

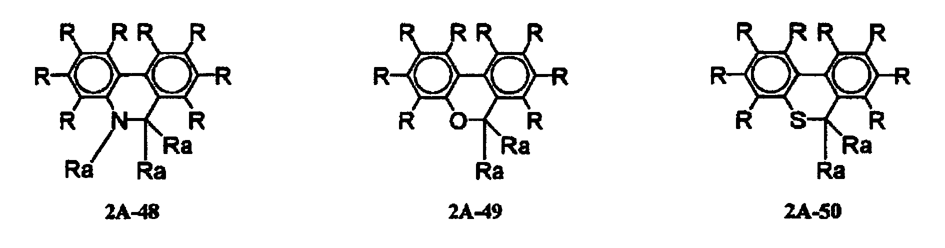

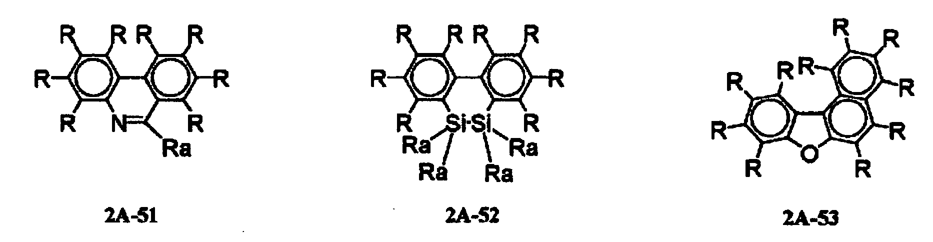

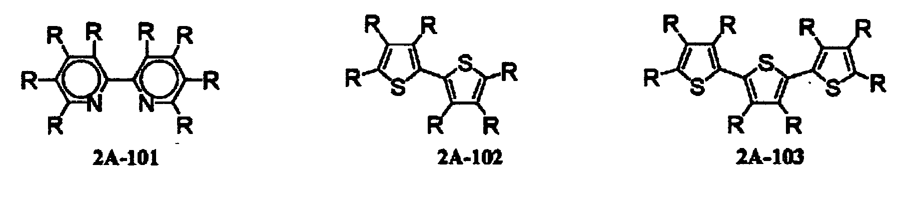

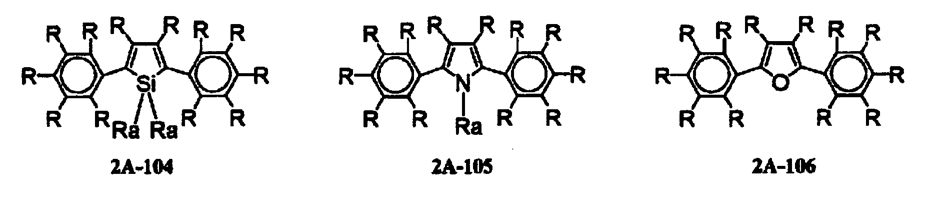

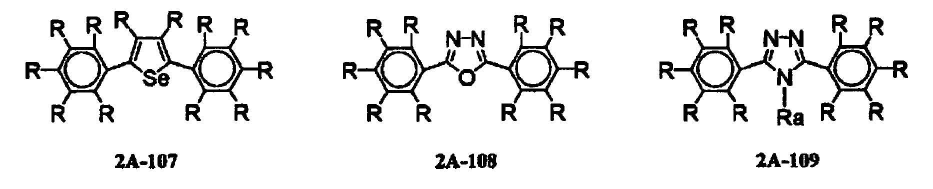

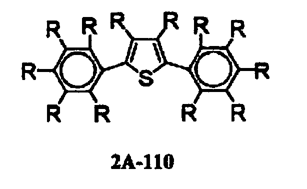

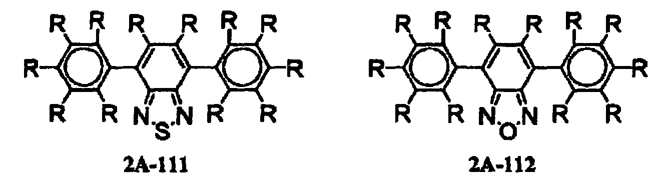

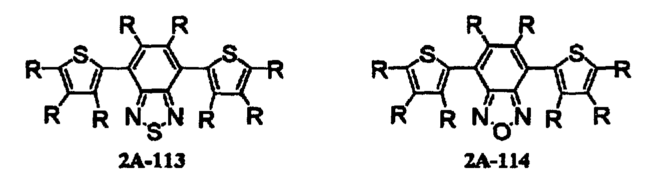

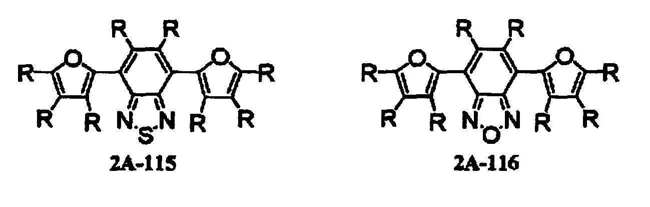

In the above-shown formulae 2A-1 to 2A-53 and 2A-101 to 2A-116 exemplifying Ar¹, R represents a hydrogen atom, a valence bond or a substituent. Any two of R's are a valence bond, and at least one of R's is a hydrogen ataom. When there exist plural substituents represented by R, they may be identical or different from each other. Ra represents a hydrogen atom or a sustituent. When there exist plural substituents represented by Ra, they may be identical or different from each other. When two Ra's exist on a same atom, they may be combined together to form an oxo or thioxo group, or may be bonded to each other to form a ring.

The substituents represented by R may form, together with the substituents on the adjoining atoms, a 5- to 7-membered aliphatic ring having a hetero-atom such as oxygen atom, sulfur atom or nitrogen atom, or a 5- to 7-membered aromatic ring which may have a hetero-atom such as oxygen atom, sulfur atom or nitrogen atom.

Of the divalent heterocyclic groups of Ar¹ indicated by the above-shown formulae 2A-1 to 2A-53 and 2A-101 to 2A-116, pyridine-diyl group (2A-1), quinoline-diyl group (2A-6), isoquinoline-diyl group (2A-7), quinoxaline-diyl group (2A-8), phenanthroline-diyl group (2A-18), thiophene-diyl group (2A-22), imidazole-diyl group (2A-24), oxazole-diyl group (2A-26), thiazole-diyl group (2A-27), 5-membered ring heterocyclic groups having nitrogen, sulfur, oxygen or selenium as hetero-atom and having their benzene ring condensed (2A-30 to 2A-32 and 2A-34 to 2A-40), heterocylic groups having a fluorene-like skeleton containing silicon, nitrogen, oxygen or sulfur as hetero-atom (2A-41 to 2A-44, 2A-46 and 2A-47), heterocyclic groups having a condensed ring structure indicated by the formulae 2A-48 to 2A-53, diazaphenylene group (2A-101), compound groups having phenyl group and thienyl group bonded at the 2,5-position of a 5-membered ring heterocyclic group having nitrogen, oxygen or sulfur as hetero-atom (2A-103, 2A-105, 2A-106, and 2A-108 to 2A-110), and the compound groups having phenyl group or thienyl group bonded to a 5-membered ring heterocyclic group having nitrogen, oxygen or sulfur as hetero-atom and having its benzene ring condensed (2A-111 to 2A-116) are preferred. Of those shown above, pyridine-diyl group (2A-1), quinoline-diyl group (2A-6), isoquinoline-diyl group (2A-7), quinoxaline-diyl group (2A-8), phenanthroline-diyl group (2A-18), heterocyclic groups having a fluorene-like skeleton containing silicon, nitrogen, oxygen or sulfur as hetero-atom (2A-41 to 2A-44, 2A-46 and 2A-47), heterocyclic groups having a condensed ring structure indicated by the formulae 2A-48 to 2A-53, diazaphenylene group (2A-101), compound groups having phenyl group bonded at the 2,5-position of a 5-membered ring heterocyclic group containing nitrogen, oxygen or sulfur as hetero-atom (2A-103, 2A-105, 2A-106, and 2A-108 to 2A-110), and compound groups having phenyl group bonded to a 5-membered ring heterocyclic group having nitrogen, oxygen or sulfur as hetero-atom and having its benzene ring condensed (2A-111 to 2A-116) are more preferred. The heterocyclic groups having a fluorene-like skeleton having silicon, nitrogen, oxygen or sulfur as hetero-atom (2A-41 to 2A-44, 2A-46 and 2A-47), heterocyclic groups having a condensed ring structure indicated by the formulae 2A-48 to 2A-53, compound groups having phenyl group bonded to the 2,5-position of a 5-membered ring heterocyclic group containing nitrogen, oxygen or sulfur as hetero-atom (2A-103, 2A-105, 2A-106, and 2A-108 to 2A-110), and compound groups having phenyl group bonded to a 5-membered ring heterocyclic group having its benzene ring condensed and containing nitrogen, oxygen or sulfur as hetero-atom (2A-111 to 2A-116) are even more preferred.

"Divalent aromatic amine group" is an atomic group which is left after elimination of two hydrogen atoms from an aromatic amine. This divalent aromatic amine group may have a substituent. The carbon number of the portion exclusive of the substituent in the divalent aromatic amine group is usually about 4 to about 60. Examples of the divalent aromatic amine group are the groups represented by the following general formula (1-2): 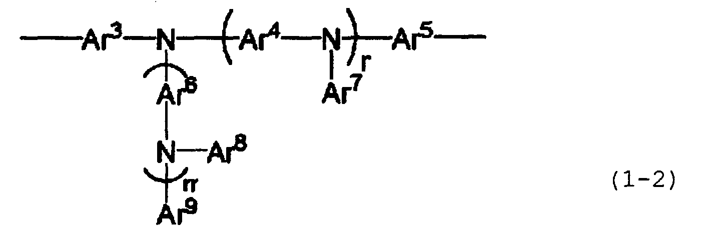 (wherein Ar³, Ar⁴, Ar⁵ and Ar⁶ represent independently an arylene group or a divalent heterocyclic group; Ar⁷, Ar⁸ and Ar⁹ represent independently an aryl gjroup or a monovalent heterocyclic group; each of Ar³, Ar⁴, Ar⁵, Ar⁶, Ar⁷, Ar⁸ and Ar⁹ may have a substituent; r and rr are independently 0 or 1.)

More specifically, the groups represented by the following formulae 3A-1 to 3A-8 can be cited as examples of the divalent aromatic amine group:

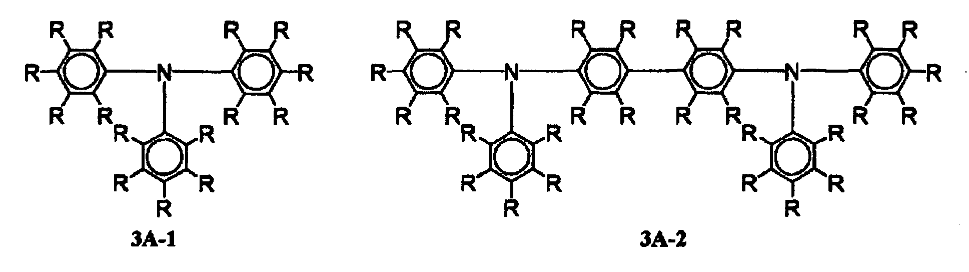

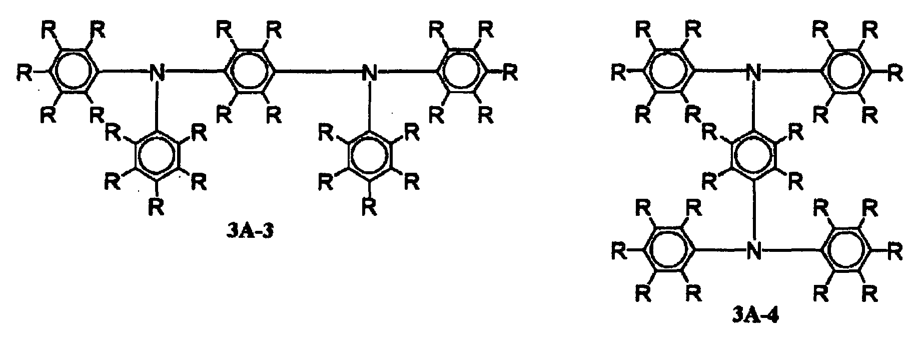

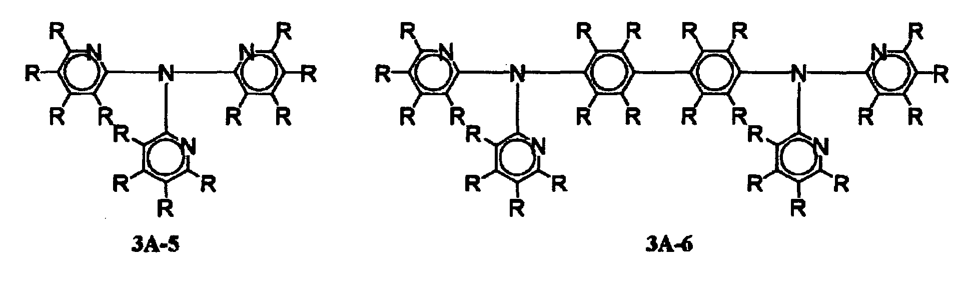

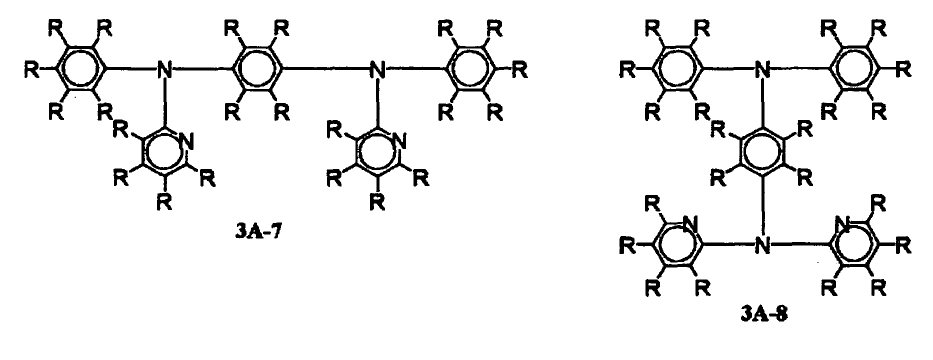

In the above formulae 3A-1 to 3A-8 of Ar¹, R represents a hydrogen atom, a valence bond or a substituent. Any two of R's are a valence bond, and at least one of R's is a hydrogen atom. When there exist plural substituents represented by R, they may be identical or different from each other.

As the divalent aromatic amine group represented by Ar¹, of those shown by the formulae 3A-1 to 3A-8, the ones designated by 3A-1 to 3A-4 are preferred, the ones designated by the formulae 3A-1 to 3A-3 are more preferred, and the ones designated by 3A-2 and 3A-3 are even more preferred.

The substituents represented by R may form, together with the substituents on the adjoining atoms, a 5- to 7-membered aliphatic ring having a hetero-atom such as oxygen atom, sulfur atom or nitrogen atom, or a 5- to 7-membered aromatic ring which may have a hetero-atom such as oxygen atom, sulfur atom or nitrogen atom.

As the group represented by Ar¹, of the arylene group, divalent heterocyclic group and divalent aromatic amine group, arylene group and divalent heterocyclic group are preferred, with arylene group being more preferred.

Exemplary of the substituents represented by R or Ra are alkyl, aryl, aralkyl, monovalent heterocyclic, arylalkenyl, arylalkynyl, alkoxy, aryloxy, aralkyloxy, alkylthio, arylthio, aralkylthio, substituted amino, substituted silyl, sulfonic, phosphonoic, cyano and nitro groups.

The alkyl groups represented by R or Ra may be either linear, branched or cyclic in molecular structure, and their carbon number is usually about 1 to about 20, preferably 3 to 20. Examples of such alkyl groups include methyl, ethyl, propyl, isopropyl, n-butyl, isobutyl, s-butyl, t-butyl, pentyl, isopentyl, hexyl, cyclohexyl, heptyl, octyl, 2-ethylhexyl, nonyl, decyl, 3,7-dimethyloctyl, dodecyl and octadecyl groups.

In view of solubility in the organic solvents and ease of synthesis, methyl, ethyl, propyl, isopropyl, n-butyl, isobutyl, s-butyl, t-butyl, pentyl, isopentyl, hexyl, cyclohexyl, heptyl, cyclohexylmethyl, octyl, 2-ethylhexyl, 2-cyclohexylethyl, nonyl, decyl, 3,7-dimethyloctyl and dodecyl are preferred. Of these groups, methyl, ethyl, propyl, isopropyl, butyl, isobutyl, s-butyl, t-butyl, pentyl, isopentyl, hexyl, cyclohexyl, heptyl, octyl, 2-ethylhexyl, nonyl, decyl and 3.7-dimethyloctyl are more preferred, and propyl, isopropyl, butyl, isobutyl, s-butyl, t-butyl, pentyl, isopentyl, hexyl, cyclohexyl, heptyl, octyl, 2-ethylhexyl, nonyl, decyl and 3.7-dimethylocyl are even more preferred.

Aryl group is an atomic group comprising an aromatic hydrocarbon from which one hydrogen atom on the aromatic ring has been eliminated. It may have a condensed ring. Aryl group has a carbon number of usually about 6 to about 60, preferably 7 to 48, and its examples include phenyl, C₁-C₁₂ alkylphenyl, 1-naphthyl, 2-naphthyl, 1-anthracenyl, 2-anthracenyl and 9-anthracenyl. ("C₁-C₁₂" indicates that the carbon number is 1 to 12, and this designation applies in the following description.)

In view of solubility in the organic solvents and ease of synthesis, C₁-C₁₂ alkylphenyl groups are preferred.

Examples of such C₁-C₁₂ alkylphenyl groups are methylphenyl, ethylphenyl, dimethylphenyl, dimethyl-t-butylphenyl, propylphenyl, mesityl, methylethylphenyl, isopropylphenyl, n-butylphenyl, isobutylphenyl, s-butylphenyl, t-butylphenyl, pentylphenyl, isopentylphenyl, hexylphenyl, heptylphenyl, octylphenyl, nonylphenyl, decylphenyl, 3,7-dimethyloctylphenyl, and dodecylphenyl. Of these groups, dimethylphenyl, dimethyl-t-butylphenyl, propylphenyl, mesityl, methylethylphenyl, isopropylphenyl, n-butylphenyl, isobutylphenyl, s-butylphenyl, t-butylphenyl, pentylphenyl, isopentylphenyl, hexylphenyl, heptylphenyl, octylphenyl, nonylphenyl, decylphenyl, 3,7-dimethyloctylphenyl and dodecylphenyl are preferred.

Aralkyl group is a group having a carbon number of usually about 7 to about 60, preferably 7 to 48. Examples thereof are phenyl-C₁-C₁₂ alkyl, C₁-C₁₂ alkylphenyl-C₁-C₁₂ alkyl, 1-naphthyl-C₁-C₁₂ alkyl, and 2-naphthyl-C₁-C₁₂ alkyl.

In view of solubility in the organic solvents and ease of synthesis, C₁-C₁₂ alkylphenyl-C₁-C₁₂ alkyl is preferred.

Monovalent heterocyclic group is an atomic group which is left after elimination of one hydrogen atom from a heterocyclic compound, and its carbon number is usually about 4 to about 60, preferably 4 to 20. The carbon number of the heterocyclic group does not include the carbon number of the substituent. The "heterocyclic compounds" referred to herein mean those of the organic compounds having a cyclic structure in which the elements constituting the ring comprise not only a carbon atom but also include a hetero-atom such as oxygen, sulfur, nitrogen, phosphorus or boron. Examples of the monovalent heterocyclic group are thienyl, C₁-C₁₂ alkylthienyl, pyrolyl, furyl, pyridyl, C₁-C₁₂ alkylpyridyl, piperidyl, quinolyl and isoquinolyl.

In view of solubility in the organic solvents and ease of synthesis, thienyl, C₁-C₁₂ alkylthienyl, pyridyl and C₁-C₁₂ alkylpyridyl are preferred.

Arylalkenyl group has a carbon number of usually about 8 to sbout 60 and includes as its examples phenyl-C₂-C₁₂ alkenyl, C₁-C₁₂ alkylphenyl-C₂-C₁₂ alkenyl, 1-naphthyl-C₂-C₁₂ alkenyl, and 2-naphthyl-C₂-C₁₂ alkenyl.

In view of solubility in the organic solvents and ease of synthesis, C₁-C₁₂ alkylphenyl-C₂-C₁₂ alkenyl is preferred.

Arylalkynyl group is usually about 8 to about 60 in carbon number and its examples are phenyl-C₂-C₁₂ alkynyl, C₁-C₁₂ alkylphenyl-C₂-C₁₂ alkynyl, 1-naphthyl-C₂-C₁₂ alkynyl, and 2-naphthyl-C₂-C₁₂ alkynyl.

In view of solubility in the organic solvents and ease of synthesis, C₁-C₁₂ alkylphenyl-C₂-C₁₂ alkynyl is preferred.

Alkoxyl group may be either linear, branched or cyclic in its molecular structure, and its carbon number is usually about 1 to about 20, preferably 3 to 20. Examples of this group are methoxy, ethoxy, propyloxy, isopropyloxy, n-butoxy, isobutoxy, t-butoxy, pentyloxy, hexyloxy, cyclohexyloxy, heptyloxy, octyloxy, 2-ethylhexyloxy, nonyloxy, decyloxy, 3,7-dimethyloctyloxy and dodecyloxy.

In view of solubility in the organic solvents and ease of synthesis, pentyloxy, hexyloxy, octyloxy, 2-ethylhexyloxy, decyloxy and 3,7-dimethyloctyloxy are preferred.

Aryloxy group ranges from usually about 6 to about 60, preferably 7 to 48 in carbon number, and its examples are phenoxy, C₁-C₁₂ alkylphenoxy, 1-naphthyloxy and 2-naphthyloxy.

In view of solubility in the organic solvents and ease of synthesis, C₁-C₁₂ alkylphenoxy is preferred.

Exemplary of the C₁-C₁₂ alkylphenoxy group are methylphenoxy, ethylphenoxy, dimethylphenoxy, propylphenoxy, 1,3,5-trimethylphenoxy, methylethylphenoxy, isopropylphenoxy, n-butylphenoxy, isobutylphenoxy, t-butylphenoxy, pentylphenoxy, isopentylphenoxy, hexylphenoxy, heptylphenoxy, octylphenoxy, nonylphenoxy, decylphenoxy, and dodecylphenoxy.

Aralkyloxy group is of a carbon number of usually about 7 to about 60, preferably 7 to 48, and its examples are phenyl-C₁-C₁₂ alkoxy, C₁-C₁₂ alkylphenyl-C₁-C₁₂ alkoxy, 1-naphthyl-C₁-C₁₂ alkoxy and 2-naphthyl-C₁-C₁₂ alkoxy, more specifically phenylmethoxy, phenylethoxy, phenyl-n-butoxy, phenylpentyloxy, phenylhexyloxy, phenylheptyloxy and phenyloctyloxy.

In view of solubility in the organic solvents and ease of synthesis, C₁-C₁₂ alkylphenyl-C₁-C₁₂ alkoxy is preferred.

Alkylthio group may be either linear, branched or cyclic, with its carbon number being usually about 1 to about 20, preferably 3 to 20, and its examples are methylthio, ethylthio, propylthio, isopropylthio, n-butylthio, isobutylthio, t-butylthio, pentylthio, hexylthio, cyclohexylthio, heptylthio, octylthio, 2-ethylhexylthio, nonylthio, decylthio, 3,7-dimethyloctylthio and dodecylthio.

In view of solubility in the organic solvents and ease of synthesis, pentylthio, hexylthio, octylthio, 2-ethylhexylthio, decylthio and 3.7-dimethyloctylthio are preferred.

Arylthio group is usually about 3 to about 60 in carbon number, and its examples are phenylthio, C₁-C₁₂ alkylphenylthio, 1-naphthylthio and 2-naphthylthio.

In view of solubility in the organic solvents and ease of synthesis, C₁₋C₁₂ alkylphenylthio is preferred.

Aralkylthio group is of a carbon number of usually about 7 to about 60, preferably 7 to 48, and its examples phenyl-C₁-C₁₂ alkylthio, C₁-C₁₂ alkylphenyl-C₁-C₁₂ alkylthio, 1-naphthyl-C₁-C₁₂ alkylthio and 2-naphthyl-C₁-C₁₂ alkylthio.

In view of solubility in the organic solvents and ease of synthesis, C₁-C₁₂ alkylphenyl-C₁-C₁₂ alkylthio is preferred.

Substituted amino group is, for instance, an amino group which has been substituted with one or two groups selected from alkyl, aryl, arylalkyl and monovalent heterocyclic groups, with its carbon number being usually about 1 to about 60, preferably 2 to 48.

Exemplary of this substituted amino group are methylamino, dimethylamino, ethylamino, diethylamino, propylamino, dipropylamino, isopropylamino, diisopropylamino, n-butylamino, isobutylamino, t-butylamino, pentylamino, hexylamino, cyclohexylamino, heptylamino, octylamino, 2-ethylhexylamino, nonylamino, decylamino, 3,7-dimethyloctylamino, dodecylamino, cyclopentylamino, dicyclopentylamino, cyclohexylamino, dicyclohexylamino, pyrrolidyl, piperidyl, diphenylamino, (C₁-C₁₂ alkylphenyl) amino, di (C₁-C₁₂ alkylphenyl)amino, 1-naphthylamino, 2-naphthylamino, pyridylamino, pyridazinylamino, pyrimidylamino, pyrazylamino, triazylamino, phenyl-C₁-C₁₂ alkylamino, C₁-C₁₂ alkylphenyl-C₁-C₁₂ alkylamino, di (C₁-C₁₂ alkylphenyl-C₁-C₁₂ alkyl)amino, 1-naphthyl-C₁-C₁₂ alkylamino, and 2-naphthyl-C₁-C₁₂ alkylamino.

In view of solubility in the organic solvents and ease of synthesis, di-substituted amino groups such as dimethylamino, diethylamino, diphenylamino and di(C₁-C₁₂ alkylphenyl)amino are preferred. Diarylamino groups such as diphenylamino and di(C₁-C₁₂ alkylphenyl)amino are more preferred.

Substituted silyl group may be, for instance, a silyl group which has been substituted with one, two or three groups selected from alkyl, aryl, arylalkyl and monovalent heterocyclic groups. The carbon number of this substituted silyl group is usually about 1 to about 60, preferably 3 to 48.

More specific examples of this group are trimethylsilyl, triethylsilyl, tripropylsilyl, triisopropylsilyl, dimethylisopropylsilyl, diethylisopropylsilyl, t-butylsilyldimethylsilyl, pentyldimethylsilyl, hexyldimethylsilyl, heptyldimethylsilyl, octyldimethylsilyl, 2-ethylhexyl-dimethylsilyl, nonyldimethylsilyl, decyldimethylsilyl, 3,7-dimethyloctyl-dimethylsilyl, dodecyldimethylsilyl, phenyl-C₁-C₁₂ alkylsilyl, C₁-C₁₂ alkylphenyl-C₁-C₁₂ alkylsilyl, 1-naphthyl-C₁-C₁₂ alkylsilyl, 2-naphthyl-C₁-C₁₂ alkylsilyl, phenyl-C₁-C₁₂ alkyldimethylsilyl, triphenylsilyl, tri-p-methylphenylsilyl, tribenzylsilyl, diphenylmethylsilyl, t-butyldiphenylsilyl, and dimethylphenylsilyl.

In case the substituent represented by R or Ra contains an aryl group or a monovalent heterocyclic group, the hydrogen atom on such an aryl group or monovalent heterocyclic group may be substituted with an aryl, aralkyl, monovalent heterocyclic, arylalkenyl, arylalkynyl, alkoxy, aryloxy, aralkyloxy, alkylthio, arylthio, aralkylthio, substituted amino, substituted silyl, sulfonic, phosphonoic, cyano or nitro group. Of these substitute groups, aryl, aralkyl, monovalent heterocyclic, alkoxy, aryloxy, aralkyloxy, alkylthio, arylthio, aralkylthio, substituted amino, substituted silyl, sulfonic, phosphonoic, cyano and nitro groups are preferred. Among them, alkyl, aryl, aralkyl, monovalent heterocyclic, alkoxy, aryloxy, aralkyloxy, alkylthio, arylthio, aralkyllthio and substituted amino groups are more preferred, and alkoxy and alkythio groups are even more preferred.

More specific examples of the said substituted groups are the groups having C₁-C₁₂ alkoxy substitutents such as C₁-C₁₂ alkoxyphenyl, C₁-C₁₂ alkoxyphenyl-C₁-C₁₂ alkyl, C₁-C₁₂ alkoxyphenyl-C₂-C₁₂ alkenyl, C₁-C₁₂ alkoxyphenyl-C₂-C₁₂ alkynyl, C₁-C₁₂ alkoxyphenoxy, C₁-C₁₂ alkoxyphenyl-C₁-C₁₂ alkoxy, C₁-C₁₂ alkoxyphenylthio, C₁-C₁₂ alkoxyphenyl-C₁-C₁₂ alkylthio, C₁-C₁₂ alkoxyphenylamino, di(C₁-C₁₂ alkoxyphenyl) amino, C₁-C₁₂ alkoxyphenyl-C₁-C₁₂ alkylamino, di(C₁-C₁₂ alkoxyphenyl-C₁-C₁₂ alkyl)amino, and C₁-C₁₂ alkoxyphenyl-C₁-C₁₂ alkylsilyl. Examples of the C₁-C₁₂ alkoxyl groups are methoxy, ethoxy, propyloxy, isopropyloxy, n-butoxy, isobutoxy, s-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, and dodecyloxy.

In case the substituent represented by R or Ra has an alkylene chain, any -CH₂- group in this alkylene chain may be substituted with a divalent hetero-atom such as oxygen, sulfur or nitrogen, a divalent group containing a hetero-atom, or a divalent group comprising a combination of two or more of them. As examples of the said divalent hetero-atom or the divalent group containing a hetero-atom, the groups shown above by the formulae X-1 to X-5, and X-7 to X-10 can be cited.

Examples of the divalent group comprising a combination of two or more of the said divalent hetero-atoms or divalent groups having a hetero-atom are the groups represented by the following formulae XX-1 to XX-4:

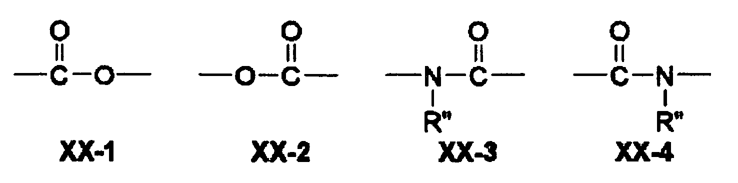

Of the groups represented by the above-shown formulae X-1 to X-5, X-6 to X-10, and XX-1 to XX-4, those represented by the formulae X-1, X-2, X-3, X-5 and X-7 are preferred, with those represented by the formulae X-1 and X-2 being more preferred and those represented by the formula X-1 are even more preferred. Typical examples of such groups are methoxymethyloxy and 2-methoxyethyloxy groups.

Preferred examples of the substituent represented by R in the group represented by Ar¹ are alkyl, aryl, aralkyl, monovalent heterocyclic, alkoxy, aryloxy, aralkyloxy, alkylthio, arylthio, aralkylthio, substituted amino, substituted silyl, sulfonic, phosphonoic, cyano and nitro groups. Of these groups, alkyl, aryl, aralkyl, monovalent heterocyclic, alkoxy, aryloxy, aralkyloxy, alkylthio, arylthio, aralkylthio and substituted amino groups are more preferred, and alkyl, alkoxy and alkylthio groups are even more preferred, with alkyl group being the most preferred.

As the substituent represented by Ra in the group represented by Ar¹, alkyl, aryl, aralkyl, monovalent heterocyclic, alkoxy, aryloxy, aralkyloxy, alkylthio, arylthio, aralkylthio, substituted amino, substituted silyl, oxo and thioxo groups are preferred, of which alkyl, alkoxy, alkylthio, alkylsilyl, oxo and thioxo groups are more preferred, and alkyl and alkoxy groups are even more preferred, with alkyl group being the most preferred.

In the repeating units of the formula (1a) which may contain a polymer used as a starting material in the present invention, Ar⁰ represents an arylene, divalent heterocyclic or divalent aromatic amine group. Ar⁰ has no C-H bond on the aromatic ring and may have a substituent.

The arylene, divalent heterocyclic or divalent aromatic amine groups represented by Ar⁰ are defined as identical with those of the afore-shown arylene, divalent heterocyclic or divalent aromatic amine groups of Ar¹ in which R is a valence bond or a substituent. In the arylene, divalent heterocyclic or divalent aromatic amine groups represented by Ar⁰, any two of R's in their formulae are a valence bond, with the remainder representing a substituent. When there exist plural substituents represented by R, they may be identical or different from each other. Ra represents a hydrogen atom or a substituent. When there exist plural substituents represented by Ra, they may be identical or different from each other. When two Ra's exist on a same atom, they may be combined together to form an oxo or thioxo group, or may be bonded to each other to form a ring.

The divalent heterocyclic groups represented by Ar⁰ also include the groups shown below by the formulae 4A-1 to 4A-4.

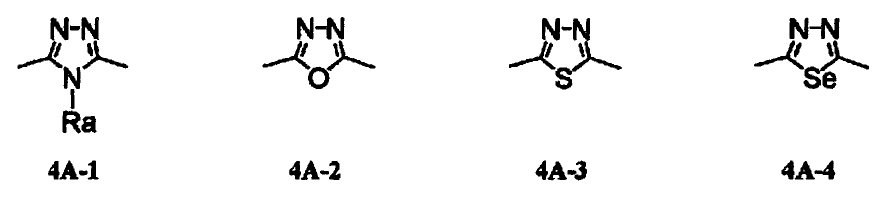

### (wherein Ra has the same meaning as defined above.)

In the above-shown formulae X-1 to X-11 of the linking groups which the polymer used as a starting material in the present invention may have, Ar represents a hydrocarbon group with a carbon number of 6 to 60, and R" represents a group selected from hydrogen atom, alkyl group, aryl group and monovalent heterocyclic group. Examples of the hydrocarbon groups represented by Ar are the same as those of the afore-shown arylene groups of Ar¹ which have an aromatic ring structure indicated by any one of the formulae 1A-1 to 1A-14. Regarding the alkyl, aryl or monovalent heterocyclic groups represented by R", there can be presented as their examples the same groups as presented in the exemplification of the substituent R in Ar¹.

As examples of the groups comprising a combination of two or more of the linking groups represented by the above-shown formulae X-1 to X-11, there can be presented the groups indicated by the above-shown formulae XX-1 to XX-4, the C₁-C₂₀ alkyl chain which may have a linear or branched structure ot may have a cyclic structure, and the C₁-C₂₀ alkyl chain in which any -CH₂- group is cut off by a group represented by one of the formulae X-1 to X-15. Examples of the C₁-C₂₀ alkyl chain are methylene, ethylene, propyl-1,3-diyl, butyl-1,4-diyl, pentyl-1,5-diyl, hexyl-1,6-diyl, octyl-1,8-diyl, decyl-1,10-diyl, octadecyl-1,18-diyl, butyl-2,3-diyl, 2,6-dimethyloctyl-1,8-diyl, cyclohexyl-1,4-diyl, and cyclohexyl-1,4-dimethyl-1'-1"-diyl.

Among the linking groups having a nonconjugated portion represented by the above-shown formulae X-1 to X-11 and XX-1 to XX-4, those indicated by the formulae X-3, X-5, X-6 and X-8 to X-11 are preferred, and those indicated by the formulae X-3, X-5, X-6 and X-8 to X-10 are more preferred, with those indicated by the formulae X-3, X-5 and X-6 being even more preferred.

In the process for producing an aromatic polymer of the present invention, it is essential that the aromatic polymer used as the starting material meets the requirement that the total of the linking groups having a nonconjugated portion indicated by any one of the formulae X-1 to X-11 is 40 mol% or less, preferably 30 mol% or less, more preferfably 20 mol% or less, even more preferably 10 mol% or less, based on the total number of the repeating units represented by the above-shown formula (1) or (1a). Most preferably, the starting compound contains no linking group having a nonconjugated portion.

Concerning the total of the linking groups in the nonconjugated portion, each of the linking groups indicated by the formulae X-1 to X-11 is counted as one, and in the case of the linking group comprising a combination of two or more groups, the total number of the linking groups indicated by the respective formulae X-1 to X-11 is counted. For instance, the linking group indicated by the formula X-12 is counted as two. In the case of a branched alkyl chain, the minimum number of the linking groups of the portion connecting the repeating units to each other is counted. For instance, the 2,6-dimethyloctyl-1,8-diyl group is counted as 8.

Now, the reaction for converting C-H bond on the aromatic ring in the process of the present invention is explained.

For the reaction for converting C-H bond on the aromatic ring, the methods shown in Table 1 below are available for instance.

**Table 1**

| Aromatic C-H bond conversion reactions | Groups formed Groups formed |
|---|---|
| Halogenation | -Cl, -Br, -I |
| Nitration | -NO₂ |
| Friedel-Crafts alkylation | Alkyl group |
| Halomethylation | -CH₂Cl, -CH₂Br, -CH₂I |
| Friedel-Crafts acylation | Acyl group |
| Gattermann aldehyde synthesis | -CHO |
| Vilsmeier formylation | -CHO |

The reaction conditions will be described in further detail below. The halogenation reaction is carried out using a halogenating agent such as bromine, chlorine, iodine, iodine monochloride, N-chlorosuccinimide, N-bromosuccinimide or N-iodosuccinnimide in an amount of one to 10 equivalents to the halogen group to be introduced. In the reaction, it is possible to add 0.01 to 50 equivalents of an acid such as acetic acid, sulfuric acid, trifluoroacetic acid or trifluoromethanesulfonic acid depending on the reactivity. As the solvent, an organic solvent such as chloroform, dichloromethane, 1,2-dichloroethane, N,N-dimethylformamide or tetrahydrofuran can be used advantageously, but an acid such as acetic acid or sulfuric acid may be used as solvent. The reaction can be let proceed at a temperature of usually about 0 to about 100°C. The reaction time is, for instance, 5 minutes to 100 hours, but any time will do as far as the reaction is allowed to proceed as desired. Since there is no need of letting the reaction product stand for a long time after the completion of the reaction, the preferred reaction time is from 10 minutes to 50 hours. As for the concentration of the reaction mixture in carrying out the reaction, it should be noted that a too low concentration will worsen the reaction efficiency while a too high concentration may cause precipitation of the polymer to make it difficult to control the reaction proceeding. So, it should be selected properly within the range from about 0.01 wt% to the maximum concentration allowing dissolution of the reactants. Usually, the concentration is in the range of 0.1 to 30 wt%. Regarding the halogenation method, reference is made, for instance, to Polymer, Vol. 30, p. 1137 (1989), and JP-A-2002-241493.

The nitration reaction is carried out properly at a temperature of from 0°C to the boiling point using a nitrating reagent such as mixed acid, concentrated nitric acid or concentrated nitroacetic acid.

The Friedel-Crafts alkylation, halomethylation and Friedel-Crafts acylataion reactions are carried out properly by reacting an alkylating reagent such as alkyl halide, terminal alkene or alcohol, and formaldehude with a halomethylating reagent such as hydrogen chloride and an acylating reagent such as an acid chloride, acid anhydride or carboxylic acid in the presence of an acid catalyst such as AlCl₃, FeCl₃, BF₃ or ZnCl₂ at a temperature of from room temperature to around 200°C. These reactions are described in, for instance, Organic Reactions, Vol. 2, p.114 (1944).

In the Gattermann aldehyde synthesis, formylation is carried out by acting, for instance, hydrogen cyanide, Zn(CN)₂, triazine or the like with hydrogen chloride or the like in the presence of a Lewis acid such as AlCl₃. This reaction is described in, for instance, Organic Reactions, Vol. 9, p. 37 (1957), and Chemical Review, Vol. 63, p. 526 (1963).

In the Vilsmeier formylation reacton, formylation can be accomplished by properly reacting 1 to 5 equivalents of POCl₃ in N,N-dimethylformamide at a temperature of from around -20°C to around 40°C. This reaction is described in, for instance, Shin-Jikken Kagaku Koza (Lectures on New Experimental Chemistry), Vol. 14, p. 688 (1977).

The step (A) includes the reactions for turning the groups introduced by the respective reactions described above further into the characteristic groups by the pertinent reactions. Various known functional conversion reactions can be used for such turning reactions, with some of the known conversion reactions being shown in Table 2 below.

**Table 2**

| Groups to be converted | Conversion reaction | Groups formed |
|---|---|---|
| -NO₂ | Reduction | -NH₂ |
| -NH₂ | Diazotization | Diazonium salt |
| Diazonium salt | Sandmeyer halogenation | Halogen atoms (-F, -Cl, -Br, -I) |
| Diazonium Salt | Oxidation | -OH |
| -OH | Sulfonation | -OSO₂Q¹ |
| Halogen atom | Metalation | -Z¹(Z²)m, -Sn(Q³)₃ |
| -Z¹(Z²)m | Conversion to boric acid | -B(OQ2)2 |
| -Z¹(Z²)m | Oxidation, hydrolysis | -OH |
| -Z¹(Z²)m | Formylation | -CHO |
| Methyl group | Halomethylation | Halomethyl group (-CH₂Cl, -CH₂Br, -CH₂I) |
| Halomethyl group | Iridation, conversion to Horner reagent | -CHQ⁴-P⁺(Q⁵)₃Z⁴, -CHQ⁶-P(=O)(OQ⁷)₂ |

A halogenation reaction is preferred for the conversion of C-H bond on the aromatic ring in view of reactivity and ease of control of the introduction rate.

After the end of the reaction, the reaction solution may be used directly for the next reaction, but the polymer obtained after the reaction may be subjected to the ordinary separating, purifying, drying and other operations such as pickling, alkali cleaning, neutralization, water washing, organic solvent cleaning, reprecipitation, centrifuging, extraction, column chromatography, etc., as occasion demands. For the improvement of yield of the next reaction, it is preferable to conduct separation, purification and drying.

In the repeating units of the formula (2') in the step A in the process of the present invention, the characteristic group X^{b} may be, for instance, a halogen atom, -OSO₂Q¹, -B(OQ²)₂, -Sn(Q³)₃, Z¹(Z²)m, -OH, -CH₂Z³, -CHQ⁴-P⁺(Q⁵)₃Z⁴, -CHQ⁶-P(=O)(OQ⁷)₂, -C(=O)Q⁸, -NH₃ or a diaonio group.

In the above formulae, Q¹ is a hydrocarbon group, and Q² is a hydrogen atom or a hydrocarbon group. Two Q²'s may be identical or different from each other and may be bonded to each other to form a ring. Q³ is a hydrocarbon group, and three Q³'s may be identical or different from each other. Q⁴ is a hydrogen atom or a hydrocarbon group, and Q⁵ is a hydrocarbon group. Three Q⁵'s may be identical or different from each other. Q⁶ is a hydrogen atom or a hydrocarbon group. Q⁷ is a hydrocarbon group, and two Q⁷'s may be identical or different from each other. Q⁸ is a hydrogen atom or a hydrocarbon group. Z¹ is a metal atom or a metal ion, Z² is a counter anion, m is an integer of 0 or greater, Z³ is a halogen atom or a cyano group, and Z⁴ is a monovalent counter anion.

The reactions shown in Table 2 are explained in further detail.

It is known that -NO₂ group can be reduced into -NH₂ group by acting a metal such as zinc, iron or tin with an acid such as hydrochloric acid. It is also known that -NH₂ group can be turned into a diazonium salt by, for instance, diazotizing this group with nitrous acid purified by acting NaNO₂ with an acid such as hydrochloric acid.

It is known that the diazonium salt can be converted into a halogen atom by, for instance, acting hydrochloric acid, hydrobromic acid or the like in the presence of copper halide (I) through a Sandmeyer reaction. This reaction is described in, for instance, Organic Synthesis, Collective Volume, Vol. 3, p. 185 (1955), and Organic Synthesis, Collective Volume, Vol. 5, p. 133 (1973). It is known that the diazonium salt can be converted into -OH group by heating it in the presence of water under an acidic condition.

Concerning the reaction for converting a halogen atom into -Z¹(Z²)m group, it is known that this halogen atom can be lithionized by use of a lithionizing reagent such as n-alkyllithium. It is also known that this halogen atom can be converted into a magnesium halide group, zinc halide group or such by a metallizing reaction in which metallic magnesium, zinc or the like is acted, or a Grignard conversion reaction using isopropyl(i-Pr)MgCl. These reactions are described in, for instance, Angew. Chem. Int. Ed. Vol. 37, p. 1701 (1998). The Grignard reaction is discussed in, for instance, Bulletin of Chemical Society of Japan, Vo. 51, p. 2091 (1978), and Chemistry Letters, p. 353 (1977).

It is further known that the halogen atom can be converted into a group represented by -Sn(Q³)₃ by acting hexaalkyldistannane in the presence of a palladium catalyst. This reaction is reviewed in, for instance, Angew. Chem. Int. Ed. Vol. 25, p. 508 (1986).

It is known that a group represented by -Z¹(Z²)m, such as -Li, -MgCl or -MgBr group, can be transformed into -B(OH)₂ group by, for instance, hydrolyzing it by acting trimethoxyboran. It is also known that this -Z¹(Z²)m group can be turned into a boric acid ester group by acting isopropoxypinacolboran. This reaction is described in, for instance, Journal of American Chemical Society, Vol. 126, p. 7041 (2004).

It is known that the -Z¹(Z²)m group such as -Li, -MgCl or -MgBr can be also converted into -OH group by, for instance, conducting oxidative destruction with hydrogen peroxide after acting trialkoxyboran.

It is also known that this -Z¹(Z²)m group can be converted into -CHO group by, for instance, acting DMF or N-formylpiperidine. This reaction is mentioned in, for instance, Synthesis, p. 228 (1984).

It is known that a methyl group can be converted into a halomethyl group such as -CH₂Cl or -CH₂Br by acting SOCl₂, SOBr₂ or the like, and it is also known that a halomethyl group can be turned into a group represented by -CHQ⁴-p⁺(Q⁵)₃Z⁴ by acting triphenylphosphine. It can be also turned into a group represented by -CHQ⁶-P(=0)(OQ⁷)₂ by acting trialkyl phosphite or the like through an Arbuzov reaction.

Regarding the characteristic group X in the repeating units of the above-shown formula (2'), this group can be, for instance, a halogen atom such as, for instance, fluorine atom, chlorine atom, bromine atom or iodine atom, of which chlorine atom, bromine atom and iodine atom are preferred, and chlorine atom and bromine atom are more preferred, with bromine atom being even more preferred.

As the hydrocarbon group in the groups represented by Q¹, Q², Q³, Q⁴, Q⁵, Q⁶, Q⁷ and Q⁸ in the above-shown formulae, the following can be presented as examples: alkyl groups with a carbon number of around 1 to around 50 such as methyl, ethyl, propyl, isopropyl, butyl, isobutyl, t-butyl, pentyl, hexyl, nonyl, dodecyl, pentadecyl, octadecyl and dococyl; cyclic saturated hydrocarbon groups with a carbon number of around 3 to around 50 such as cyclopropyl, cyclobutyl, cyclopentyl, cyclohexyl, cyclononyl, cyclododecyl, norbonyl and adamantyl; alkenyl groups with a carbon number of around 2 to around 50 such as ethenyl, propenyl, 3-butenyl, 2-butenyl, 2-pentenyl, 2-hexenyl, 2-nonenyl and 2-dodecenyl; aryl groups with a carbon number of around 6 to around 50 such as phenyl, 1-naphthyl, 2-naphthyl, 2-methylphenyl, 3-methylphenyl, 4-methylphenyl, 4-ethylphenyl, 4-propylphenyl, 4-isopropylphenyl, 4-butylphenyl, 4-t-butylphenyl, 4-hexylphenyl, 4-cyclohexylphenyl, 4-adamantylphenyl and 4-phenylphenyl; and aralkyl groups with a carbon number of around 7 to around 50 such as phenylmethyl, 1-phenyleneethyl, 2-phenylethyl, 1-phenyl-1-propyl, 1-phenyl-2-propyl, 2-phenyl-2-propyl, 1-phenyl-3-propyl, 1-phenyl-4-butyl, 1-phenyl-5-pentyl and 1-phenyl-6-hexyl. These hydrocarbon groups are preferably those with a carbon number of 1 to 20. Those with a carbon number of 1 to 12 are more preferred, and those with a carbon number of 1 to 8 are even more preferred. These hydrocarbon groups may have a substituent.

Q¹ in the formula -OSO₂Q¹ designates a hydrocarbon group which may have a substituent. As examples of such a hydrocarbon group, those mentioned above can be presented. Examples of the substituent are fuorine atom and nitro group..

Examples of the groups represented by -OSO₂Q¹ are alkyl sulfonate groups such as methane sulfonate, ethane sulfonate and trifluoromethane sulfonate, aryl sulfonate groups such as benzene sulfonate, p-toluene sulfonate, p-nitrobenzene sulfonate and o-nitrobenzene sulfonaate, and arylalkyl sulfonate groups such as benzene sulfonate. Of these groups, trifluoromethane sulfonate, benzene sulfonate, p-toluene sulfonate and p-nitrobenzene sulfonate are preferred, and trifluoromethane sulfonate is more preferred.

Q² in the formula -B(OQ²)₂ is a hydrogen atom or a hydrocarbon group which may have a substituent. Two Q²' s may be identical or different from each other, or may be bonded to each other to form a ring. The afore-mentioned hydrocarbon groups can be presented as examples of Q². Of these hydrocarbon groups, alkyl is preferred, and methyl, ethyl, propyl, isopropyl, butyl, isobutyl, pentyl, hexyl and nonyl are more preferred, with methyl, ethyl, propyl, butyl, pentyl and hexyl being even more preferred. In case two Q²'s are bonded to form a ring, the bifunctional hydrocarbon group comprising these two Q²'s is preferably selected from 1,2-ethylene, 1,1,2,2-tetramethyl-1,2-ethylene, 1,3-propylene, 2,2-dimethyl-1,3-propylene and 1,2-phenylene. Amino group can be cited as an example of the substituent.

Examples of the groups represented by -B(OQ²)₂ include those designated by the following formulae:

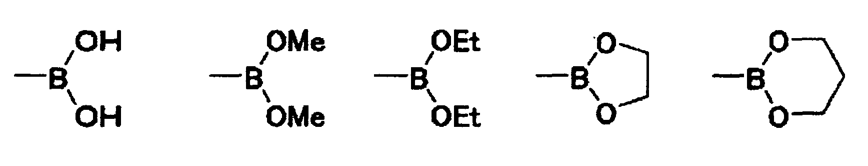

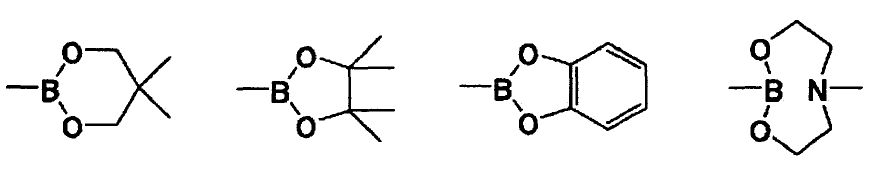

Q³ in the formula -Sn(Q³)₃ represents a hydrocarbon group which may have a substituent, and three Q³'s may be identical or different from each other. The afore-shown hydrocarbon groups can be presented as examples of Q³, of which alkyl is preferred, and methyl, ethyl, propyl, isopropyl, butyl, isobutyl, pentyl, hexyl and nonyl are more preferred. Methyl, ethyl, propyl, butyl, pentyl and hexyl are even more preferred. Amino group and alkoxyl group can be cited as examples of the substituent.

Examples of the groups represented by -Sn(Q³)₃ are tri(n-butyl)tin group and triphenyltin group.

Z¹ in the formula Z¹(Z²)m is a metal atom or a metal ion, Z² is a counter anion, and m is an integer of 0 or greater. Examples of the metal atoms or metal ions represented by Z¹ are the atoms or ions of Li, Na, K, Rb, Cs, Be, Mg, Ca, Sr, Ba, Al, Ga, In, Tl, Pb, Sc, Ti, V, Cr, Mn, Fe, Co, Ni, Cu, Zn, Y, Zr, Nb, Mo, Tc, Ru, Rh, Ag, Cd, La, Ce, Sm, Eu, Hf, Ta, W, Re, Os, Ir, Pt, Au and Hg. Of these metals, Li, Na, K, Rb, Cs, Be, Mg, Ca, Sr, Ba, Al, Ga, In, Tl, Pb, Sc, Ti, Cu, Zn, Y, Zr, Ag and Hg are preferred, and Li, Na, K, Rb, Cs, Be, Mg, Ca, In, Tl, Pb, Cu, Zn, Zr, Ag and Hg are more preferred. Li, Na, K, Mg, Ca, Cu and Zn are even more preferred.

Conjugated bases of Brønsted acid are usually used as Z². Examples of such conjugated bases are fluoride ion, chloride ion, bromide ion, iodide ion, sulfate acid ion, nitrate ion, carbonate ion, perchloride ion, tetrafluoroborate ion, hexafluorophosphate ion, methanesulfonate ion, trifluoromethanesulfonate ion, toluenesulfonate ion, acetate ion, trifluoroacetate ion, propionate ion, benzoate ion, hydroxide ion, oxide ion, methoxide ion, and ethoxide ion. Preferred among them are chloride ion, bromide ion, iodide ion, sulfate ion, nitrate ion, carbonate ion, methanesulfonate ion, trifluoromethanesulfonate ion, toluenesulfonate ion, acetate ion, trifluoroacetate ion, propionate ion, and benzoate ion. More preferred are chloride ion, bromide ion, iodide ion, methanesulfonate ion, trifluoromethanesulfonate ion, toluenesulfonate ion, acetate ion, trifluoroacetate ion, propionate ion, and benzoate ion. Even more preferred are chloride ion, bromide ion, iodide ion, methanesulfonate ion, trifluoromethanesulfonate ion, acetate ion, and trifluoroacetate ion.

In the formula Z¹(Z²)m, m is an integer which is decided so that the aromatic compound represented by the above-shown general formula (1) will become electrically neutral. In case the characteristic group X is Z¹(Z²)m, that is, when the repeating unit represented by the above-shown general formula (2) is defined by the following formula (2-2): 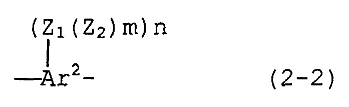 preferably the portion of Z¹(Z²)m is assumed to have a valence of + 1 and the portion indicated by the following formula (2-3):

[-Ar²-] (2-3)

is assumed to have a valence of - n while also assuming that the portion of Z¹(Z²) m and the remaining portion are ion bonded.

As the atomic groups represented by the formula Z¹(Z²)m, zinc halide groups, alkaline metal atoms and halogenated alkaline earth metal groups can be cited as examples. Examples of the zinc halide groups are zinc chloride group, zinc bromide group and zinc iodide group, with the first mentioned two being preferred. Examples of the alkaline metal atoms are lithium, sodium, potassium, etc., of which lithium and sodium are preferred. Examples of the halogenated alkaline earth metal groups are magnesium chloride group, magnesium bromide group, magnesium iodide group, calcium chloride group, calcium bromide group, and calcium iodide group, of which magnesium chloride group, magnesium bromide group and magnesium iodide group are preferred.

Z³ in the formula -CH₂Z³ represents a halogen atom or a cyano group. Examples of the halogen atom represented by Z³ are chlorine atom, bromine atom and iodine atom, of which chloride atom and bromine atom are preferred.

Q⁴ in the formula -CHQ⁴-P⁺(Q⁵)₃Z⁴ is a hydrogen atom or a hydrocarbon group. The above-mentioned hydrocarbon groups can be presented as examples of the hydrocarbon group represented by Z⁴, with methyl, ethyl, propyl, butyl, hexyl and octyl groups being preferred. Q⁵ is a hydrocarbon group which may have a substituent, and three Q⁵'s may be identical or different from each other. As examples of this hydrocarbon group, there can be shown the same hydrocarbon groups as mentioned above, with methyl, ethyl, propyl, butyl and phenyl groups being preferred. Z⁴ represents a monovalent counter anion. Usually a conjugated base of a Brφnsted acid is used as such a counter anion, the examples thereof being fluoride ion, chloride ion, bromide ion, iodide ion, sulfate ion, nitrate ion, carbonate ion, perchlorate ion, tetrafluoroborate ion, hexafluorophosphate ion, methanesulfonate ion, trifluoromethanesulfonate ion, toluenesulfonate ion, acetate ion, trifluoroacetate ion, propionate ion, benzoate ion, hydroxide ion, oxide ion, methoxide ion, and ethoxide ion, of which chloride ion, bromide ion, iodide ion, tetrafluoroborate ion and trifluoromethanesulfonate ion are preferred, and chloride ion and bromide ion are more preferred. The following can be presented as examples of the groups represented by the formula -CHQ⁴-P⁺(Q⁵)₃Z⁴:

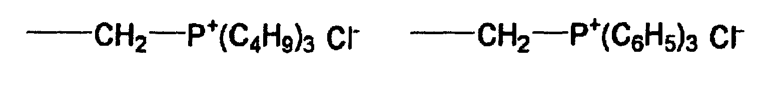

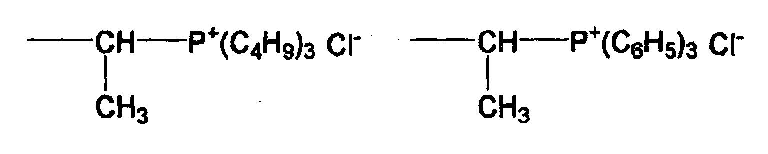

-CH₂-P⁺(C₄H₉)₃ Br⁻ -CH₂-P⁺(C₆H₅)₃ Br⁻

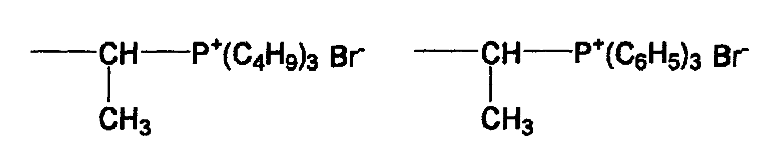

Q⁶ in the formula -CHQ⁶-P (=O) (OQ⁷)₂ is a hydrogen atom or a hydrocarbon group. The above-mentioned hydrocarbon groups can be cited as examples of the hydrocarbon groups represented by Q⁶. Of these hydrocarbon groups, methyl, ethyl, propyl, butyl, hexyl and octyl groups are preferred. Q⁷ is a hydrocarbon group which may have a substituent. Two Q⁷'s may be identical or different from each other. As examples of this hydrocarbon group, the aforementioned ones can be cited, of which methyl, ethyl, propyl, butyl and phenyl groups are preferred.

Q⁸ in the formula -C(=O)Q⁸ represents a hydrogen atom or a hydrocarbon group, the examples thereof being the aforementioned ones, of which methyl, ethyl, propyl, butyl, hexyl, octyl, phenyl and benzyl groups are preferred. Examples of the groups represented by -C(=O)Q⁸ are formyl, acetyl, benzoyl and benzylcarbonyl groups, of which formyl and benzoyl groups are preferred.

Examples of the diazonio groups are -N₂⁺Br⁻, -N₂⁺Cl⁻, -N₂⁺(HSO₄)⁻ and -N₂⁺(BF₄)⁻.

As the characteristic group X introduced in the process of the present invention, in view of reactivity at the time of introduction and easy control of the introduction rate, halogen atom and the groups derived from halogen atom, such as -OSO₂Q¹, -B(OQ²)₂, -Sn(Q³)₃, Z¹(Z²)m. -OH and -C (=O) Q⁸, are preferred. Halogen atom, -OSO₂Q¹, -B(OQ²)₂, -Sn(Q³)₃, Z¹(Z²)m and -CHO are more preferred, with halogen atom being the most preferred.

Next, a process for producing an aromatic polymer having a bromo group under a mild condition and in a high yield with a high bromination yield while controlling the rate of bromination is explained. This process is characterized in that a brominating agent is acted to an aromatic polymer having one or more types of repeating unit represented by the general formula (1) in an organic solvent in the presence of an organic strong acid of an amount 5 times or more by mol the total number of the repeating units.

Examples of the organic strong acid used in this process are trifluoroacetic acid, trifluoromethanesulfonic acid, nonafluoro-n-butanesulfonic acid, methanesulfonic acid, p-toluenesulfonic acid and p-nitrobenzenesulfonic acid, of which trifluoroacetic acid and trifluoromethanesulfonic acid are preferred, the former being more preferred in view of ease of purification of the obtained brominated aromatic polymer.

As for the amount of the organic strong acid used, it needs to be used in an amount which is 5 times or more, preferably 10 times or more, more preferably 15 times or more by mol the total number of the repeating units in the aromatic polymer having one or more types of repeating units represented by the general formula (1). Its upper limit is preferably of a level which won't hinder solubility of the obtained aromatic polymer. Specifically, its amount used is preferably 30 wt% or less, more preferably 20 wt% or less of the organic solvent used. If the amount of the organic strong acid used is below the above-said lower limit, reactivity may be deteriorated, and when its amount exceeds the above-said upper limit, solubility of the aromatic polymer may be affected.

As the brominating agent, bromine is preferred in view of economy, bromination reactivity and ease of purification of the brominated aromatic 5 polymer obtained by the process of the present invention.

In the process of the present invention, because of high bromination yield, it is possible to control the bromination rate of the aromatic polymer by adjusting the feed of the brominating agent. So, the amount of the brominating agent to be used is selected according to the objective rate of bromination. Preferably it is in the range of one to 5 mol% based on the total of the repeating units represented by the formula (1). For controlling the bromination rate with high precision, the rate of bromination is preferably 100% or below, more preferably 80% or below, even more preferably 60% or below, still more preferably 50% or below. In the present invention, the "rate of bromination" means the ratio of the number of the introduced bromine atoms to the total number of the repeating units represented by the formula (1), and the "bromination yield" means the ratio of the number of moles of the bromine atoms introduced to the aromatic polymer to the number of moles of bromine used as the halogenating agent.

As the organic solvent used here, halogenated methanes and halogenated ethanes are preferred. Here, "halogenated methanes" mean a group of the compounds in which 1 to 4 of the four hydrogen atoms of methane have been substituted with a halogen atom. A similar meaning is had by "halogenated ethanes." As the organic solvent used here, methylene chloride, chloroform and 1,2-dichloroethane are preferred. In selection of the organic solvent, the type having a high solubility for the aromatic polymer used is preferred. Preferably an organic solvent capable of dissolving 0.1 wt% or more, more preferably 0.5 wt% or more, even more preferably 1 wt% or more of the aromatic polymer is selected.

In consideration of reactivity and solubility for the starting material, the amount of the organic solvent is properly selected within the range of 10 to 1,000 times, preferably 20 times or more, more preferably 40 times or more the starting aromatic polymer in weight. Its upper limit is preferably 500 times or less, more preferably 300 times or less the starting aromatic polymer in weight.

The bromination reaction temperature is properly selected within the range of usually from 0°C to boiling point of the solvent depending on the solubility of the aromatic polymer and the boiling point of the organic strong acid used. The mixture may be refluxed. In case the boiling point of the organic strong acid is lower than that of the solvent, the reaction is preferably carried out at a temperature below the boiling point of the organic strong acid. For suppressing the side reactions other than the bromination reaction, it is advisable to conduct the reaction at a temperature in the range of 0 to 30°C.

The time for the bromination reaction is usually 10 minutes or more, preferably around one to around 200 hours, although variable depending on the reaction conditions such as reaction temperature.

The bromination rate of the aromatic polymer can be determined by conventional means such as NMR and organic elemental analysis.

The aromatic polymer having repeating units with a characteristic group X produced by the process of the present invention has the repeating units represented by the above-shown formula (2'). Ar^{2b} in the formula (2') represents an arylene or heterocyclic group with a valence of m' + 2 in which m' of C-H bonds on the aromatic ring possessed by Ar¹ have been converted into C-X bonds, and m' is an integer of 1 to 4.

In the above-shown formula (2'), m' represents an integer of 1 to 4, preferably 1 or 2, more preferably 1.

The aromatic polymer having repeating units with a characteristic group X produced in the process of the present invention and the aromatic polymer used as the starting material may be a random, block or graft copolymer, or a polymer having an intermediate structure, for example, a block-oriented random copolymer. It also includes the type of polymer which is branched in the backbone and has three or more terminals.

The aromatic polymer having repeating units with a characteristic group X produced in the process of the present invention and the aromatic polymer used as the starting material are typically the polymers whose polystyrene-reduced number-average molecular weight falls in the range of 10³ to 10⁸, preferably 5 x 10³ to 5 x 10⁷.

The conventional methods can be used for withdrawal and purification of the aromatic polymer produced in the process of the present invention. For example, the reaction solution is poured into a poor solvent to cause precipitation of the aromatic polymer having repeating units with a characteristic group X, and the objective material is taken out by suitable means such as filtration, then washed with water and purified by reprecipitation using both a good and a poor solvents.

(III) Application of the polymer produced by the process of the present invention to the polymeric light-emitting devices is here described.

The polymer produced according to the process of the present invention can be applied advantageously, for instance, to the polymeric light-emitting devices (polymer LED). Polymer LED has, in its structure, a light-emitting layer interposed between the electrodes comprising a pair of anode and cathode, at least one of which is transparent or translucent, and the polymer obtained from the process of the present invention is contained in the said light-emitting layer.

Polymer LED's contemplated here include the type in which an electron transport layer is provided between the cathode and the light-emitting layer, the type in which a hole transport layer is provided between the anode and the light-emitting layer, and the type in which an electron transport layer is provided between the cathode and the light-emitting layer and also a hole transport layer is provided between the anode and the light-emitting layer.

More specifically, polymer LED's presented here include those of the structures a) to d) shown below:
a) anode/light-emitting layer/cathode
b) anode/hole transport layer/light-emitting layer/cathode
c) anode/light-emitting layer/electron transport layer/cathode
d) anode/hole transport layer/light-emitting layer/electron transport layer/cathode.
(In the above structural formats a) to d), the slash marks (/) indicate that the respective layers are laminated one on another. This applies in the following description.)

Here, "light-emitting layer" is a layer having a function to emit light, "hole transport layer" is a layer having a function to transport the hole, and "electron transport layer" is a layer having a function to transport electrons. The electron transport layer and the hole transport layer are both referred to as "charge transport layer". Each of the light-emitting, hole transport and electron transport layers may be provided two or more in number.

Among the charge transport layers provided adjacent to the electrodes, those having a function to improve charge injecting efficiency from the electrodes and also having an effect to lower drive voltage of the element are generally called charge injection layer (hole injection layer, electron injection layer).

In order to improve adhesion to the electrode or charge injection from the electrode, it is possible to provide said charge injection layer or an insulating layer with a thickness of 2 nm or less adjacent to the electrode. It is also possible to interpose a thin buffer layer at the interface between the charge transport layer and the light-emitting layer for improving adhesion at the interface or for preventing mixing of the layer materials. The order of lamination, the number of the laminated layers and the thickness of the respective layers can be properly decided in consideration of light-emitting efficiency and expected life of the element.

The polymer LED's provided with the charge injection layers (electron injection layer and hole injection layer) include the type in which a charge injection layer is provided adjacent to a cathode, and the type in which a charge injection layer is provided adjacent to an anode. More specifically, these LED's include those of the structures e) to p) shown below:
e) anode/charge injection layer/light-emitting layer/cathode
f) anode/light-emitting layer/charge injection layer/cathode
g) anode/charge injection layer/light-emitting layer/charge injection layer/cathode
h) anode/charge injection layer/hole transport layer/light-emitting layer/cathode
i) anode/hole transport layer/light-emitting layer/charge injection layer/cathode
j) anode/charge injection layer/hole transport layer/light-emitting layer/charge injection layer/cathode
k) anode/charge injection layer/light-emitting layer/electron transport layer/cathode
l) anode/light-emitting layer/electron transport layer/charge injection layer/cathode
m) anode/charge injection layer/light-emitting layer/electron transport layer/charge injection layer/cathode
n) anode/charge injection layer/hole transport layer/light-emitting layer/electron transport layer/cathode
o) anode/hole transport layer/light-emitting layer/electron transport layer/charge injection layer/cathode
p) anode/charge injection layer/hole transport layer/light-emitting layer/electron transport layer/charge injection layer/cathode.

Exemplary of the charge injection layer are a layer containing a conductive polymer, a layer provided between an anode and a hole transport layer and containing a material having an ionization potential of a value intermediate between those of the anode material and the hole transport material contained in the hole transport layer, and a layer provided between a cathode and an electron transport layer and containing a material having an electron affinity of a value intermediate between those of the cathode material and the electron transport material contained in the electron transport layer.

When the charge injection layer is a layer containing a conductive polymer, electric conductivity of the conductive polymer is preferably from 10⁻⁵ S/cm to 10³ S/cm. For minimizing leak current between the light-emitting pixels, said electric conductivity is preferably from 10⁻⁵ S/cm to 10² S/cm, more preferably from 10⁻⁵ S/cm to 10¹ S/cm. Usually the conductive polymer is doped with an adequate amount of ion for keeping electric conductivity of the conductive polymer within the range from 10⁻⁵ to 10³ S/cm.

The type of the ion to be doped is anion in the case of the hole injection layer and cation in the case of the electron injection layer. Examples of the anion are polystyrenesulfonic acid ion, alkylbenzenesulfonic acid ion and camphoric acid ion, and examples of the cation are lithium ion, sodium ion, potassium ion and tetrabutylammonium ion. Thickness of the charge injection layer is, for instance, 1 to 100 nm, preferably 2 to 50 nm.

The material used for the charge injection layer can be properly selected in consideration of the materials of the electrode and the adjoining layers. For instance, polyaniline and its derivatives, polythiophene and its derivatives, polypyrrole and its derivatives, polyphenylenevinylene and its derivatives, polythienylenevinylene and its derivatives, polyquinoline and its derivatives, polyquinoxaline and its derivatives, conductive polymers, for example, polymers having an aromatic amine structure in the main or side chain, metal phthalocyanine (copper phthalocyanine), carbon and the like can be used.

The insulating layer with a thickness of 2 nm or less has a function to facilitate charge injection. As the material of this insulating layer, metal fluorides, metal oxides and organic insulating materials can be cited as examples. Examples of the polymer LED's provided with said insulating layer include the type provided with said insulating layer adjacent to a cathode and the type provided with said insulating layer adjacent to an anode.

More specifically, these LED's include those of the following structures q) to ab):
q) anode/2 nm or less insulating layer/light-emitting layer/cathode
r) anode/light-emitting layer/2 nm or less insulating layer/cathode
s) anode/2 nm or less insulating layer/light-emitting layer/2 nm or less insulating layer/cathode
t) anode/2 nm or less insulating layer/hole transport layer/light-emitting layer/cathode
u) anode/hole transport layer/light-emitting layer/2 nm or less insulating layer/cathode
v) anode/2 nm or less insulating layer/hole transport layer/light-emitting layer/2 nm or less insulating layer/cathode
w) anode/2 nm or less insulating layer/light-emitting layer/electron transport layer/cathode
x) anode/light-emitting layer/electron transport layer/2 nm or less insulating layer/cathode
y) anode/2 nm or less insulating layer/light-emitting layer/electron transport layer/2 nm or less insulating layer/cathode
z) anode/2 nm or less insulating layer/hole transport layer/light-emitting layer/electron transport layer/cathode
aa) anode/hole transport layer/light-emitting layer/electron transport layer/2nm or less insulating layer/cathode
ab) anode/2 nm or less insulating layer/hole transport layer/light-emitting layer/electron transport layer/2 nm or less insulating layer/cathode

By use of these organic solvent-soluble polymers obtained by the process of the present invention, when forming a film from its solution in producing a polymer LED, it suffices to remove the solvent by drying after coating the solution. The similar techniques can be applied where the electron transport material and/or light-emitting material are mixed, providing a great advantage in manufacture of the said elements. For forming a film from the solution, there can be used, for instance, the following coating methods: spin coating, casting, microgravure coating, gravure coating, bar coating, roll coating, wire bar coating, dip coating, spray coating, screen printing, flexo printing, offset printing, and ink jet printing.

As for the thickness of the light-emitting layer, its optimal value varies depending on the material used, and it is selected so that the drive voltage and the light-emitting efficiency will take an appropriate value respectively. It is, for instance, in the range from 1 nm to 1 µm, preferably from 2 to 500 nm, more preferably from 5 to 200 nm.

In manufacture of polymer LED, a light-emitting material other than the polymer obtained by the process of the present invention may be mixed in the light-emitting layer. Also, in the polymer LED of the present invention, the light-emitting layer containing a light-emitting material other than the polymer of the present invention may be laminated with a light-emitting layer containing the polymer of the present invention. As such a light-emitting material, those known in the art can be used, including, for instance, the low-molecular compounds such as naphthalene derivatives, anthracene and its derivatives, perillene and its derivatives, dyes such as polymethine dye, xanthene dye, cumalin dye and cyanine dye, 8-hydroxyquinoline and metal complexes of its derivatives, aromatic amines, tetraphenylcyclopentadiene and its derivatives, and tetraphenylbutadiene and its derivatives. The known materials, specifically those disclosed in, for instance, JP-A-57-51781 and JP-A-59-194393 can be used.

In case the polymer LED has a hole transport layer, the following, for instance, can be used as the hole transport material: polyvinylcarbazole and its derivatives, polysilane and its derivatives, polysiloxane derivatives having an aromatic amine in the side or main chain, pyrazoline derivatives, arylamine derivatives, stilbene derivatives, triphenyldiamine derivatives, polyaniline and its derivatives, polythiophene and its derivatives, polypyrrole and its derivatives, poly(p-phenylenevinylene) and its derivatives, and poly(2,5-thienylenevinylene) and its derivatives. More specifically, as the hole transport material, those disclosed in, for instance, JP-A-63-70257, JP-A-63-175860, JP-A-2-135359, JP-A-2-135361, JP-A-2-209988, JP-A-3-37992, and JP-A-3-152184 can be cited as useful examples.

Of the materials mentioned above, the following are preferred for use as the hole transport material for the hole transport layer: polyvinylcarbazole and its derivatives, polysilene and its derivatives, polysiloxane derivatives having an aromatic amine compound in the side or main chain, polyaniline and its derivatives, polythiophene and its derivatives, poly(p-phenylenevinylene) and its derivatives, and poly(2,5-thienylenevinylene) and its derivatives. Among them, polyvinylcarbazole and its derivatives, polysilane and its derivatives, and polysiloxane derivatives having an aromatic amine in the side or main chain are more preferred. In the case of a low-molecuar hole transport material, it is preferably used as a dispersion in a polymeric binder. Polyvinylcarbazole and its derivatives can be obtained, for example, by cationic or radical polymerization of vinyl monomers.

As polysilane and its derivatives, the compounds disclosed in Chemical Review, Vol. 89, p. 1359 (1989), and British Patent GB2300196 can be cited as examples. For the synthesis of these materials, the methods also disclosed in the above documents are usable, but the Kipping method is preferred.

As polysiloxane and its derivatives, since the siloxane skeleton structure is almost devoid of hole transporting property, there are preferably used those having the structure of said low-molecular hole transport material in the side or main chain, especially those having a hole transportable aromatic amine in the side or main chain.

The method for forming the hole transport layer is not defined, but in case of using a low-molecular hole transport material, a method is preferred in which a film is formed from a mixed solution of the said material and a polymeric binder. In the case of a polymer hole transport material, a method comprising film formation from a solution is suited.

The solvent used for forming the film from a solution is not subject to any specific restrictions as far as it is capable of dissolving the hole transport material. For instance, the chlorine type solvents such as chloroform, methylene chloride and dichloroethane, ether type solvents such as tetrahydrofuran, aromatic hydrocarbon type solvents such as toluene and xylene, ketone type solvents such as acetone and methyl ethyl ketone, and ester type solvents such as ethyl acetate, butyl acetate and ethyl cellosolve acetate can be used.

As the method for forming the film from a solution, there can be used the known coating methods such as spin coating, casting, microgravure coating, gravure coating, bar coating, roll coating, wire bar coating, dip coating, spray coating, screen printing, flexo printing, offset printing, and ink jet printing.

As the polymeric binder to be mixed, it is preferred to use one which does not hinder charge transport to an excessive degree, especially one which does not show strong absorption of visible light. Examples of such polymeric binders are polycarbonate, polyacrylate, polymethyl acrylate, polymethyl methacrylate, polystyrene, polyvinyl chloride and polysiloxane.

The thickness of the hole transport layer varies in its optimal value depending on the material used. It is selected so that the drive voltage and light-emitting efficiency will take the appropriate values, but at least the thickness needs to be enough to prevent formation of pinholes. A too large thickness is undesirable as it may cause rise of drive voltage of the element. Thus, the thickness of the hole transport layer is usually in the range of 1 nm to 1 µm, preferably 2 to 500 nm, more preferably 5 to 200 nm.

In case the polymer LED has an electron transport layer, the known electron transport materials such as, for example, oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, 8-hydroxyquinoline and metal complexes of its derivatives, polyquinone and its derivatives, polyquinoxaline and its derivatives, and polyfluorene and its derivatives can be used for forming the electron transport layer.

More specifically, the materials disclosed in JP-A-63-70257, JP-A-63-175860, JP-A-2-135359, JP-A-2-135361, JP-A-2-209988, JP-A-3-37992 and JP-A-3-152184 can be cited as typical examples.

Of these materials, oxadiazole derivatives, benzoquinone and its derivatives, anthraquinone and its derivatives, 8-hydroxyquinoline and metal complexes of its derivatives, polyquinone and its derivatives, polyquinoxaline and its derivatives and polyfluorene and its derivatives are preferred, and 2-(4-biphenylyl)-5-(4-t-butylphenyl)-1,3,4-oxadiazole, benzoquinone, anthraquinone, tris(8-quinolinol)aluminum and polyquinoline are more preferred.

The method for forming the electron transport layer is not specifically restricted, but in case of using a low-molecular electron transport material, a vacuum deposition method using a powder or a method in which a film is formed from a solution or a molten state can be suggested, and in case of using a polymer electron transport material, a method comprising forming a film from a solution or a molten state can be cited as an example of film forming method. A polymeric binder may be used when forming a film from a solution or a molten state.

The solvent used for forming a film from a solution is not subject to any specific restrictions as far as it is capable of dissolving the electron transport material and/or the polymeric binder. For instance, the chlorine type solvents such as chloroform, methylene chloride and dichloroethane, ether type solvents such as tetrahydrofuran, aromatic hydrocarbon type solvents such as toluene and xylene, ketone type solvents such as acetone and methyl ethyl ketone, and ester type solvents such as ethyl acetate, butyl acetate and ethyl cellosolve acetate can be used.

As the method for forming a film from a solution or a molten state, there can be used the known coating methods such as spin coating, casting, microgravure coating, gravure coating, bar coating, roll coating, wire bar coating, dip coating, spray coating, screen printing, flexo printing, offset printing, and ink jet printing.

As the polymeric binder to be mixed, it is preferred to use one which does not hinder charge transport to an excessive degree, especially one which does not show strong absorption of visible light. Examples of such polymeric binders are poly(N-vinylcarbazole), polyaniline and its derivatives, polythiophene and its derivatives, poly(p-phenylenevinylene) and its derivatives, poly(2,5-thienylenevinylene) and its derivatives, polycarbonate, polyacrylate, polymethyl acrylate, polymethyl methacrylate, polystyrene, polyvinyl chloride and polysiloxane.

The thickness of the electron transport layer varies in its optimal value depending on the material used. It is selected so that the drive voltage and light-emitting efficiency will take the appropriate values, but at least the thickness needs to be enough to prevent formation of pinholes. A too large thickness is undesirable as it may cause rise of drive voltage of the element. Thus, the thickness of the electron transport layer is usually in the range of 1 nm to 1 µm, preferably 2 to 500 nm, more preferably 5 to 200 nm.

The substrate used for the polymer LED can be an ordinary type and is only required that it is capable of forming an electrode and stays unchanged when a layer of an organic material is formed. Examples of such a substrate are glass, plastic, polymeric film and silicon substrate. When the substrate is opaque, the opposite electrode is preferably transparent or translucent.

It is preferable that the polymer LED is transparent or translucent on the anode side, and a conductive metal oxide film, a translucent metallic thin film or such is used as the anode material. More specifically, as the anode, there can be used, for instance, a film (NESA, etc.) made by using conductive glass comprising indium oxide, zinc oxide, tin oxide or their composites such as indium tin oxide (ITO) and indium zinc oxide, as well as gold, platinum, silver, copper and such. Of these materials, ITO, indium zinc oxide and tin oxide are preferred. The known methods such as vacuum deposition, sputtering, ion plating and plating can be used for forming the anode. It is also possible to use an organic transparent conductive film made of polyaniline or its derivative, or polythiophene or its derivative. The film thickness of the anode can be properly selected by taking into account light transmission and electric conductivity. It is, for instance, 10 nm to 10 µm, preferably 20 nm to 1 µm, more preferably 50 to 500 nm. In order to facilitate charge injection, a layer made of a phthalocyanine derivative, conductive polymer, carbon or the like, or a layer with an average thickness of 2 nm or less made of a metal oxide, metal fluoride, organic insulating material or the like may be provided on the anode.

The cathode used for the polymer LED is preferably made of a material with a small work function, for example, metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium, alloys of two or more of these metals, alloys of at least one of these metals and at least one of gold, silver, platinum, copper, manganese, titanium, cobalt, nickel, tungsten and tin, and graphite or graphite interlayer compounds. Exemplary of the alloys are magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy. The cathode may be of a two- or more multilayered structure. The film thickness of the cathode can be properly selected by taking into account electric conductivity and durability. It is, for instance, 10 nm to 10 µm, preferably 20 nm to 1 µm, more preferably 50 to 500 nm.

As the method for making the cathode, vacuum deposition, sputtering, lamination comprising heat bonding of a metallic thin film, and such can be used. A layer made of a conductive polymer or a layer with an average film thickness of 2 nm or less made of a metal oxide, metal fluoride, organic insulating material or the like may be provided between the cathode and the organic material layer. It is also possible to provide a protective layer for protecting the polymer LED after forming the cathode.

It is preferable to provide a protective layer and/or a protective cover for protecting the element from the outside to allow long-time stabilized use of LED.

For the protective layer, high polymeric compounds, metal oxides, metal fluorides, metal borates and the like can be used. As the protective cover, a glass plate, a plastic plate having a low water permeability treatment applied on the surface, and the like can be used, and preferably such a protective cover is bonded to the element substrate with a heat-or light-curing resin to seal the substrate. The element can be easily protected against flawing by providing a suitable space with a spacer or spacers. By infusing an inert gas such as nitrogen or argon gas in the space, it is possible to prevent oxidation of the cathode. Further, placing a desiccant such as barium oxide in the space makes it easy to inhibit water adsorbed in the production process from giving damage to the element. It is advisable to incorporate at least one of these measures.

For obtaining planar light emission by using a polymer LED, the planar anode and cathode are arranged so that they are placed one on the other. For obtaining patterned light emission, there are available the following methods: A mask having a patterned window is provided on the surface of the planar light-emitting device; The organic material layer of the non-light-emitting portion is formed extremely thick to make this layer substantially non-light emissive; One or both of the anode and the cathode are formed as a pattern. By forming the pattern by one of these methods and arranging some electrodes so that they can be put on and off independently, it is possible to obtain a segment type display element which is capable of displaying numbers, letters and simple signs. For obtaining a dot matrix element, both of the anode and the cathode are formed stripe-wise and arranged to cross at right angles. Further, partial color display or multi-color display is made possible by, for instance, painting in different colors the polymeric phosphors which emit light of different colors. The dot matrix elements are capable of passive drive, or they may be designed to be an active drive type by combining them with TFT or such. These display elements can be used as display means for computers, TV, portable terminals, cell phones, car navigation systems, view finders of video cameras, etc. Further, the said planar light-emitting devices are a thin self-luminous type and can be used advantageously as a planar light source for back light of liquid crystal display devices or a light source for planar illumination. These elements can also be used as a curved light source or display device by using a flexible substrate.

### EXAMPLES

Shown below are the embodiments of the present invention for explaining the invention in further detail, but these embodiments are not to be construed as limitative to the scope of the invention.

### (Number-average molecular weight and weight-average molecular weight)

Here, regarding the number-average molecular weight (Mn), weight-average molecular weight (Mw) and peak-top molecular weight (Mp), there were shown those determined by GPC with polystyrene calibration.

### <GPC determination method A>

Determination was conducted by GPC (LC-10Avp (trade name, mfd. by Shimadzu Corp.) at 40°C, passing the solution through two columns of TSKgel SuperHM-H (trade name, made by Toso Co., Ltd.) and one column of TSKgel SuperH2000 (trade name, made by Toso Co., Ltd.) connected in series to each other, at a flow rate of 0.6 ml/min, using tetrahydrofuran as developing solvent. A differential refractomer (RID-10A (trade name, mfd. by Shimadzu Corp.)) was used as detector.

### <GPC determination method B>

Determination was made at70°C by Polymer Laboratory Co.'s PL-GPC 210 system (trade name)(RI detection) by passing the solution through three columns of Polymer Laboratory's PLgel 10 µm MIXED-B (trade name), using o-dichlorobenzene (containing 0.01 w/v% of 2,6-di-t-butyl-4-methylphenol) as developing solvent.

### <GPC determination method C>

By Toso's HLC-8220GPC system (trade name)(RI detection), determination was made at 40°C by passing the solution through three columns of TSKgel SuperHM-H (trade name, mfd. by Toso Co., Ltd.) connected in series to each other, at a flow rate of 0.5 ml/min, using tetrahydrofuran as developing solvent. A differential refractometer was used as detector.

### (NMR determination)

NMR determination was conducted at room temperature by a Varian Ltd.'s INOVA300 NMR device, using a polymer as a tetrahydrofuran decahydride solution.

(I) First, the production process in the first embodiment of the present invention is explained by showing the examples. Synthesis Example 1

### <Synthesis of N-(4-(4,4,5,5-tetramethyl-[1,3,2]dioxabororane-2-yl)phenyl)-N-(4-t-butyl-2,6-dimethylphenyl)-N-phenylamine, and compound N>

### (Synthesis of 4-t-butyl-2,6-dimethylbromobenzene)

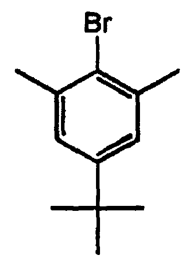

Under an inert atmosphere, 225 g of acetic acid was put into a 500 ml three-necked flask, followed by the addition of 24.3 g of 5-t-butyl-m-xylene. Then 31.2 g of bromine was added and the mixture was reacted at 15 to 20°C for 3 hours.

The reaction solution was poured into 500 ml of water and the precipitate was filtered off and washed twice with 250 ml of water to obtain 34.2 g of a white solid.
¹H-NMR (300 MHz/CDCl₃) : δ (ppm) = 1.3 [s, 9H], 2.4 [s, 6H], 7.1 [S, 2H]
MS (FD⁺)M⁺ 241

### (Synthesis of N,N-diphenyl-N-(4-t-butyl-2,6-dimethylphenyl)-amine)

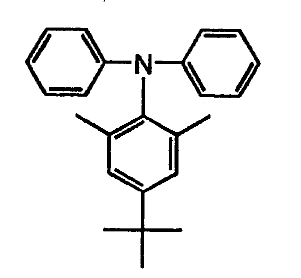

Under an inet atmosphere, 100 ml of deaerated and dehydrated toluene was supplied into a 300 ml three-necked flask, followed by the addition of 16.9 g of diphenylamine and 25.3 g of 4-t-butyl-2,6-dimethylbromobenzene. Then 0.92 g of tris(dibenzilideneacetone)dipalladium and 12.0 g of t-butoxysodium were added, followed by further addition of 1.01 g of tri(t-butyl)phosphine, and the mixture was allowed to react at 100°C for 7 hours.

The reaction solution was poured into a saturated saline solution and extracted with 100 ml of toluene. The toluene layer was washed with dilute hydrochloric acid and a saturated saline solution, and then the solvent was distilled away to obtain a black solid. This was separated and purified by silica gel column chromatography (hexane/chloroform = 9/1) to obtain 30.1 g of a white solid.
¹H-NMR (300 MHz/CDCl₃): δ (ppm) = 1.3 [s, 9H], 2.0 [s, 6H], 6.8-7.3 [m, 10H]

### (Synthesis of N-(4-bromophenyl)-N-(4-t-butyl-2,6-dimethylphenyl)-N-phenylamine)

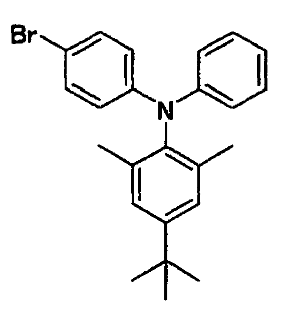

3.0 g (9.1 mmol) of N,N-diphenyl-N-(4-t-butyl-2,6-dimethylphenyl)-amine was supplied to a dried three-necked flask, and after replacing the inside of the vessel with argon gas, 105 ml of dehydrated dimethylformamide was added by a syringe to make the solution homogeneous. The reaction solution was cooled to 0 to 5°C by an ice bath, and a solution composed of 1.5 g (0.9 equivalent) of N-bromosuccineimide and and 5.2 ml of dehydrated dimethylformamide was added dropwise over a period of 30 minutes. The resulting solution was stirred as it was for 30 minutes. Then the ice bath was removed to return the solution to room temperature, and the solution was stirred for 5 hours. To this reaction solution, 130 ml of distilled water and 150 ml of chloroform were added and stirred sufficiently, separating the organic layer and the aqueous layer. The organic layer was dried over anhydrous magnesium sulfate and evaporated to dryness. The resulting product was dissolved in 200 ml of toluene, and the solution was passed through a silica gel column and evaporated to dryness. The product was purified by silica gel column chromatography using chloroform and cyclohexane as developing solution and evaporated to dryness to give 2.0 g of N-(4-bromophenyl)-N-(4-t-butyl-2,6-dimethylphenyl)-N-phenylamine as a white solid (LC area percentage: 99.7%; yield: 53.3%).
¹H-NMR (300 MHz, CDCl₃): δ 1.32 (s, 9H), 2.00 (s, 6H), 6.81-6.98 (m, 5H), 7.09 (s, 2H), 7.16-7.27 (m, 4H).
LC/MS (APPI (+)): M⁺ 407

### (Synthesis of N-(4-4,4,5,5-tetramethyl-[1,3,2]dioxabororane-2-yl)phenyl)-N-(4-t-butyl-2,6-dimethylphenyl)-N-phenylamine)

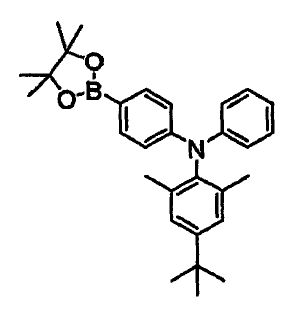

7.78 g (19.1 mmol) of N-(4-bromophenyl)-N-(4-t-butyl-2,6-dimethylphenyl)-N-phenylamine was supplied to a dried three-necked flask, and after replacing the inside of the vessel with argon gas, 76 ml of dehydrated tetrahydrofuran and 191 ml of dehydrated diethyl ether were added and dissolved with stirring. The reaction solution was cooled to -76°C, and 13.61 ml (21.0 mmol) of an n-hexane solution of 1.54 mol/l n-butyllithium was added dropwise over a period of 30 minutes, the resulting solution being stirred as it was for 0.5 hour. Then, 5.83 ml (28.6 mmol) of 2-isopropyloxy-4,4,5,5-tetramethyl-[1,3,2]dioxabororane was added at -76°C over a period of 20 minutes, and after one-hour stirring, the solution was heated to room temperature and stirred for 2 hours. The reaction solution was added dropwise, over a period of 15 minutes, into 200 ml of 0.2N hydrochloric acid cooled to 0°C, and the mixed solution was further stirred at room temperature for 15 minutes and separated into an organic layer and an aqueous layer. The aqueous layer was extracted with diethyl ether. The organic layers were joined and washed with distilled water, a 5% sodium hydrogencarbonate solution and distilled water successively in this order. The resulting organic layer was dried over anhydrous sodium sulfate and evaporated to dryness to obtain 9.0 g of a crude product as a light pink solid. 8.6 of this crude product was dissolved in 17.1 g of tetrahydrofuran by heating at 50°C. To this solution, 85.6 g of methanol was added slowly to cause precipitation, and the precipitate was filtered off and drived in vacuo to obtain 7.6 g of N-(4-(4,4,5,5-tetramethyl-[1,3,2]dioxabororane-2-yl)phenyl)-N-(4-t-butyl-2,6-dimethylphenyl)-N-phenylamine as a white solid. (LC area percentage: 98.5%; yield: 86.7%.) N,N-diphenyl-N-(4-t-butyl-2,6-dimethylphenyl)-amine was contained as an impurity in an amount of 1.5% in terms of LC area percentage.
¹H-NMR (300 MHz, CDCl₃): δ 1.32 (s, 9H), 1.32 (s, 12H), 2.00 (s, 6H), 6.81-6.98 (m, 3H), 7.01 (d, 2H), 7.09 (s, 2H), 7.15-7.27 (m, 2H), 7.62 (d, 2H).
LC/M (APPI) (+)) : [M + H]⁺ 456

### Synthesis of N,N-bis(4-bromophenyl)-N-(4-t-butyl-2,6-dimethylphenyl)amine)

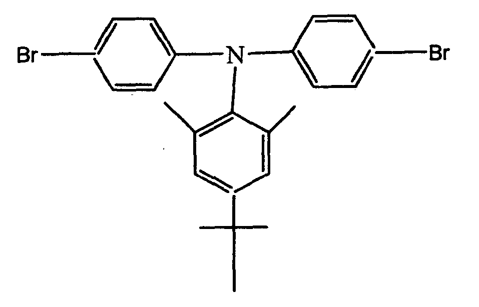

Under an inert atmosphere, 333 ml of dehydrated N,N-dimethylforamide and 166 ml of hexane were supplied to a 1,000 ml three-necked flask, and 29.7 g of N,N-diphenyl-N-(4-t-butyl-2,6-dimethylphenyl)-amine synthesized in the same way as described above was dissolved therein. Then, under ice bath cooling with light shut out, 100 ml of an N,N-dimethylformamide solution of 33.6 g of N-bromosuccineimide was added dropwise, and the mixture was allowed to react for a whole day and night.

The reaction solution was concentrated under reduced pressure to 200 ml, then 1,000 ml of water was added, and the precipitate was filtered off. The thus obtained crystals were recrystallized twice with DMF/ethanol to obtain 23.4 g of a white solid.
¹H-NMR (300 MHz/CDCl₃): δ (ppm) = 1.3 [s, 9H], 2.0 [s, 6H], 6.8 [d, 2H], 7.1 [s, 2H], 7.3 [d, 2H].
MS (APCI(+)): M⁺ 488.

### <Synthesis of compound N>

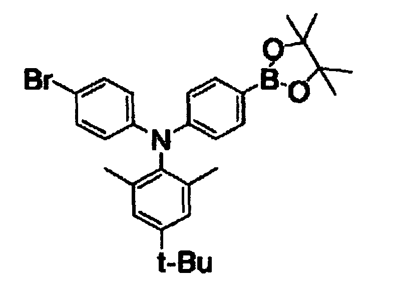

### Compound N

### Synthesis of (4-bromophenyl)-(4-tert-butyl-2,6-dimethylphenyl)-[4-(4,4,5,5-tetramethyl-[1,3,2]dioxabororane-2-yl)-phenyl]amine

To a dried four-necked flask, under an arogon atmosphere, 91.89 g (188.58 mmol) of bis-(4-bromophenyl)-(4-tert-butyl-2,6-dimethylphenyl)amine was supplied, and then 2,750 ml of dehydrated tetrahydrofuran was added to homogenize the solution. The reaction solution was cooled to -70°C, to which 98 ml (150.9 mmol) of an n-hexane solution of 1.54M n-butyllithium was added dropwise over a period of 78 minutes, and the mixture was stirred as it was for 65 minutes. Then 35.1 g (188.65 mmol) of 2-isopropoxy-4,4,5,5-tetramethyl-[1,3,2]dioxabororane was added dropwise at -70°C over a period of 60 minutes and the mixture was stirred as it was for one hour, followed by heating to 15 to 20°C and additional 2-hour stirring. One litre of water was supplied at room temperature, and after one-hour stirring, tetrahydrofuran was evaporated away under reduced pressure. Two liters of toluene was added to the concentrated suspension, and after stirring, the oil layer was separated from the aqueous layer. The oil layers obtained by three times of said separating operation were joined, to which anhydrous sodium sulfate was added and the mixture was stirred. Anhydrouis sodium sulfate was filtered away and the filtrate was concentrated under reduced pressure to obtain 113.54 g of a white solid. This white solid was purified by silica gel column chromatography using toluene and n-hexane as developing solution and evaporated to dryness to obtain 45.5 g of a yellowish white solid. This yellowish white material was dissolved in 800 ml of tetrahydrofuran, to which 800 ml of distilled water was added dropwise at 25°C over a period of 3 hours to let the crystals precipitate, followed by one-hour stirring and further filtration. This operation was repeated 7 times, and the obtained crystals were dried in vacuo to give the objective (4-bromophenyl)-(4-tert-butyl-2,6-dimethylphenyl)-[4-(4,4,5,5-tetramethyl-[1,3,2]dioxabororane-2-yl)-phenyl]amine as a white solid. (Yield: 40.2 g (37.8%); LC area percentage: 98.0%.)
¹H-NMR: 1.32 (s, 9H), 1.32 (s, 12H), 1.98 (s, 6H), 6.87 (d, 2H), 6.90 (d, 2H), 7.09 (s, 2H), 7.28 (d, 2H), 7.63 (d, 2H).
LC-MS: 535.1 (M + H)

### Synthesis Example 2

### <Synthesis of compounds F and G>

### (Synthesis of compound A)

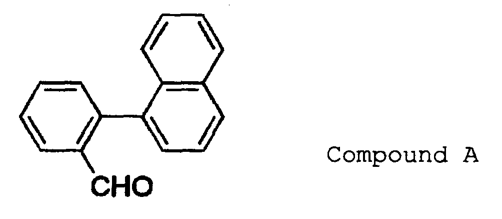

Under an inert atmosphere, 5.00 g (29 mmol) of 1-naphthaleneboric acid, 6.46 g (35 mmol) of 2-bromobenzaldehyde, 10.0 g (73 mmol) of potassium carbonate, 36 ml of toluene and 36 ml of ion exchange water were supplied to a 300 ml three-necked flask, and argon gas was bubbled into the mixture for 20 minutes with stirring at room temperature. Then 16.8 mg (0.15 mmol) of tetrakis(triphenylphosphine)palladium was supplied, and argon gas bubbling was further conducted for 10 minutes with stirring at room temperature. The mixture was heated to 100°C and reacted for 25 hours. After cooling to room temperature, the organic layer was extracted with toluene and dried over sodium sulfate, and then the solvent was evaporated away. The resultant product was purified by silica gel column chromatography using a 1:2 mixture of toluene and cyclohexane as developing solvent to obtain 5.18 g (yield: 86%) of compound A as white crystals.
¹H-NMR (300 MNz/CDCl₃): δ 7.39-7.62 (m, 5H), 7.70 (m, 2H), 7.94 (d, 2H), 8.12 (dd, 2H), 9.63 (s, 1H).
MS (APCI (+)): (M + H)⁺ 233.

### (Synthesis of compound B)

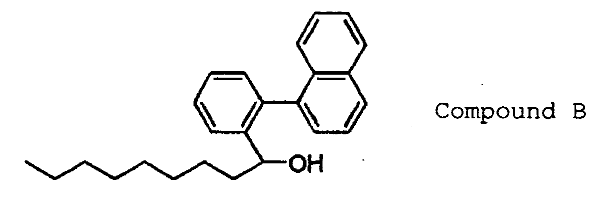

Under an inert atmosphere, 8.00 g (34.4 mmol) of the compound A and 46 ml of dehydrated THF were supplied to a 300 ml three-necked flask and cooled to -78°C. Then 52 ml of n-octylmagnesium bromide (a 1.0 mol/l THF solution) was added dropwise over a period of 30 minutes. After this dropwise addition, the mixture was heated to 0°C, stirred for one hour, further heated to room temperature and stirred for 45 minutes. 20 ml of hydrochloric acid was added under cooling with an ice bath to conclude the reaction. The organic layer was extracted with ethyl acetate and dried over sodium sulfate. After evaporating away the solvent, the product was purified by silica gel column chromatography using a 10:1 mixture of toluene and hexane as the developing solvlent to obtain 7.64 g (yield: 64%) of the compound B as a light yellow oil. Two peaks were observed in HPLC analysis, but because of the same mass number as determined by LC-MS analysis, the product was judged to be a mixture of isomers.

### (Synthesis of compound C)

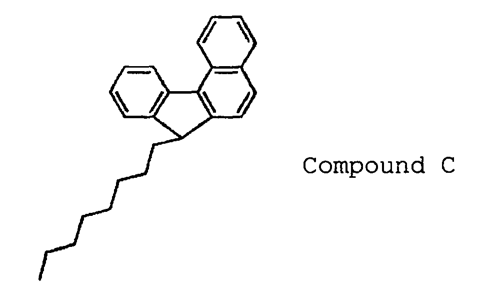

Under an inert atmosphere, 5.00 g (14.4 mmol) of the compound B (a mixture of isomers) and 74 ml of dehydrated dichloromethane were supplied to a 500 ml three-necked flask and dissolved by stirring at room temperature. Then an etherate complex of boron trifluoride was added dropwise at room temperatgure over a period of one hour, after which the mixture was stirred at room temperature for 4 hours. 125 ml of ethanol was added slowly with stirring, and when heat generation abated, the organic layer was extracted with chloroform, washed with water twice and dried over magnesium sulfate. After evaporating away the solvent, the product was purified by silica gel column chromatography using hexane as the developing solvent to obtain 3.22 g (68% yield) of the compound C as a colorless oil.
¹H-NMR (300 MHz/CDCl₃): δ 0.90 (t, 3H), 1.03-1.26 (m, 14H), 2.13 (m, 2H), 4.05 (t, 1H), 7.35 (dd, 1H), 7.46-7.50 (m, 2H), 7.59-7.65 (m, 3H), 7.82 (d, 1H), 7.94 (d, 1H), 8.35 (d, 1H), 8.75 (d, 1H).
MS (APCI (+)): (M + H)⁺ 329

### (Synthesis of compound D)

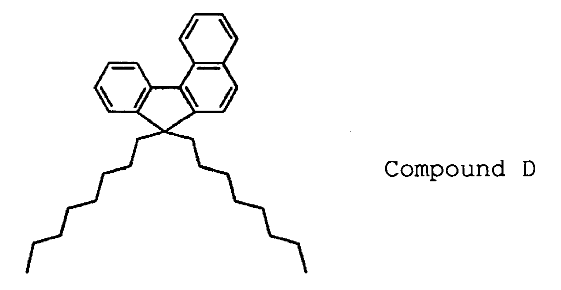

Under an inert atmosphere, 20 ml of ion exchange water was put into a 200 ml three-necked flask, and then 18.9 g (0.47 mmol) of sodium hydroxide was added piecemeal with stirring and dissolved. After the solution was cooled to room temperature, 20 ml of toluene, 5.17 g (15.7 mmol) of compound C and 1.52 g (4.72 mmol) of tributylammonium bromide were added and the mixture was heated to 50°C. Then, n-octyl bromide was added dropwise, and after this dropwise addition, the mixture was allowed to react at 50°C for 9 hours. After the reaction ended, the organic layer was extracted with toluene, washed with water twice and dried over sodium sulfate. The product was purified by silica gel column chromatography using hexane as the developing solvent to obtain 5.13 g (74% yield) of the compound D as a yellow oil.
¹H-NMR (300 MHz/CDCl₃): δ 0.52 (m, 2H), 0.79 (t, 6H), 1.00-1.20 (m, 22H), 2.05 (t, 4H), 7.34 (d, 1H), 7.40-7.53 (m, 2H), 7.63 (m, 3H), 7.83 (d, 1H), 7.94 (d, 1H), 8.31 (d, 1H), 8.75 (d, 1H).
MS (APCI (+)): (M + H)⁺ 441

### (Synthesis of compound E)

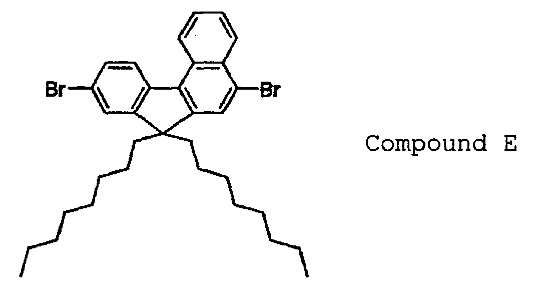

Under an air atmosphere, 4.00 g (9.08 mmol) of compound D and 57 ml of a 1:1 acetic acid and dichloromethane mixed solvent were supplied to a 50 ml three-necked flask and dissolved by stirring at room temperature. Then 7.79 g (20.0 mmol) of benzyltrimethyllammonium tribromide was added, and with stirring, zinc chloride was added until benzyltrimethylammonium tribromide was perfectly dissolved. After stirring at room temperature for 20 hours, 10 ml of a 5% sodium hydrogensulfate solution was added to end the reaction, and the organic layere was extracted, washed twice with a potassium carbonate solution and dried over sodium sulfate. The resulting product was purified twice by flash column chromatography using hexane as the developing solvent and recrystallized with a 1:1 and then 10:1 ethanol/hexane mixed solvent to produce 4.13 g (76% yield) of the compound E as white crystals.
¹H-1LNLMR (300 MHz/CDCl₃): δ 0.60 (m, 4H), 0.91 (t, 6H), 1.01-1.38 (m, 20H), 2.09 (t, 4H), 7.62-7.75 (m, 4H), 7.89 (s, 1H), 8.20 (d, 1H), 8.47 (d, 1H), 8.72 (d, 1H) .
MS (APPI (+)): M⁺ 596

### <Synthesis of compound F>

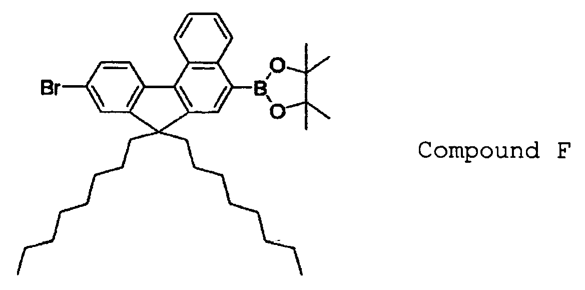

Under an argon gas atmosphere, 11.97 g (20.0 mmol) of compound E, 200 ml of commercial dehydrated tetrahydrofuran and 200 ml of commercial dehydrated diethyl ether were supplied to a 500 ml three-necked flask and dissolved by stirring at room temperature. The solution was cooled to -78°C, to which 12.99 ml (20.0 mmol) of a hexane solution of n-butyllithium (1.54 mol/l) was added dropwise slowly over a period of 30 minutes. After stirring at -78°C for 50 minutes, 4.90 mL (24.0 mmol) of 2-isopropoxy-4,4,5,5-tetramethyl-[1,3,2]dioxabororane was added dropwise over a period of 15 minutes. After stirring at -78°C for one hour, the mixture was heated to room temperature by taking 1.5 hour, and then the reaction mass was added dropwise into 200 ml of 2N hydrochloric acid at room temperature. After stirring at room temperature for 30 minutes, the oil layer was separated, extracted with 40 ml of diethyl ether and separated from the aqueous layer. The obtained oil layers were joined, washed with distilled water, a 5% sodium hydrogencarbonate solution and distilled water successively in this order, then dried over anhydrous sodium sulfate and concentrated to obtain a crude product (15.3 g) as a light yellow oily substance. This oily substance was dissolved in tetrahydrofuran and crystallized by adding methanol dropwise thereto, with this operation being repeated three times to obtain 11.0 g (85% yield) of the compound F as white crystals.
¹H-NMR (270 MHz/CDCl₃) : δ 0.40-0.60 (m, 4H), 0.80 (t, 6H), 0.90-1.20 (m, 20H), 1.45 (s, 12H), 1.94-2.17 (m, 4H), 7.54-7.64 (m, 4H), 8.03 (s, 1H), 8.19 (d, 1H), 8.66 (d, 1H), 8.92 (d, 1H).
MS (APPI (+)): M⁺ 644

### <Synthesis of compound G>

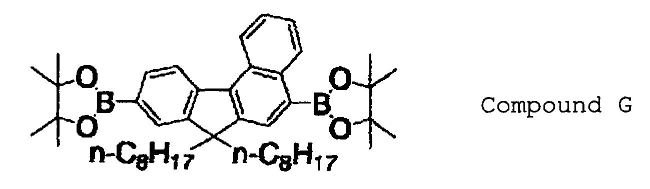

To a 100 ml four-necked round flask having its inside replaced with argon gas, compound E (3.2 g, 5.3 mmol) synthesized in the same way as in Synthesis Example 2, bispinacolatediboron (3.8 g, 14.8 mmol), PdCl₂(dppf) (0.39 g, 0.45 mmol), bis(diphenylphosphino)ferrocene (0.27 g, 0.45 mmol) and potassium acetate (3.1 g, 32 mmol) were supplied, followed by the addition of 45 ml of dehydrated dioxane. The mixture was heated to 100°C and reacted for 36 hours under an argon atmospherfe. After allowed to cool by standing, the solution was passed through a filter precoated with 2 g of celite and concentrated to obtain a black liquid. This was dissolved in 50 g of hexane and the colored components were removed by active carbon to obtain 37 g of a light yellow liquid. (For filtration, precoating was conducted with 5 g of Radiolite (produced by Showa Kagaku Kogyo KK.))

After adding 6 g of ethyl acetate, 12 g of dehydrated methanol and 2 g of hexane, the mixture was immersed in a dry ice/methanol bath to obtain 2.1 g of colorless crystals of the compound G. Synthesis Example 3

### <Synthesis of polymer 1>

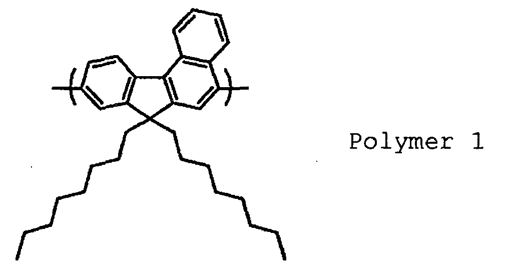

To a 1-litre three-necked flask having a Dimroth condenser connected thereto, 10.0 g (15.5 mmol) of compound F, 173.9 mg of palladium acetate and 435.1 mg of tricyclohexylphosphine were supplied under an argon atmosphere, and then the inside of the vessel was replaced with argon gas. To this mixture, 620 ml of toluene and 8.6 g of n-octylbenzene (internal standard material) were added and stirred at 110°C for 10 minutes. To this monomer solution, 80 ml of a 20 wt% tetraethylammonium hydroxide solution was added and stirred at 110°C for 16 hours. After confirming that the compound F disappeared by liquid chromatography, the mixture was cooled to room temperature and the organic layer was separated from the aqueous layer. The organic layer was concentrated to approximately 200 ml and added dropsie to 1.8 litre of ethanol to precipitate a polymer. The precipitate was filtered off and dried in vacuo to obtain a powder. This powder was dissolved in toluene and the solution was passed through a silica gel column and an alumina column and evaporated to dryness to obtain a powder. This powder was dissolved in 130 ml of chloroform and added dropwise to 1.5 litre of ethanol to precipitate a polymer, and the precipitate was filtered off and dried to obtain 6.4 g (94.1% yield) of a polymer (hereinafter referred to as polymer 1). The polystyrene-reduced number-average molecular weight (Mn) and weight-average molecular weight (Mw) of this polymer were: Mn = 1.5 x 10⁴; Mw = 3.1 x 10⁴ (GPC determination method B).
¹H-NMR (300 MHz/CDCl₃): δ 0.83 (bs), 1.16 (bs), 2.19 (bs), 7.3-9.1 (m). Integral ratio: (alkyl-derived protons)/(aryl-derived protons) = 4.19.

### Example 1

### <Synthesis of polymer compound 1: Step A>

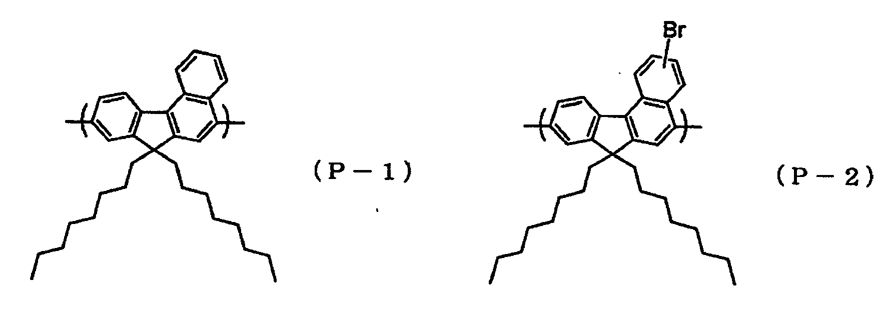

Under an argon gas atmosphere, polymer 1 (400 mg, 0.912 mmol calcd. in terms of benzofluorene repeating units) and 20 ml of chloroform were supplied to a 50 ml flask and dissolved by stirring at room temperature. Then 1.40 ml of trifluoroacetic acid and 19.6 µl (0.38 mmol, 42 mol% based on benzofluorene units) of bromine were supplied successively and the mixture was further stirred for 16 hours with light shut off. The reaction mass was added dropwise to 200 ml of methanol with stirring to cause precipitation. The precipitate was filtered off, washed with methanol and dried in vacuo to obtain 405 mg of a polymer. This polymer is called polymer compound 1. The polystyrene-reduced number-average molecular weight (Mn),weight-average molecular weight (Mw) and peak-top molecular weight (Mp) of the obtained polymer compound 1 were as follows: Mn =1.5 x 10⁴; Mw = 3.2 x 10⁴; Mp = 3.3 x 10⁴. Degree of dispersion (Mw/Mn) = 2.1 (GPC determination method B).

As a result of an elemental analysis, it was found that the ratio of repeating units of formula (P-1) having no Br groups to repeating units of formula (P-2) having Br groups was: (P-1)/(P-2)= 62/38, and (overall benzofluorene repeating units)/Br groups = 73/27.

Elemental Anal. Found: C, 84.33%; H, 8.82%; N<0.3%; Br, 6.49%.

Elemental Anal. Calcd. (on condition of (P-1)/(P-2) = 62/38): C, 84.55%; H, 8.96%; N, 0%; Br, 6.49%.

The results of determination by ¹H-NMR showed that the peak attributable to protons of alkyl group on the high magnetic field side remained unchanged, while a change was seen in the peak aattributable to protons of aryl group on the low magnetic field side. There was also noted a decrease of the aryl group proton/alkyl group proton ratio, indicating that the Br group has been introduced to the aromatic ring portion of benzofluorene.
¹H-NMR (300 MHz/CDCl₃) δ 0.83 (bs), 1. 16 (bs), 2.19 (bs), 7.3-9.3 (m). Integral ratio: (alkyl-derived protons)/(aryl-derived protons) = 4.40.

### <Synthesis of polymeric compound 2: Step B>

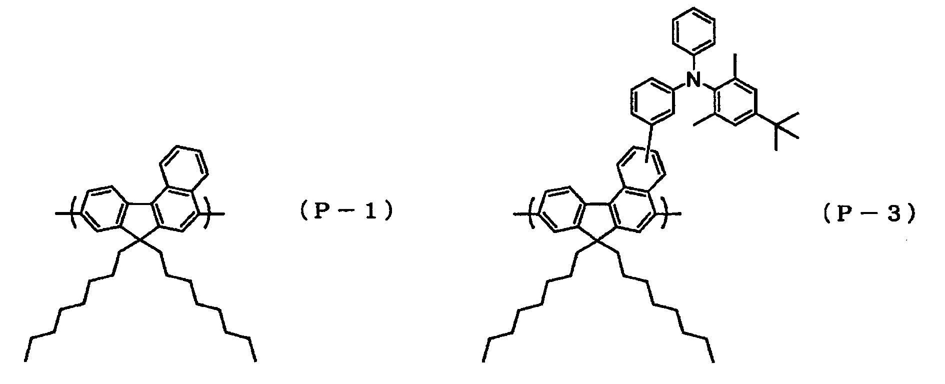

High-molecuar compound 1 (150 mg, 0.322 mmol calcd. in terms of benzofluorene repeating units), N-(4-(4,4,5,5-tetramethyl-[1,3,2]dioxabororane-2-yl)phenyl-N-(4-t-butyl-2,6-dimethylphenyl)-N-phenylamine (100 mg, 0,.22 mmol), palladium acetate (II) (1.23 mg, 0.005 mmol) and tricyclohexylphosphine (3.07 mg, 0.011 mmol) were supplied to a 50 ml flask. After argon gas replacement of the inside of the flask, 18.6 ml of commercial dehydrated toluene was supplied and the mixture was stirred at room temperature for dissolving the supplied materials. After heating the mixture to 110°C, a tetraethylammonium hydroxide solution (1.4 mol/1, 0.49 ml, 0.68 mmol) was supplied and stirred at 110°C for 2.5 hours. The mixture was cooled to room temperature and washed with 7.5 ml of distilled water. The organic layer was concentrated, dissolved in chloroform and added dropwise into acetone to cause precipitation. The precipitate was filtered off, washed with acetone and dried in vacuo to obtain 160 mg of a crude polymer. The number-average molecular weight (Mn), weight-average molecular weight (Mw) and peak-top molecular weight (Mp), all reduced to polystyrene basis, of the obtained crude polymer were: Mn = 2.2 x 10⁴; Mw = 3.8 x 10⁴; Mp = 3.7 x 10⁴, and degree of dispersion (Mw/Mn) = 1.8 (GPC determination method B).

146 mg of this crude polymer was dissolved in 30 ml of toluene at room temperature, then passed through a silica gel column and an alumina column through which toluene had previoiusly been passed, further washed out with toluene, concentrated, dissolved in chloroform and added dropwise into methanol for reprecipitation. The precipitate was filtered off, washed with methanol and dried in vacuo to obtain 145 mg of a polymer. This polymer is called polymer compound 2. Mn = 2.0 x 10⁴; Mw = 3.7 x 10⁴; Mp = 3.5 x 10⁴; Mw/Mn = 1.8 (GPC determination method B).

The result of an elemental analysis showed that this polymer had the repeating units of formula (P-1), repeating units of formula (P-2) having Br groups and repeating units of formula (P-3) having side chains in a ratio of (P-1)/(P-2)/(P-3) = 75/0/25, and benzofluorene repeating units/side chains = 80/20.

Elemental Anal. Found: C, 89.86%; H, 9.22%; N, 0.68%; Br<0.1%.

Elemental Anal. Calcd. (on condition of (P-1)/(P-2)/(P-3) = 75/0/25): C, 89.97%; H, 9.35%; N, 0.68%; Br, 0%.

### Synthesis Example 4

### <Synthesis of polymer 2: Condensation polymerization of 2,7-dibromo-9,9-di-n-octylfluorene and 2,7-dibromo-9,9-bis(3-methylbutyl)fluorene

26.3 g of 2,7-dibromo-9,9-di-n-octylfluorene, 5.6 g of 2,7-dibromo-9,9-bis(3-methylbutyl)fluorene and 22 g of 2,2'-bipyridyl were dissolved in 1,600 ml of dehydrated tetrahydrofuran and then the inside of the system was replaced with nitrogen by bubbling it through the system. To this solution was added bis(1,5-cyclooctadiene)nickel(0) {Ni(COD)₂} (40.66 g) under a nitrogen atmospherfe, and the mixture was heated to 60°C and reacted with stirring for 8 hours. After the reaction, the reaction solution was cooled to room temperature (about 25°C) and added dropwise into a mixed solution of 1,200 ml of 25% ammonia water, 1,200 ml of methanol and 1,200 ml of ion exchange water. The mixture was stirred for 0.5 hour and the formed precipitate was filtered off, dried in vacuo for 2 hours and then dissolved in 1,110 ml of toluene. The resulting solution was filtered and toluene was added to the filtrate to form approximately 2,800 ml of a solution. Then the organic layer was washed with 2,000 ml of 1N hydrochloric acid solution for one hour, then with 2,200 ml of 4% ammonia water for one hour, further with 1,000 ml of ion exchange water for 10 minutes and additionally with 1,000 ml of ion exchange water for 10 minutes. This organic layer was concentrated under reduced pressure to 592 g at 50°C and added dropwise to 3,330 ml of methanol, followed by 0.5-hour stirring. The precipitate was filtered off, washed twice with 500 ml of methanol and dried in vacuo at 50°C for 5 hours. The yield of the obtained copolymer was 12.6 g. This copolymer is called polymer 2. Its polystyrene-reduced number-average molecular weight (Mn) and weight-average molecular weight (Mw) were: Mn = 8.4 x 10⁴ and Mw = 1.6 x 10⁵ (GPC determination method C). In the polymer 5, the ratio of repeating units of 9,9-di-n-octylfluorene/repeating units of 9,9-bis(3-methylbutyl)fluorene was 80/20.

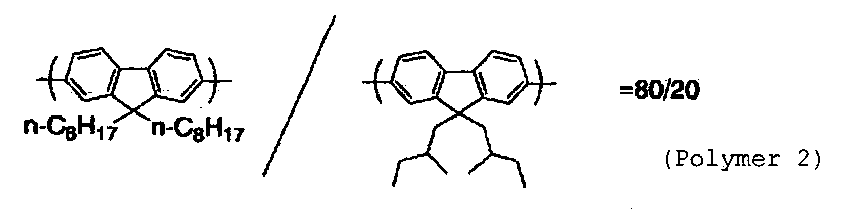

### Example 2

### <Synthesis of polymeric compound 3: Step A>

Under an argon gas atmosphere, the polymer 2 (2.00 g, 5.38 mmol calcd. in terms of fluorene repeating units) and chloroform (100 ml) were supplied to a 200 ml flask and dissolved by stirring at room temperature. Then 8.3 ml of trifluoroacetic acid and 104 µL (2.05 mmol, 38 mol% based on fluorene repeating units) were supplied successively and the mixture was stirred with light shut out for 20 hours. The reaction mass was added dropwise to 500 ml of methanol with stirring to cause precipitation, and the precipitate was filtered off, washed with methanol and dried in vacuo to obtain 2.17 g of polymer. This polymer is called polymer compound 3. Its polystyrene-reduced number-average molecular weight Mn was 9.2 x 10⁴, weight-average molecular weight Mw was 1.7 x 10⁵, peak-top molecular weight Mp was 1.4 x 10⁵, and the degree of dispersion Mw/Mn was 1.90 (GPC determination method C).

The result of an elemental analysis showed that this polymer had a combination of repeaing units having Br groups (P-7) and a combination of repeating units having no Br groups (P-6) in a ratio of (P-6)/(P-7) = 63/37, and (overall fluorene repeating units)/Br groups = 73/27.

Elemental Anal. Found: C, 82.48%; H, 9.25%; N<0.3%; Br, 7.44%.

Elemental Anal. Calcd. (on condition of (P-6)/(P-7) = 63/37): C, 83.21%; H, 9.35%; N, 0%; Br, 7.44%.

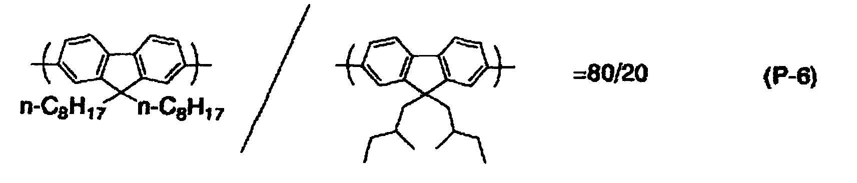

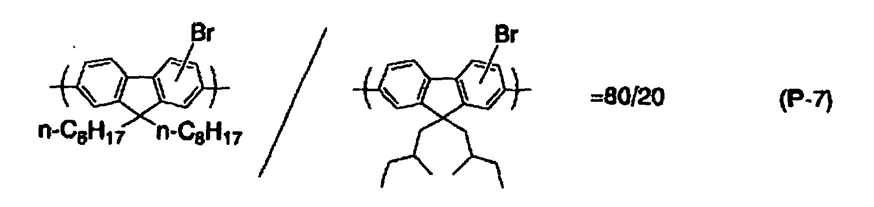

### <Synthesis of polymer compound 4: Step B>

300 mg of polymer compound 3, 62.0 mg of N-(4-(4,4,5,5-tetramethyl-[1,3,2]dioxabororane-2-yl)phenyl)-N-(4-t-butyl-2,6-dimethylphenyl)-N-phenylamine, 0.65 mg of palladium acetate (II) and 1.58 mg of tricyclohexylphosphine were supplied to a 100 ml flask. After replacement with argon gas, 72 ml of commercial dehydrated toluene was supplied and dissolved by stirring at room temperature. Then 1.00 mL of a tetraethylammonium hydroxide solution (1.4M) was supplied and the mixture was heated to 110°C and stirred at 110°C for 3 hours. Heating was suspeneded, and 196.3 mg of 4-(4,4,5,5-tetramethyl-1,3,2]dioxabororane-2-yl)butyltoluene, 0.63 mg of palladium acetate (II), 1.62 mg of tricyclohexylphosphine and 1.00 ml of a tetraethylammonium hydroxide solution (1.4M) were supplied. The mixture was again heated to 110°C and stirred for 3 hours. After cooled to room temperature, the solution wad diluted with 15 ml of toluene, separated, and washed twice with 20 ml of a 15% saline solution. The obtained organic layer was passed through a filter precoated with 3 g of Radiolite (produced by Showa Kagaku Kogyo KK) and washed with 20 ml of toluene. This organic layer was concentrated and added dropwise into acetone for precipitation. The precipitate was filtered off, washed with acetone and dried in vacuo to obtain 278 mg of a crude polymer.

277 mg of this crude polymer was dissolved in 60 ml of toluene at room temperature, passed through a silica gel column and an alumina column through which toluene had previouisly been passed, then further washed out with toluene, washed twice with 3% ammonia water and distilled water, concentrated under reduced pressure and added dropwise into methanol for reprecipitation. The precipitate was filtered off, washed with methanol and dried in vacuo to obtain 259 mg of a polymer.

This polymer is called polymer compound 4. Its polystyrene-reduced number-average molecular weight Mn was 9.2 x 10⁴, weight-average molecular weight Mw was 1.7 x 10⁵, peak-top molecular weight Mp was 1.4 x 10⁵, and the degree of dispersion Mw/Mn was 1.9 (GPC determination method C).

The aromatic polymer 5 had a combination of repeating units represented by the formula (P-6) and a combination of repeating units represented by the formula (P-8) in a ratio of (P-6)/(P-8) = 94/6.

Elemental Anal. Found: C, 89.36%; H, 9.92%; N, 0.24%; Br<0.1%.

Elemental Anal. Calcd. (on condition of (P-

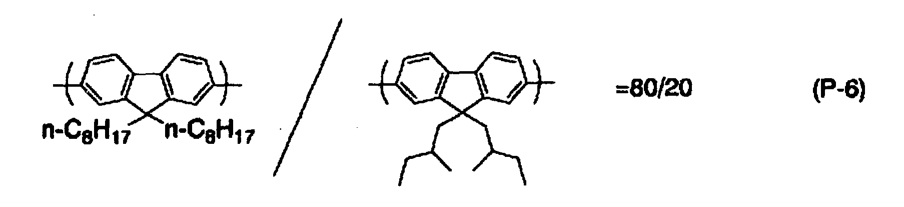

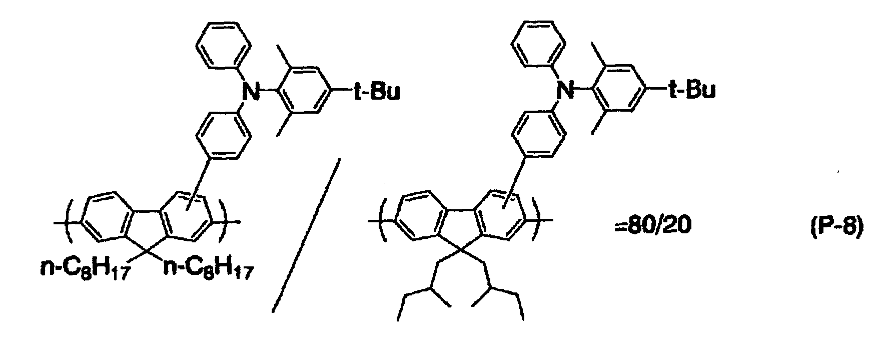

### Synthesis Example 5

### <Synthesis of polymer 3>

Under an argon gas atmosphere, 37.7 g (63 mmol) of compound E synthesized according to the method of Synthesis Example 2 and 43.6 g (63 mmol) of compound G synthesized according to the method of Synthesis Example 6 were supplied to a 200 ml flask having a Dimroth condenser connected thereto, and dissolved in 70 ml of toluene. The solution was degassed by bubbling arogon gas into the solution. Then 42 mg of palladium acetate and 266 mg of tris(o-methoxyphenyl)phosphine were added, followed by dropwise addition of 283.4 ml of a bis(tetraethylammonium) carbonate solution (33 wt%) while heating the solution, and the mixture was refluxed for 24 hours. Then 10.8 g of bromobenzene was added and the mixture was refluxed for one hour, after which 8.9 g of phenylboric acid was added and the mixture was further refluxed for one hour. The oil layer was washed twice with a 2N hydrochloric acid solution, twice with a 10% acetic acid solution and 6 times with water, and the solution was filtered with celite, concentrated under reduced pressure and added dropwise into methanol to cause precipitation. The obtained solid was filtered off, dried in vacuo, dissolved again in toluene, reprecipitated into methanol and dried in vacuo, with this operation being repeated twice to obtain 22.4 g of a polymer (hereinafter called polymer 3). Its polystyrene-reduced number-average molecular weight Mn and weight-average molecular weight Mw were Mn = 7.3 x 10⁴ and Mw = 1.8 x 10⁵ (GPC determination method C).

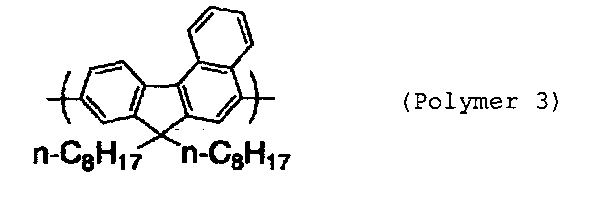

### Example 3

### <Synthesis of polymeric compound 5: Step A>

Under an argon gas atsmophere, the polymer 3 (5.00 g, 11.4 mmol calcd. in terms of benzofluorene repeating units) and chloroform (150 ml) were supplied to a 500 ml flask and dissolved by stirring at room temperature. Then 17.6 ml of trifluoroacetic acid and 236 µl (4.6 mmol, 40 mol% based on benzofluorene repeating units) of bromine were supplied successively and the mixture was stirred with light shut out for 24 hours. The reaction mass was added dropwise to 1,250 ml of methanol to cause precipitation, and the precipitate was filtered off, washed with methanol and dried in vacuo to obtain 5.29 g of a polymer. This polymer is called polymer compound 5. Its polystyrene-reduced number-average molecular weight Mn was 7.5 x 10⁴, weight-average molecular weight Mw was 1.6 x 10⁵, peak-top molecular weight Mp was 1.2 x 10⁵, and the degree of dispersion Mx/Mn was 2.1 (GPC determination method C).

The result of an elemental analysis showed that the ratio of the repeating units having no Br groups (formula P-1) to the repeating units having Br groups (formula P-2) was (P-1)/(P-2) = 61/39, and (overall benzofluorene repeating units)/Br groups = 72/28.

Elemental Anal. Found: C, 84.93%; H, 9.06%; N<0.3%; Br, 6.57%.

Elemental Anal. Calcd. (on condition of (P-1)/(P-2) = 61/39): C, 84.48%; H, 8.94%; N, 0%, Br, 6.57%.

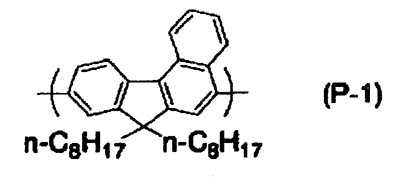

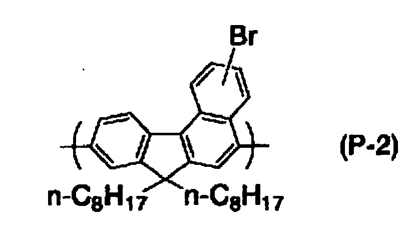

### <Synthesis of polymeric compound 6: Step B>

600 mg of polymer compound 5, 147 mg of N-(4-(4,4,5,5-tetramethyl-[1,3,2]dioxabororane-2-yl)phenyl)-N-(4-t-butyl-2,6-dimethylphenyl)-N-phenylamine, 0.96 mg of palladium acetate (II)and 2.40 mg of tricyclohexylphosphine were supplied to a 100 ml flask. After replacement with argon gas, 72 mL of commercial dehydrated toluene was supplied and dissolved by stirring at room temperature. The mixture was heated to 110°C and 1.55 ml of a tetraethylammonium hydroxide solution (1.4M) was fed, followed by 3-hour stirring at 110°C. Heating was suspended, and 336 mg of 4-(4,4,5,5-tetramethyl-[1,3,2]dioxabororane-2-yl)butylbenzene, 1.00 mg of palladium acetate (II), 2.43 mg of tricyclohexylphosphine and 1.55 ml of a tetraethylammonium hydroxide solution (1.4M) were supplied. The mixture was again heated to 110°C and stirred for 3 hours. After cooled to room temperature, the mixture was diluted with 30 mL of toluene, separated, and washed twice with 36 mL of 15% saline, and the obtained organic layer was passed through a filter precoated with 6 g of Radiolite (produced by Showa Kagaku Kogyo KK), and washed with 36 mL of toluene. The produced organic layer was concentrated and added dropwise into acetone to urge precipitation. The precipitate was filtered off, washed with acetone and dried in vacuo to obtain 630 mg of a crude polymer.

This crude polymer (630 mg) was dissolved in 130 mL of toluene, passed through a silica gel column and an alumina column through which toluene had previously been passed, further washed out with toluene, washed twice with 3% ammonia water and distilled water, concentrated under reduced pressure, and added dropwise into methanol to cause reprecipitation. The precipitate was filtered off, washed with methanol and dried in vacuo to obtain 627 mg of a polymer.

The obtained polymer is called polymer compound 6. Mn = 8.3 x 10⁴; Mw = 1.6 x 10⁵; Mp = 1.3 x 10⁵; Mw/Mn = 1.9 (GPC determination method C).

The result of an elemental analysis revealed that this polymer had repeating units (P-1), repeating units having Br groups (P-2) and repeating units having substituent groups (P-3) in a ratio of (P-1)/(P-2)/(P-3) = 82/0/18, and the benzofluorene repeating units to substituent ratio was benzofluorene/side chain = 85/15.

Elemental Anal. Found: C, 90.46%; H, 9.18%; N, 0.49%; Br<0.1%.

Elemental Anal. Calcd. (on condition of (P-1)/(P-2)/(P-3) = 82/0/18): C, 90.08%; H, 9.43%; N, 0.49%; Br, 0%.

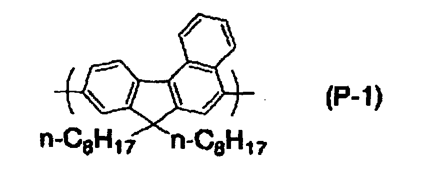

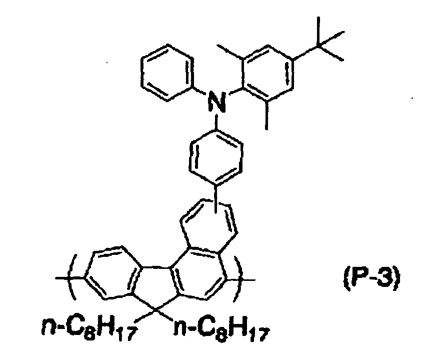

### Synthesis Example 6

### <Synthesis of compound I>

### (Synthesis of compound H)

Under an argon gas atmosphere, 6.63 g (40.0 mmol) of 9H-carbazole, 0.09 g (0.4 mmol) of palladium acetate (II), 16.5 g (119 mmol) of potassium carbonate and 10.0 g (43.6 mmol) of 4-trimethylsilylbromobenzene were supplied, heated to 120°C and stirred for 12 hours. After every passage of 3, 6 and 9 hours from the start of this process, 1.0 g of 4-trimethylsilylbromobenzene was additionally supplied. The reaction mass was diluted with xylene, washed with distilled water, dried over anhydrous magnesium sulfate, concentrated under reduced pressure, recrystallized from chloroform and methanol, and then further recrystallized from ethyl acetate and methanol to obtain 5.25 g (41% yield) of compound H as pale gray crystals.
¹H-NMR (300 MHz, CDCl₃): δ(ppm) 0.35 (s, 9H), 7.23-7.29 (m, 2H), 7.35-7.45 (m, 4H), 7.53 (J=8,0 Hz, 2H), 7.72 (J=8.0 Hz, 2H), 8.12 (d, J=7.7 Hz, 2H).

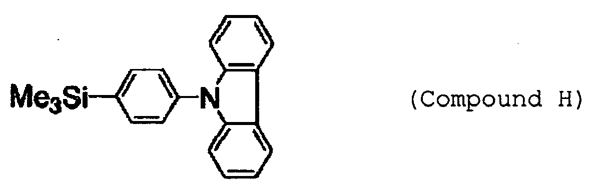

### (Synthesis of compound I)

Under an argon gas atmosphere, 32.0 ml of a dichloromethane solution (1.0M) of boron tribromide was added dropwise over a period of 20 minutes to a solution formed by dissolving 5.00 g (15.9 mmol) of compound H in 100 ml of dichloromethane and cooled to 0°C. After 3.5-hour stirring of the solution at 0°C, the solvent was evaporated away under reduced pressure. Then 160 ml of ethyl acetate and 6.74 g of pinacol were supplied. The mixture was stirred at room temperature for one hour, then washed with distilled water, a 5% sodium hydrogencarbonate solution and distilled water successively in this order, dried over anhydrous magnesium sulfate, and concentrated under reduced pressure. Then methanol was added to precipitate a solid, and the precipitate was filtered off and dried in vacuo to obtain 5.0 g of compound I.
¹H-NMR (300 MHz, CDCl₃): δ (ppm) 1. 39 (s, 12H), 7.24-7.30 (m, 2H), 7.36-7.46 (m, 4H), 7.58 (d, J=8.2 Hz, 2H), 8.05 (d, J=8.2 Hz, 2H), 8.12 (d, J=7.8 Hz, 2H)

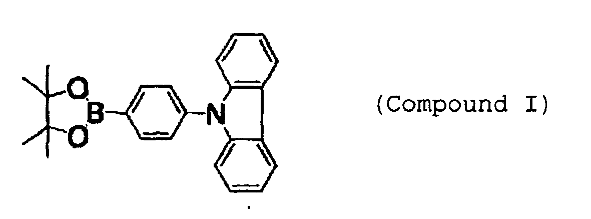

### Example 4

### <Synthesis of high-moleculaar compound 7: Step B>

300 mg of polymeric compound 5, 55.5 mg of compound I, 0.55 mg of palladium acetate (II) and 1.38 mg of tricyclohexylphosphine were supplied to a 100 ml flask. After replacement with argon gas, 36 ml of commercial dehydrated toluene was added and dissolved by stirring at room temperature. The mixture was heated to 110°C and 0.88 ml of a tetraethylammonium hydroxide solution (1.4M) was supplied and stirred at 110°C for 3 hours. Then heating was suspended, and 167 mg of 4-(4,4,5,5-tetramethyl-[1,3,2]dioxabororane-2-yl)butylbenzene, 0.55 mg of palladium acetate (II), 1.40 mg of tricyclohexylphosphine and 0.88 ml of a tetraethylammonium hydroxide solution (1.4M) were supplied. The mixture was again heated to 110°C and stirred for 3 hours. After cooled to room temperature, the solution was diluted with 15 ml of toluene, separated, and washed twice with 20 ml of 15% saline, and the obtained organic layer was passed through a filter precoated with 3 g of Radiolite (produced by Showa Kagaku Kogyo KK) and washed with 20 ml of toluene. This organic layer was concentrated and added dropwise into acetone for precipitation. The precipitate was filtered off, washed with acetone and dried in vacuo to obtain 309 mg of a cruse polymer.

This 309 mg of crude polymer was dissolved in 60 ml of toluene at room temperature, passed through a silica gel column and an alumina pass through which toluene had previoiusly been passed, further washed out with toluene, washed twice with 3% ammonia water and distilled water, concentrated under reduced pressure and added dropwise into methanol for reprecipitation. The precipitate was filtered off, washed with methanol and dried in vacuo to obtain 293 mg of a polymer.

The thus obtained polymer is called polymer compound 7. Mn = 8.7 x 10⁴; Mw = 1.8 x 10⁵; Mp = 1.4 x 10⁵; Mw/Mn = 2.1 (GPC determination method C).

As a result of an elemental analysis, it was found that this polymer had repeating units (P-1), repeating units having Br groups (P-2) and repeating units having substituent groups (P-4) in a ratio of (P-1)/(P-2)/(P-4) = 83/0/17, and the ratio of benzofluorene repeating units to substituent groups was: benzofluorene/side chain = 86/14.

Elemental Anal. Found: C, 89.49%; H, 9.00%; N, 0.50%; Br<0.1%.

Elemental Anal. Calcd. (on condition of (P-1)/(P-2)/(P-4) = 83/0/17): C, 90.28%; H, 9.22%; N, 0.50%; Br, 0%.

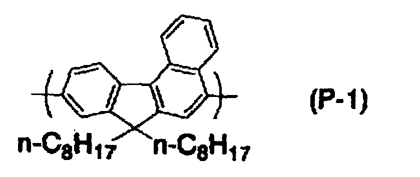

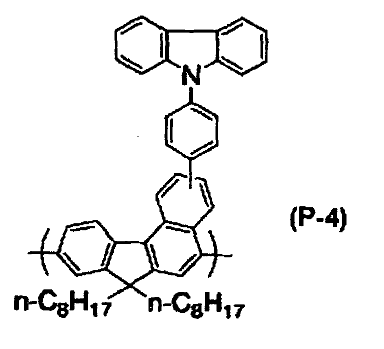

### Example 5

### <Synthesis of polymer compound 8: Step B>

300 mg of polymeric compound 5, 791 mg of compound N, 3.9 mg of palladium acetate (II) and 9.8 mg of tricyclohexylphosphine were supplied to a 100 ml flask. After replacement with argon gas, 36 ml of commercial dehydrated toluene was supplied and dissolved by stirring at room temperature. Then 6.2 ml of a tetraethylammonium hydroxide solution (1.4M) was fed and the mixture was heated to 110°C and stirred at 110°C for 3 hours. Then heating was suspended and 166 mg of 4-(4,4,5,5-tetramethyl-[1,3,2]dioxabororane-2-yl)butylbenzene, 3.88 mg of palladium acetate (II), 9.69 mg of tricyclohexylphosphine and 1.2 ml of a tetraethylammonium hydroxide solution (1.4M) were supplied. The mixture was then again heated to 110°C and stirred for 3 hours. After cooled to room temperature, the mixture was diluted with 15 ml of toluene, separated, and washed twice with 15 ml of 15% saline. The obtained organic layer was passed through a filter precoated with 3 g of Radiolite (produced by Showa Kagaku Kogyo KK), then washed with 18 ml of toluene, concentrated and added dropwise into acetone to cause precipitation. The precipitate was filtered off, washed with acetone and dried in valuo to obtain 730 mg of a crude polymer.

728 mg of this crude polymer was dissolved in 140 ml of toluene at room temperature, passed through a silica gel column and an alumina column through which toluene had previously been passed, further washed out with toluene, concentrated under reduced pressure and added dropwise into acetone for reprecipitation. The precipitate was filtered off, washed with acetone and dried in vacuo to obtain 705 mg of a polymer.

This polymer is called polymer compound 8. Mn = 4.2 x 10⁴; Mw = 1.8 x 10⁵; Mp = 1.6 x 10⁵; Mw/Mn = 4.4 (GPC determination method C).

From the result of an elemental analysis, it was found that the polymeric compound 8 comprised repeating units (P-1) and repeating units having a side chain (P-5), the length of this side chain being 4.1 equivalents to the triphenylamine derivative repeating units (indicated by n in the formula (P-5) shown below), the ratio (P-1)/(P-5)= 61/39, and the ratio of benzofluorene repeating units to triphenylamine derivative repeating units, represented by benzofluorene/side chain, was 38/62.

Elemental Anal. Found: C, 88.57%; H, 8.57%; N, 2.32%; Br<0.1%.

Elemental Anal. Calcd. (on condition of (P-1)/(P-5) = 61/39) : C, 88.94%, H, 8.74%; N, 2.32%; Br, 0%.

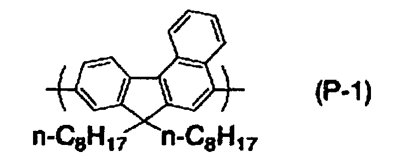

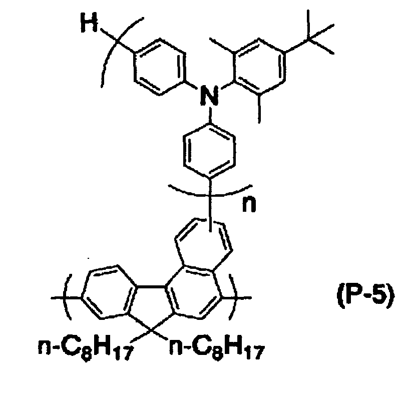

### Synthesis Example 7

### <Synthesis of compounds L>

### (Synthesis of compound L-1)

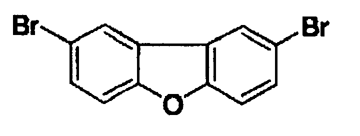

### Compound L-1

Under an inert atmosphere, benzofuran (23.2 g, 137.9 mmol) and acetic acid (232 g) were supplied to a 1-litre three-necked flask, dissolved by stirring at room temperature and heated to 75°C. Then bromine (92.6 g, 579.3 mmol) diluted with acetic acid (54 g) was added dropwise. After completion of this dropwise addition, the mixture was stirred for 3 hours while maintaining the temperature and then allowed to stand to cool. After disappearance of the starting material has been confirmed by TLC, a sodium thiosulfate solution was added to end the reaction, and the mixture was further stirred at room temperature for one hour and then filtered. The filtered off cakes were washed with a sodium thiosulfate solution and water and then dried. The resulting crude product was recrystallized from hexane to obtain the objective substance. (Yield: 21.8 g (49%).)
¹H-NMR (300 MHz/CDCl₃): δ 7.44 (d, 2H), 7.57 (d, 2H), 8.03 (s, 2H).

### (Synthesis of compound L-2)

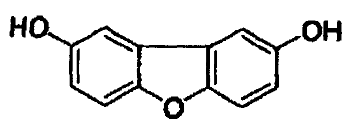

### Compound L-2

Under an inert atmosphere, the compound L-1 (16.6 g, 50.9 mmol) and tetrahydrofuran (293 g) were supplied to a 500 ml four-necked flask and cooled to -78°C. Then n-butyllithium (80 ml <1.6 mol hexane solution>, 127.3 mmol) was added dropwise, and the mixture was stirred for one hour while maintaining the temperature. This reaction solution was added dropwise, under an inert atmosphere, to a solution of trimethoxyboric acid (31.7 g, 305.5 mmol) and tetrahydrofuran (250 ml) in a 1,000 ml four-necked flask cooled to -78°C. After this dropwise addition was completed, the mixture was returned to room temperature slowy and stirred at room temperature for 2 hours, and then disappearance of the starting material was confirmed by TLC. The reaction mass was poured into a 2,000 ml beaker containing concentrated sulfuric acid (30 g) and water (600 ml) to finish the reaction. Then toluene (300 ml) was added and the organic layer was extracted and washed with water. After evaporating away the solvent, 8 g of the extract and 160 ml of ethyl acetate were put into a 300 ml four-necked flask, then a 30% hydrogen peroxide solution (7.09 g) was added and the mixture was stirred at 40°C for 2 hours. This reaction solution was poured into an aqueous solution of iron ammonium sulfate (II) (71 g) and water (500 ml) in a 1,000 ml beaker. After stirring, the organic layer wass extracted and washed with water. The solvent was removed to obtain 6.72 g of a crude preparation of compound L-2.
MS spectrum: M⁺ 200.0

### (Synthesis of compound L-3)

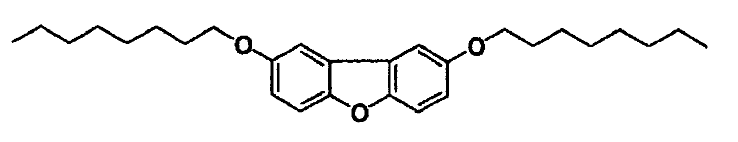

### Compound L-3

Under an inert atmosphere, the compound L-2 (2.28 g, 11.4 mmol) synthesized by the above-described method and N-dimethylformamide (23 g) were supplied to a 200 ml four-necked flask and dissolved by stirring at room temperature. Then potassium carbonate (9.45 g, 68.3 mmol) was added and the mixture was heated to 60°C. Thereafter, a solution of n-octyl bromide (6.60 g, 34.2 mmol) diluted with N,N-dimethylformamide (11 g) was added dropwise. On conclusion of this dropwise addition, the mixture was heated to 60°C, stirred for 2 hours maintaining this temperature, and disappearance of the starting material was confirmed by TLC. Water (20 ml) was added to end the reaction. Then the organic layer was extracted with toluene (20 ml), washed twice with water and dried over anhydrous sodium sulfate, and then the solvent was evaporated away. The obtained crude product was purified by silica gel column chromatography to obtain the objective substance (yield: 1.84 g (38%)).
MS spectrum: M⁺ 425.3.

### (Synthesis of compound L)

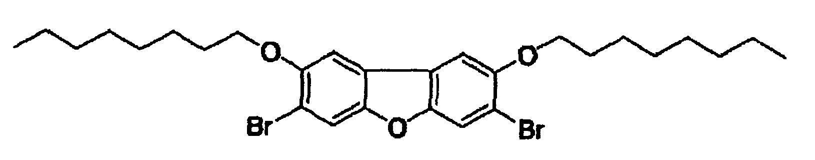

### Compound L

Under an inert atmosphere, the compound L-3 (7.50 g, 17.7 mmol) synthesized by the above-described method and N,N-dimethylformamide were supplied to a 500 ml four-necked flask, dissolved by stirring at room temperature and cooled by an ice bath. After cooling, a solution of N-bromosuccineimide (6.38 g, 35.9 mmol) diluted with N,N-dimethylformamide (225 ml) was added dropwise. Thereafter, the mixture was kept in the ice bath for one hour, then left at room temperature for 18.5 hours, and then heated to 40°C. The mixture was stirred for 6.5 hours while maintaining this temperature, and disappearance of the starting material was confirmed by liquid chromatography. The solvent was removed and toluene (75 ml) was added for dissolution, and the formed organic layer was washed thrice with water and dried over anhydrous sodium sulfate, after which the solvent was evaporated away. About half of the obtained crude product was purified by silica gel column and liquid chromatography to harvest 0.326 g of the objective substance.
¹H-NMR (300 MHz/CDCl₃): δ 0.90 (t, 6H), 1.26-1.95 (m, 24H), 4.11 (t, 4H), 7.34 (s, 2H), 7.74 (s, 2H).
MS spectrum: M⁺ 582.1

### Synthesis Example 8

### <Synthesis of polymer 4>

Under a nitrogen atmosphere, 0.104 g of 3,8-dibromobenzofuran, 0.719 g of compound L and 0.578 g of 2,2'-bipyridyl were dissolved in 30 g of dehydrated tetrahydrofuran and heated to 60°C. To this solution was added 1.040 g of bis(1,5-cyclooctadiene)nickel(0) {Ni(COD)₂}, and the mixture was allowed to react at 60°C for 3 hours. The reaction solution was cooled to room temperature, added dropwise into a mixed solution of 9 g of 25% ammonia water, 95 g of methanol and 50 g of ion exchange water and stirred for 30 minutes. The precipitate was filtered off, dried in vacuo for 2 hours and dissolved in 30 mL of toluene. Then 30 g of 1N hydrochloric acid was added, and after stirring for 3 hours, the aqueous layer was removed. Then 30 g of 4% ammonia water was added to the organic layer, and after stirring for 3 hours, the aqueous layer was removed. Then the organic layer was added dropwise to 200 mL of methanol and stirred for 30 minutes, and the precipitate was filtered off, dried in vacuo for 2 hours and dissolved in 30 mL of toluene. Thereafter, the mixture was passed through an alumina column (alumina quantity: 10 g) for purification, and the recovered toluene solution was added dropwise to 200 mL of methanol and stirred for 30 minutes. The formed precipitate was filtered off and dried in vacuo for 2 hours. The yield of the obtained polymer was 0.456 g. This polymer is called polymer 4. Its polystyrene-reduced number-average molecular weight (Mn) was 1.3 x 10⁵ and weight-average molecular weight (Mw) was 4.6 x 10⁵ (GPC determination method A).

The polymer 4 had the dibenzofuran repeating units represented by the formulae (P-9) and (P-10) and their ratio conjectured from the feed ratio was (p-9)/(P-10) = 80/20.

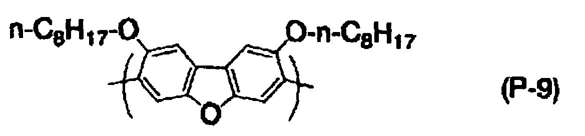

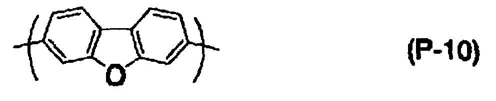

### Example 6

### <Synthesis of polymer compound 9: Step A>

Under an argon gas atmosphere, the polymer 7 (150 mg, 0.404 mmol calcd. in terms of dibenzofuran repeating units) and chloroform (8 ml) were supplied to a 20 ml flask and stirred at room temperature for dissolving the compound. Then trifluoroacetic acid (0.6 ml) and a solution of bromine (5.2 µl) diluted with chloroform (1 ml) (0.10 mmol, 25 mol% based on dibenzofuran repeating units) were supplied successively and stirred for 20 hours with light shut out. The reaction mass was added dropwise to 38 ml of methanol with stirring to cause precipitation. The precipitate was filtered off, washed with methanol, dried in vacuo for 2 hours and dissolved in 25 ml of toluene. This solution was passed through a silica gel column and an alumina column through which toluene had previouisly been passed, further washed out with toluene, concentrated under reduced pressure, and added dropwise into methanol for provoking reprecipitation. The precipitate was filtered off, washed with methanol and dried in vacuo to obtain 152 mg of a polymer. This polymer is called polymer compound 9. Its polystyrene-reduced number-average molecular weight)Mn) was 1.5 x 10⁵, weight-average molecular weight (Mw) was 3.8 x 10⁵, peak-top molecular weight (Mp) was 3.7 x 10⁵, and the degree of dispersion (Mw/Mn) was 2.6 (GPC determination method C).

It is considered that the polymeric compound 9 has benzofuran repeating units represented by the formulae (P-9), (P-10), (P-9b) and (P-11).

The ratio of the repeating units having no Br groups (P-9), (P-10) to the repeating units having Br groups (P-9b), (P-11) conjectured from the result of an elemental analysis is {(P-9) + (P-10)}/{(P-9b) + (P-11)} = 77/23, and (overall benzofuran repeating units)/Br groups = 81/19.

Elemental Anal. Found: C, 75.46%; H, 7.93%; N<0.3%; Br, 4.67%.

Elemental Anal. Calcd. (on condition of {P-9} + (P-10))/{(P-9b) + (P-11)} = 77/23) : C, 76.52%; H, 8.12%; N, 0%; Br, 4.67%.

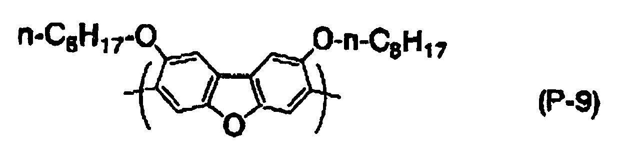

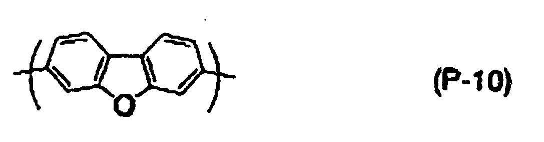

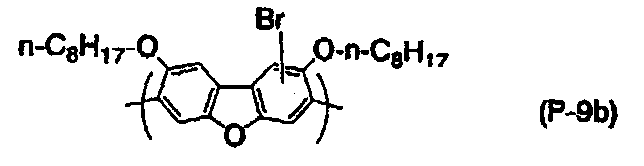

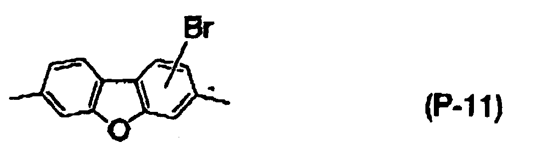

### <Synthesis of polymer compound 10: Step B>

40 mg of Aliluot 336, 80 mg of polymer compound 9 and 15.3 mg of compound I were supplied to a 25 mL flask. After replacement of the inside of the flask with argon gas, 36 ml of commercial dehydrated toluene was supplied and the mixture was stirred at room temperature for dissolving the materials. The solution was degassed by bubbling argon gas into the solution and then heated to 80°C. Then 0.30 mg of palladium acetate (II) and 1.91 mg of tris(o-methoxyphenyl)phosphine were added, followed by further addition of 0.41 mL (17.5 wt%) of a sodium carbonate solution. The mixture was heated to 105°C and stirred for 3 hours. Heating was suspended and 42 mg of 4-(4,4,5,5-tetramethyl-[1,3,2]dioxabororane-2-yl)butyltoluene was supplied. The mixture was again heated to 105°C and stirred for 2 hours. After removing the aqueous layer, the mixture was washed twice with ion exchange waater, twice with a 3% acetic acid solution and twice with ion exchange waater successively in this order, and then added dropwise into methanol to cause precipitation. The precipitate was filtered off, washed with methanoland dried in vacuo to obtain 93 mg of a crude polymer.

90 mg of this crude polymer was dissolved in 6 mL of toluene at room temperature, passed through a silica gel column and an alumina column through which toluene had previously been passed, further washed out with toluene and then added dropwise into methanol to cause reprecipitation. The precipitate was filtered off, washed with methanol and dried in vacuo to obtain 63 mg of a polymer.

This polymer is called polymer compound 10. Its polystyrene-reduced number-average molecular weight (Mn) was 1.5 x 10⁵, weight-average molecular weight (Mw) was 4.7 x 10⁵, peak-top molecular weight (Mp) was 3.7 x 10⁵, and the degree of dispersion (Mw/Mn) was 3.1 (GPC determination method C).

It is considered that the polymer compound 10 has dibenzofuran repeating units represented by the formulae (P-9), (P-10), (P-9c) and (P-12).

From the result of an elemental analysis, the ratio of the repeating units (P-9), (P-10) to the repeating units having substituents (P-9c), (P-12) is {(P-9) + (P-10)}/{(P-9c) + (P-12) } = 92/8, and (overall dibenzofuran repeating units)/carbazole substituents = 93/7.

Elemental Anal. Found: C, 78.90%; H, 7.90%; N, 0.27%.

Elemental Anal. Calcd. (on condition of {(P-9) + (P-10)}/{}P-9c) + (P-12)} = 92/8): C, 80.64%; H, 8.41%; N, 0.27%.

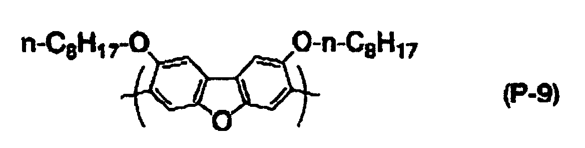

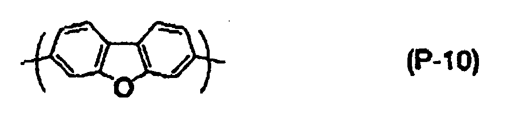

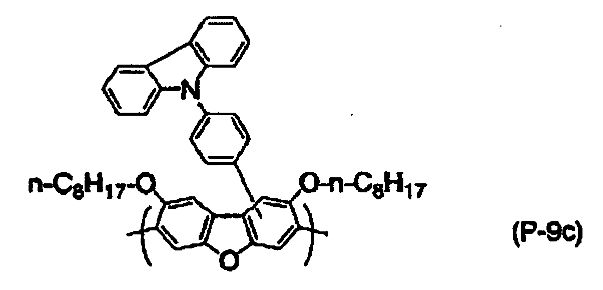

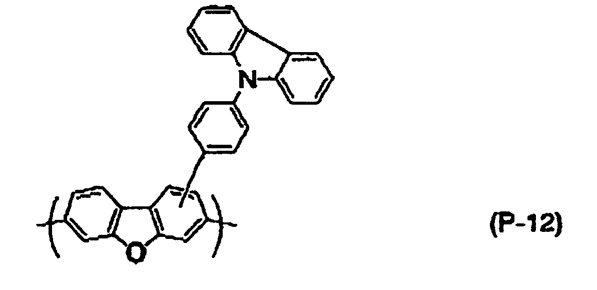

### Referential Example 1

### Preparation of solution

The polymer compound 2 obtained as described above wad dissolved in toluene to prepare a toluene solution with a polymer concentration of 2.0 wt%.

### Preparation of electron single element

An approximately 500 nm thick layer of aluminum was formed by vapor deposition on a glass substrate having a 150 nm thick ITO film formed by sputtering. Aluminum was formed into an electrode pattern by use of a deposition mask. The above-said toluene solution was spin coated at a speed of 2,600 rpm on the aluminum electrode substrate under a nitrogen atmosphere. The coating film was about 78 nm thick. This was dried in vacuo at 80°C for one hour, and then lithium fluoride was deposited to a thickness of about 4 nm, after which calcium was deposited to a thickness of about 5 nm to form a cathode and then aluminum was further deposited to a thickness of about 80 nm to make an electron single element. Metal deposition was started after the degree of vacuum has reached 1 x 10⁻⁴ Pa or below.

### Preparation of hole single element

A solution formed by filtering a suspension of poly(3,4)ethylenedioxythiophene and polystyrenesulfonic acid (BaytronP A14083 by Bayer) through a 0.2 µm membrane filter was spin coated to form a 70 nm thick film on a glass substrate having a 150 nm thick ITO film formed by sputtering, and dried on a hot plate at 200°C for 10 minutes. Then the above-said toluene solution was spin coated thereon at a speed of 2,600 rpm to form a film. The film thickness was about 78 nm. This was dried in vacuo at 80°C for one hour and then gold was deposited to a thickness of 200 nm to make a hole single element. Metal deposition was started after the degree of vacuum has reached 1 x 10⁻⁴ Pa or below.

### Determination of voltage-current characteristic

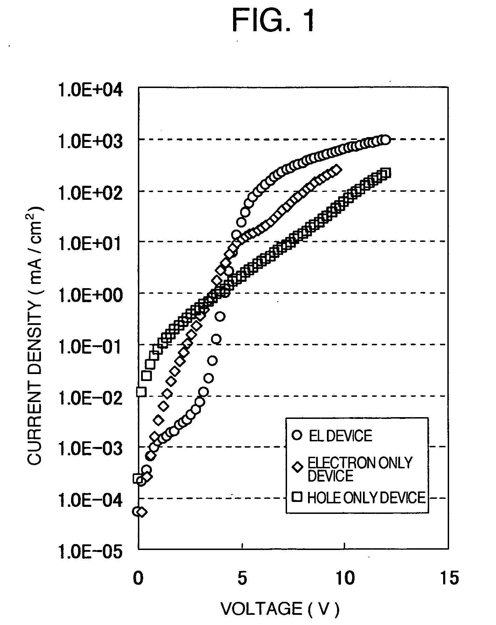

A voltage was applied stepwise with an increment of 0.2 V for each step in the range from 0 to 12 V to the above-said electron single element and hole single element by using a Hewlet Packard Ltd.'s picoampere meter and DC power source (Model No. 4140B), and the current that flew through the element in this operation was recorded. In each of these carrier single elements, in view of the interrelation between the work function of the metal used for the anode and cathode of each element and HOMO and LUMO of the light-emitting material, it may rightly be supposed that in the relatively low voltage region, substantially the electrons alone are allowed to flow in the element in the case of the electron single element while the holes alone are allowed to flow in the element in the case of the hole single element. The results of measurements are shown in FIG. 1.

### Referential Example 2

### Preparation of solution

The polymer compound 2 obtained as described above was dissolved in toluene to prepare a toluene solution with a polymer concentration of 2.0 wt%.

### Making of EL element

A solution obtained by passing a suspension of poly(3,4)ethylenedioxythiophene and polystyrenesulfonic acid (BaytronP AI4083 by Bayer) through a 0.2 µm membrane filter was spin coated to form a 70 nm thick film on a glass substrate having a 150 nm thick ITO film formed by sputtering, and dried on a hot plate at 200°C for 10 minutes. Then the toluene solution obtained as described above was additionally spin coated at a speed of 2,600 rpm to form a film. The formed film was about 78 nm thick. This was dried in vacuo at 80°C for one hour. Then lithium fluoride was deposited to a thickness of about 4 nm, after which calcium was deposited to a thickness of about 5 nm to form a cathode and then aluminum was further deposited to a thickness of about 80 nm to make an EL element. Deposition of metal was started after the degree of vacuum has reached 1 x 10⁻⁴ Pa or below.

### Performance of EL element

Applying a voltage to the obtained element, there was obtained EL emission having a peak at 460 nm from this element. The C.I.E. chromaticity coordinates of EL emitted light color on application of 8.0 V were x = 0.217 and Y = 0.324. Intensity of EL light emission was almost proportional to the current density. Also, with this element, commencement of light emission was observed on application of voltage of 4.2 V upwards, with the maximum emission efficiency being 0.29 cd/A. The voltage(V)-current(I) characteristic determined from the above measurements is also shown in FIG. 1. (II) The process in accordance with the second embodiment of the present invention is explained below by giving examples.

### Synthesis Example 9

### <Synthesis of compound F>

### (Synthesis of compound A)

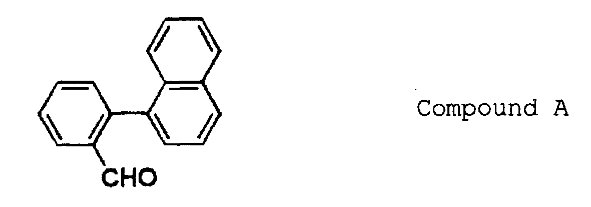

Under an inert atmosphere, 5.00 g (29 mmol) of 1-naphthaleneboric acid, 6.46 g (35 mmol) of 2-bromobenzaldehyde, 10.0 g (73 mmol) of potassium carbonate, 36 ml of toluene and 36 ml of ion exchange water were supplied to a 300 ml three-necked flask, and argon was bubbled into the mixture for 20 minutes with stirring at room temperature. Then 16.8 mg (0.15 mmol) of tetrakis(triphenylphosphine)palladium was supplied and argon bubbling was continued for 10 minutes with stirring at room temperature. The mixture was heated to 100°C and allowed to react for 25 hours. After cooling to room temperature, the organic layer was extracted with toluene and dried over sodium sulfate, and then the solvent was evaporated away. The resulting product was purified by silica gel column chromatography using a 1:2 mixture of toluene and xylene as the developing solvent to obtain 5.18 g (86% yield) of compound A as white crystals.
¹H-NMR (300 MHz/CDCl₃): δ 3.39-7.62 (m, 5H), 7.70 (m, 2H), 7.94 (d, 2H), 8.12 (dd, 2H), 9.63 (s, 1H).
MS (APCl (+)): (M + H)⁺ 233

### (Synthesis of compound B)

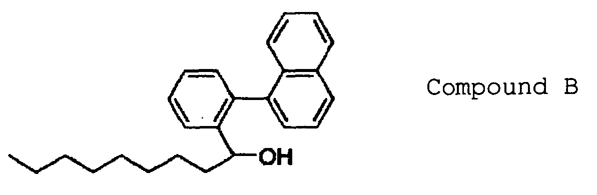

Under an inert atmosphere, 8.00 g (34.4 mmol) of compound A and 46 ml of dehydrated THF were supplied to a 300 ml three-necked flask and cooled to -78°C. Then 52 ml of n-octylmagnesium bromide (1.0 mol/l THF solution) was added dropwise over a period of 30 minutes, followed by heating to 0°C. The mixture was stirred for one hour, heated to room temperature and further stirred for 45 minutes. With the solution cooled with an ice bath, 20 ml of 1N hydrochloric acid was added to end the reaction. The organic layer was extracted with ethyl acetate and drived over sodium sulflate. Then the solvent was evaporated away and the mixture was purified by silica gel column chromatography using a 10:1 mixture of toluene and hexane as the developing solvent to obtain 7.64 g (64% yield) of compound B as a light yellow oil. Two peaks were observed in HPLC, but because of the identical mass number in LC-MS analysis, the product was judged to be a mixture of isomers.

### (Synthesis of compound C)

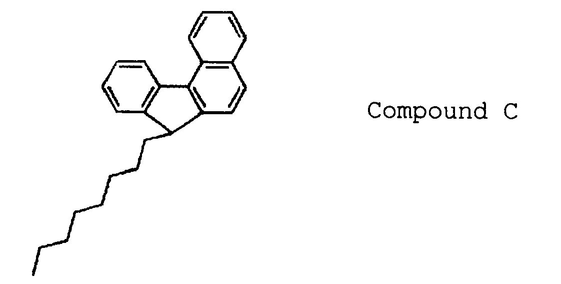

Under an inert atmosphere, 5.00 g (14.4 mmol) of compound B (a mixture of isomers) and 74 ml of dehydrated dichloromethane were supplied to a 500 ml three-necked flask and dissolved by stirring at room temperature. Then an etherate complex of boron trifluoride was added dropwise over a period of one hour at room temperature, after which the mixture was stirred at room temperature for 4 hours. 125 ml of ethanol was added slowly with stirring, and when generation of heat abated, the organic layer was extracted with chloroform, washed twice with water and dried over magnesium sulfate. The solvent was evaporated away and the resultant product was purified by silica gel column chromatography using hexane as the developing solvent to obtain 3.22 g (68% yield) of compound C as a colorless oil.
¹H-NMR (300 MHz/CDCl₃) : δ 0.90 (t, 3H), 1.03-1.26 (m, 14H), 2.13 (m, 2H), 4.05 (t, 1H), 7.35 (dd, 1H), 7.46-7.50 (m, 2H), 7.59-7.65 (m, 3H), 7.82 (d, 1H), 7.94 (d, 1H), 8.35 (d, 1H), 8.75 (d, 1H).
MS (AOCI (*)): (M + H)⁺ 329

### (Synthesis of compound D)

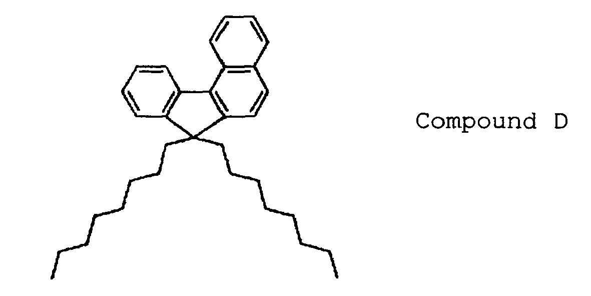

Under an inert atmosphere, 20 ml of ion exchange water was supplied to a 200 ml three-necked flask, then 18.9 g (0.47 mmol) of sodium hydroxide was added piecemeal with stirring and dissoled. After the solution has been cooled to room temperature, 20 ml of toluene, 5.17 g (15.7 mmol) of compound C and 1.52 g (4.72 mmol) of tributylammonium bromide were added and the mixture was heated to 50°C. Then n-octyl bromide was added dropwise, after which the mixture was allowed to react at 50°C for 9 hours. After the reaction ended, the organic layer was extracted with toluene, washed twice with water and dried over sodium sulfate. The product was purified by silica gel column chromatography using hexane as the developing solvent to obtain 5.13 g (74% yield) of compound D as a yellow oil.
¹H-NMR (300 MHz/CDCl₃): δ 0.52 (m, 2H), 0.79 (t, 6H), 1.00-1.20 (m, 22H), 2.05 (t, 4H), 7.34 (d, 1H), 7.40-7.53 (m, 2H), 7.63 (m, 3H), 7.83 (d, 1H), 7.94 (d, 1H), 8.31 (d, 1H), 8.75 (d, 1H).
MS (APCI (+)): (M + H)⁺ 441

### (Synthesis of compound E)

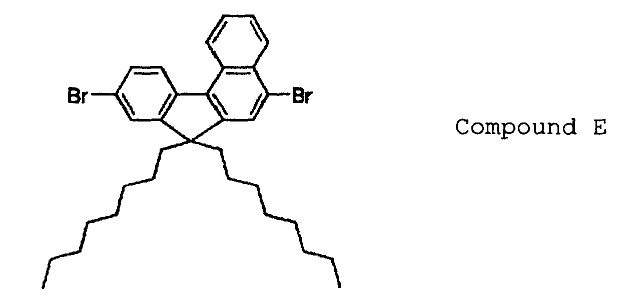

Under an air atmosphere, 4.00 g (9.08 mmol) of compound D and 57 ml of an acetic acid and dichloromethane (1:1) mixed solvent were supplied to a 50 ml three-necked flask and dissolved by stirring at room temperature. Then 7.79 g (20.0 mmol) of benzyltrimethylammonium tribromide was added, with zinc chloride being also added with stirring until benzyltrimethylammonium tribromide was dissolved completely. After further stirring at room temperature for 20 hours, 10 ml of a 5% sodium hydrogensulfite solution was added to stop the reaction. The organic layer was extracted with chloroform, washed twice with a potassium carbonate solution and dried over sodium sulfate. The resulting product was purified twice by flush column chromatography using hexane as the developing solvent and recrystallized from a 1:1 and then a 10:1 ethanol/hexane mixed solvent to obtain 4.13 g (76% yield) of compound E as white crystals.
¹H-NMR (300 MHz/CDCl₃): δ 0.60 (m, 4H), 0.91 (t, 6H), 1.01-1.38 (m, 20H), 2.09 (t, 4H), 7.62-7.75 (m, 4H), 7.89 (s, 1H), 8.20 (d, 1H), 8.47 (d, 1H), 8.72 (d, 1H).
MS (APPI (+)): M⁺ 596

### (Synthesis of compound F)

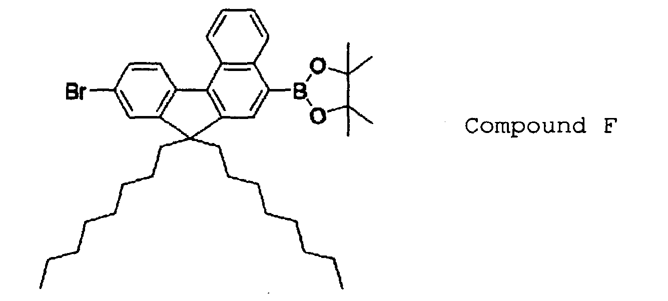

Under an argon gas atmosphere, 11.97 g (20.0 mmol) of compound E, 200 mL of commercial dehydrated tetrahydrofuran and 200 mL of commercial dehydrated diethyl ether were supplied to a 500 mL three-necked flask and dissolved by stirring at room temperature. The solution was cooled -78°C, to which 12.99 ml (20.0 mmol) of a hexane solution of n-butyllithium (1.54 mol/L) was added dropwise slowly over a period of 30 minutes. After stirring at -78°C for 50 minutes, 4.90 ml (24.0 mmol) of 2-isopropoxy-4,4,5,5-tetramethyl-[1,3,2]dioxabororane was added dropwise over a period of 15 minutes. After further stirring at -78°C for one hour, the mixture was heated to room temperature by taking 1.5 hour, and the reaction mass was added dropwise into 200 mL of 2N hydrochloric acid at room temperature. After 30-minute stirring at room temperature, the oil layer was separated, with extraction and separation from the aqueous layer with 40 mL of diethyl ether being carried out. The obtained oil layers were joined, washed with distilled water, a 5% sodium hydrogen carbonate solution and distilled water successively in this order, then dried over anhydrous sodium sulfate and concentrated to obtain a crude product (15.3 g) as a light yellow oily substance. This oily substance was dissolved in tetrahydrofuran and methanol was added dropwise thereto to cause crystallization, this operation being repeated three times to obtain 11.0 g (85% yield) of compound F as white crystals.
¹H-NMR (270 MHz/CDCl₃): δ 0.40-0.60 (m, 4H), 0.80 (t, 6H), 0.90-1.20 (m, 20H), 1.45 (s, 12H), 1.94-2.17 (m, 4H), 7.54-7.64 (m, 4H), 8.03 (s, 1H), 8.19 (d, 1H), 8.66 (d, 1H), 8.92 (d, 1H).
MS (APPI (+)): M⁺ 644

### Synthesis Example 10

### <Synthesis of aromatic polymer compound 1>

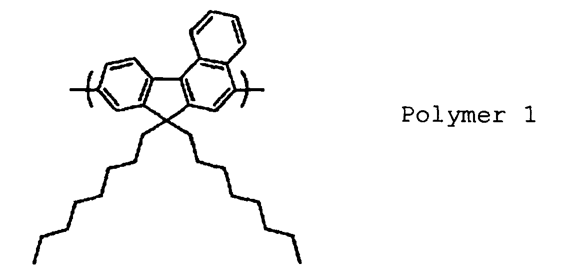

Under an argon gas atmosphere, 10.0 g (15.5 mmol) of compound F, 173.9 mg of palladium acetate and 435.1 mg of tricyclohexylphosphine were supplied to a 1-litre three-necked flask having a Dimroth condenser connected thereto, and the inside of the vessel was replaced with argon gas. Then 620 ml of toluene and 8.6 g of n-octylbenzene (internal standard material) were added and the mixture was stirred at 110°C for 10 minutes. Into this monomer solution, 80 ml of a 20 wt% tetraethylammonium hydroxide solution was poured and stirred at 110°C for 16 hours. After it was confirmed by liquid chromatography that the compound F has disappeared, the mixture was cooled to room temperature and the organic layer was separated from the aqueous layer. The organic layer was concentrated to about 200 mL and 1.8 litre of ethanol was added to precipitate the polymer. The precipitate was filtered off and dried in vacuo to obtain a powder. This powder was dissolved in toluene and the solution was passed through a silica gel column and an alumina column, and evaporated to dryness to obtain a powder. This powder was dissolved in 130 mL of chloroform and added dropwise to 1.5 litre of ethanol to precipitate a polymer. The precipitate was filtered off and dried to obtain 6.4 g (94.1% yield) of a polymer (hereinafter called aromatic polymer compound 1). Its polystyrene-reduced number-average molecular weight (Mn) was 1.5 x 10⁴ and weight-aveerage molecular weight (M)w was 3.1 x 10⁴ (GPC determination method B).
¹H-NMR (300 MHz/CDCl₃) : δ 0.83 (bs), 1.16 (bs), 2.19 (bs), 7.3-9.1 (m). Integral ratio: (alkyl-derived protons)/(aryl-derived protons) = 4.19.

### Example 7

### <Synthesis of brominated aromatic polymer compound 1:

### Bromination of aromatic polymer compound 1>

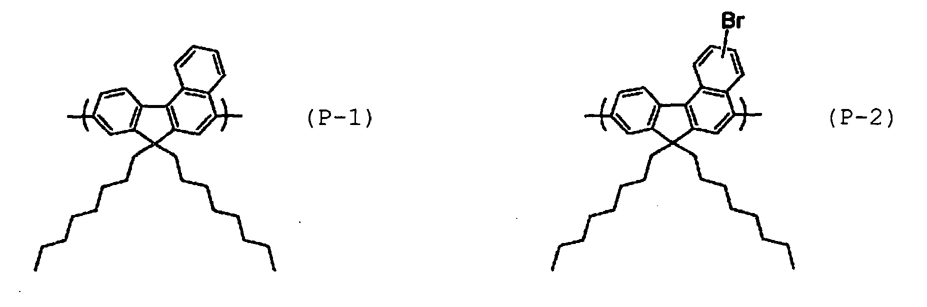

Under an inert gas atmosphere, the aromatic polymer compound 1 (400 mg, 0.912 mmol calcd. in terms of benzofluorene repeating units) and chloroform (20 mL) were supplied to a 50 mL flask and dissolved by stirring at room temperature. Then 1.40 ml (18.2 mmol, 20 times by mol the benzofluorene units) of trifluoroacetic acid and 19.6 µL (0.38 mmol, 42 mol% based on benzofluorene units) of bromine were supplied successively and stirred for 16 hours with light shut out. The reaction mass was added dropwise to 200 ml of methanol with stirring to cause precipitation. The precipitate was filtelred off, washed with methanol and dried in vacuo to obtain 405 mg of a polymer. This polymer is called brominated aromatic polymer compound 1. Its polystyrene-reduced number-average molecular weight (Mn) was 1.5 x 10⁴, weight-average molecular weight (Mw) was 3.2 x 10⁴, peak-top molecular weight (Mp) was 3.3 x 10⁴, and the degree of disspersion (Mw/Mn) was 2.1 (GPC determination method B).

The result of an elemental anlysis shows that this polymer had the repeating units having Br groups (P-2) and the repeating units having no Br groups (P-1) in a ratio of (P-1)/(P-2) = 62/38, the bromination ratio was 38%, and the bromination yield was 90%.

Elemental Anal. Found: C, 84.33%;, H, 8.82%; N<0.3%; Br, 6.49%.

Elemental Anal. Calcd. (on condition of (P-1)/(P-2) = 62/38): C, 84.55%; H, 8.96%; N, 0%; Br, 6.49%.

The results of analysis by ¹H-NMR showed that the peak attributable to protons of alkyl group on the high magnetic field side remained unchanged, while a change was seen in the peak attributable to protons of aryl group on the low magnetic field side. There was also noted a decrease of the aryl group proton/alkyl group proton ratio, indicating that the Br group has been introduced to the aromatic ring portion of benzofluorene.
¹H-NMR (300 MHz/CDCl₃): δ 0.83 (bs), 1.16 (bs), 2.19 (bs), 7.3-9.3 (m). Integral ratio: (alkyl-derived protons)/(aryl-derived protons) = 4.40; bromination ratio determined by ¹H-NMR = 34%; bromination yield = 81.

### Example 8

### <Synthesis of brominated aromatic polymer compound 2: Bromination of aromatic polymeric compound 1>

Under an inert gas atmosphere, the aromatic polymer compound 1 (20.0 mg, 0.0456 mmol calcd. in terms of benzofluorene repeating units) and 1.0 mL of chloroform were supplied to a 4 mL screwed pipe and dissolved by stirring at room temperature. Then 70 *µ*L of trifluoroacetic acid (0.91 mmol, 20 times by mol the benzofluorene units) and 0.7 µl of bromine (0.014 mmol, 30 mol% based on benzofluorene units) were supplied successively and stirred for 16 hours, with the flask stoppered and light shut out. The reaction mass was added dropwise to 20 ml of methanol with stirring to cause precipitation. The precipitate was filtered off, washed with methanol and dried in vacuo to obtain 19.9 mg of a polymer. This polymer is called brominated aromatic polymer compound 2. Mn = 1.3 x 10⁴; Mw = 3.1 x 10⁴; Mp = 3.2 x 10⁴; Mw/Mn = 2.3 (GPC determination method B).

The result of an elemental analysis showed this polymer had the repeating units having Br groups (P-2) and the repeating units having no Br groups (P-1) in a ratio of (P-1)/(P-2)= 72/28; bromination ratio = 28%; bromination yield = 93%.

Elemental Anal. Found: C, 85.39%; H, 9.07%; N<0.3%; Br, 4.79%.

Elemental Anal. Calcd. (on condition of (P-1)/(P-2) = 72/28): C, 86.07%; H, 9.14%; N, 0%; Br, 4.79%.

Integral ratio determined by ¹H-NMR (300 MHz/CDCl₃ (alkyl-derived protons)/(aryl-derived protons) = 4.34; bromination ratio determined by ¹H-NMR = 22%; bromination yield determined by ¹H-NMR = 73%.

### Example 9

### <Synthesis of brominated aromatic polymeric compound 3: Bromination of aromatic polymer compound 1>

Under an inert gas atmosphere, the aromatic polymer compound 1 (20.0 mg, 0.0456 mmol calcd. in terms of benzofluorene repeating units) and 1.0 mL of chloroform were supplied to a 4 mL screwed pipe and dissolved by stirring at room temperature. Then 70 µL of trifluoroacetic acid (0.91 mmol, 20 times by mol the benzofluorene units) and 1.6 *µ*L of bromine (0.032 mmol, 70 mol% based on benzofluorene units) were supplied successively and stirred for 16 hours, with the flask stoppered and light shut out. The reaction mass was added dropwise to 20 ml of methanol with stirring to cause precipitation. The precipitate was filtered off, washed with methanol and dried in vacuo to obtain 21.4 mg of a polymer. This polymer is called brominated aromatic polymer compound 3. Mn = 1.3 x 10⁴; Mw = 3.1 x 10⁴; Mp = 3.3 x 10⁴; Mw/Mn = 2.3 (GPC determination method B).

The result of an elemental analysis showed the ratio of the repeating units having no Br groups (P-1) to the repeating units having Br groups (P-2) is: (P-1)/(P-2) = 35/65; bromination ratio = 65%; bromination yield = 93%.

Elemental Anal. Found: C, 79.11%; H, 8.42%; N<0.3%; Br, 10.61%.

Elemental Anal. Calcd. (on condition of (P-1)/(P-2) = 35/65): C, 80.87%; H, 8.52%; N, 0%; Br, 10.61%.

Integral ratio determined by ¹H-NMR (300 MHz/CDCl₃): (alkyl-derived protons)/(aryl-derived protons) = 4.53; bromination ratio determined by ¹H-NMR = 56%; bromination yield determined by ¹H-NMR = 80%.

### Example 10

### <Synthesis of brominated aromatic polymer compound 4: Bromination of aromatic polymer compound 1>

Under an inert gas atmosphere, the aromatic polymer compound 1 (20.4 mg, 0.0465 mmol calcd. in terms of benzofluorene repeating units) and 1.0 ml of chloroform were supplied to a 4 mL screwed pipe and dissolved by stirring at room temperature. Then 70 µL of trifluoroacetic acid (0.91 mmol, 20 types by mol the benzofluorene units) and 2.3 *µ*L of bromine (0.045 mmol, 96 mol% based on benzofluorene units) were supplied successively and stirred for 16 hours, with the flask stoppered and light shut out. The reaction mass was added dropwise to 20 ml of methanol with stirring to cause precipitation. The precipitate was filtered off, washed with methanol and dried in vacuo to obtain 22.7 mg of a polymer. This polymer is called brominated aromatic polymer compound 4. Mn = 1.5 x 10⁴; Mw = 3.2 x 10⁴; Mp = 3.3 x 10⁴; Mw/Mn = 2.2 (GPC determination method B).

The result of an elemental analysis showed the ratio of the repeating units having no Br groups (P-1) to the repeating units having Br groups (P-2) is: (P-1)/(P-2) = 13/87; bromoination ratio = 87%; bromination yield = 91%.

Elemental Anal. Found: C, 78.18%; H, 8.20%; N<0.3%; Br, 13.75%.

Elemental Anal. Calcd. (on condition of (P-1)/(P-2) = 13/87) : C, 78.07%; H, 8.18%; N, 0%; Br, 13.75%.

Integral ratio determined by ¹H-NMR (300 MHz/CDCl₃): (alkyl-derived protons)/(aryl-derived protons) = 4.78; bromination ratio determined by ¹H-NMR = 94%; bromination yield determined by ¹H-NMR = 98%.

### Example 11

### <Synthesis of brominated aromatic polymer compound 5: Bromination of aromatic polymer compound 1>

Under an inert gas atmosphere, the aromatic polymer compound 1 (20.0 mg, 0.0456 mmol calcd. in terms of benzofluorene repeating units) and 1.0 ml of dehydrated tetrahydrofuran were supplied to a 4 mL screwed pipe and dissolved by stirring at room temperature. Then 70 µl of trifluoroacetic acid (0.91 mmol, 20 times by mol the benzofluorene units) and 2.3 µl of bromine (0.045 mmol, 98 mol% based on benzofluorene units) were supplied successively and stirred for 16 hours, with the flask stoppered and light shut out. The reaction mass was added dropwise to 20 mL of methanol with stirring to cause precipitation. The precipitate was filtered off, washed with methanol and dried in vacuo to obtain 19.6 mg of a polymer. This polymer is called brominated aromatic polymer compound 5. Mn = 1.5 x 10⁴; Mw = 3.1 x 10⁴; Mp = 3.3 x 10⁴; Mw/Mn = 2.1 (GPC determination method B).

Integral ratio determined by ¹H-NMR (300 MHz/CDCl₃): (alkyl-derived protons)/(aryl-derived protons) = 4.29; bromination ratio determined by ¹H-NMR = 13%; bromination yield determined by ¹H-NMR = 13%. Exasmple 12

### <Synthesis of brominated aromatic polymer compound 6: Bromination of aromatic polymer compound 1>

Under an inert gas atmosphere, the aromatic polymer compound 1 (20.0 mg, 0.0456 mmol calcd. in terms of benzofluorene repeating units) and 1.0 ml of chloroform were supplied to a 4 mL screwed pipe and dissolved by stirring at room temperature. Then 70 µl of trifluoroacetic acid (0.91 mmol, 20 times by mol the benzofluorene units) and 2.4 µl of bromine (0.047 mmol, 103 mol% based on benzofluorene units) were supplied successively and stirred for 16 hours, with the flask stoppered and light shut out. The reaction mass was added dropwise to 20 mL of methanol with stirring to cause precipitation. The precipitate was filtered off, washed with methanol and dried in vacuo to obtain 17.6 mg of a polymer. This polymer is called brominated aromatic polymer compound 6. Mn = 1.5 x 10⁴; Mw = 3.1 x 10⁴; Mp = 3.3 x 10⁴; Mw/Mn = 2.1 (GPC determination method B).

Integral ratio determined by ¹H-NMR (300 MHz/CDCl₃): (alkyl-derived protons)/(aryl-derived protons) = 4.49; bromination ratio determined by ¹H-NMR = 49%; bromination yield determined by ¹H-NMR = 48%.

### Example 13

### <Synthesis of brominated aromatic polymeric compound 7: Bromination of aromatic polymeric compound 1>

Under an inert gas atmosphere, the aromatic polymer compound 1 (30.0 mg, 0.0685 mmol calcd. in terms of benzofluorene repeating units) and 1.5 ml of chloroform were supplied to a 4 mL screwed pipe and dissolved by stirring at room temperature. Then 105 µl of trifluoroacetic acid (0.91 mmol, 20 times by mole the benzofluorene units) and 12.2 mg of N-bromosuccineimide (0.068 mmol, 100 mol% based on benzofluorene units) were supplied successively and stirred for 16 hours, with the flask stoppered and light shut out. The reaction mass was added dropwise to 20 ml of methanol with stirring to cause precipitation. The precipitate was filtered off, washed with methanol and dried in vacuo to obtain 31.9 mg of a polymer. This polymer is called brominated aromatic polymer compound 7. Mn = 1.4 x 10⁴; Mw = 2.9 x 10⁴; Mp = 3.1 x 10⁴; Mw/Mn = 2.1 (GPC determination method B).

Integral ratio determined by ¹H-NMR (300 MHz/CDCl₃): (alkyl-derived protons)/(aryl-derived protons) = 4.47; brominaion ratio determined by ¹H-NMR = 45%; bromination yield determined by ¹H-NMR = 45%. Synthesis Example 11

### <Synthesis of compound G>

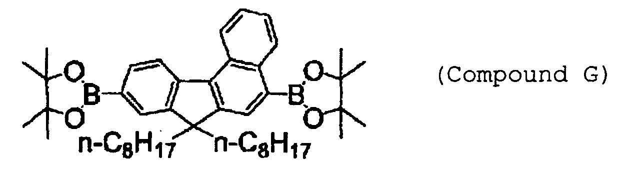

To a 100 mL round flask having its inside replaced with argon gas, a compound E (3.2 g, 5.3 mmol) synthesized in the same way as compound E in Synthesis Example 9, bispinacolatediboron (3.8 g, 14.8 mmol), PdCl₂ (dppf) (0.39 g, 0.45 mmol), bis(diphenylphosphino)pherocene (0.27 g, 0.45 mmol) and potassium acetate (3.1 g, 32 mmol) were supplied, followed by the addition of 45 ml of dehydrated dioxane. The mixture was heated to 100°C and allowed to react for 36 hours under an argon atmosphere. After allowed to stand to cool, the reaction solution was passed through a filter precoated with 2 g of celite and concentrated to obtain a black liquid. It was dissolved in 50 g of hexane and the colored components were removed with active carbon to obtain 37 g of a light yellow liquid. (Precoating with 5 g of Radiolite (produced by Showa Kagaku Kogyo KK) was conducted for filtration.) Then 6 g of ethyl acetate, 12 g of dehydrated methanol and 2 g of hexane were added and the mixture was immersed in a dry ice/methanol bath to obtain 2.1 g of compound I as colorless crystals. Synthesis Example 12

### <Synthesis of aromatic polymer compound 2>

To a 200 mL flask having a Dimroth condenser connected thereto, under an argon atmosphere, 37.7 g (63 mmol) of compound E same as synthesized in Synthesis Example 10 and 43.6 g (63 mmol) of compound G same as synthesized in Synthesis Example 14 were supplied and dissolved in 70 ml of toluene, and the mixture was degassed by bubbling arogon gas into the mixture. To this solultion, 42 mg of palladium acetate and 266 mg of tris(o-methoxyphenyl)phosphine were added. With the solution heated, 283.4 ml of a 33 wt% bis(tetraethylammonium) carbonate solution was added dropwise and refluxed for 24 hours. 10.8 g of bromobenzene was added, and after additional one-hour refluxing, 8.9 g of phenylboric acid was added, followed by further one-hour refluxing. The oil layer was washed twice with a 2N hydrochloric acid solution, twice with a 10% acetic acid solution and 6 times with water, then filtered with celite and concentrated under reduced pressure, and the resulting solution was added dropwise into methanol for precipitation. The produced solid was filtered off, dried in vacuo, again dissolved in toluene, reprecipitated into methanol and dried in vacuo, with this operating being repeated twice to obtain 22.4 g of a polymer (hereinafter called aromatic polymer compound 2). Mn = 7.3 x 10⁴; Mw = 1.8 x 10⁵ (GPC determination method C).

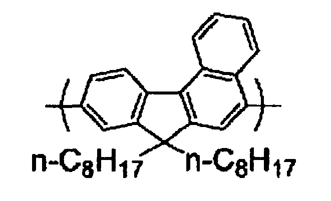

### Aromatic polymer compound 2

### Example 14

### <Synthesis of brominated aromatic polymer compound 8: Bromination of aromatic polymeric compound 2>

Under an argn gas atmosphere, the aromatic polymer compound 2 (5.00 g, 11.4 mmol calcd. in terms of benzofluorene repeating units) and chloroform (150 ml) were supplied to a 500 mL flask and dissolved by stirring at room temperature. Then 17.6 mL of trifluoroacetic acid and 236 µl of bromine (4.6 mmol, 40 mol% based on benzofluorene units) were supplied successively and stirred for 24 hours with light shut out. The reaction mass was added dropwise to 1,250 mL of methanol with stirring to cause precipitation. The precipitate was filtered off, washed with methanol and dried in vacuo to obtain 5.29 g of a polymer. This polymer is called brominated aromatic polymer compound 8. Mn = 7.5 x 10⁴; Mw = 1.6 x 10⁵; Mp = 1.2 x 10⁵; Mw/Mn = 2.1 (GPC determination method C).

From the result of an elemental analysis, the ratio of repeating units having no Br groups (P-1) to repeating units having Br groups (P-2) was: (P-1)/(P-2) = 61/39; bromination ratio = 39%; bromination yield = 98%.

Elemental Anal. Found: C, 84.93%; H, 9.06%; N<0.3%; Br, 6.57%.

Elemental Anal. Calcd. (on condition of (P-1)/(P-2) = 61/39) : 6.57%.

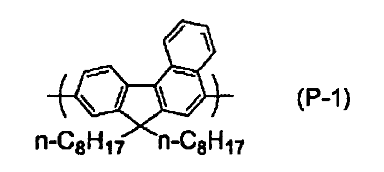

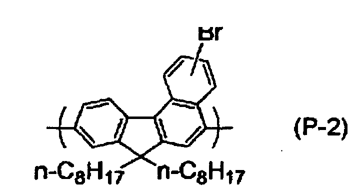

### Synthesis Example 13

### <Synthesis of aromatic polymer compound 3: Condensation polymerization of 2,7-dibromo-9,9-di-n-octylfluorene and 2,7-dibromo-9,9-bis(3-methylbutyl)fluorene>

26.3 g of 2,7-dibromo-9,9-di-n-octylfluorene, 5.6 g of 2,7-dibromo-9,9-bis(3-methylbutyl)fluorine, and 22 g of 2,2'-bipyridyl were dissolved in 1,600 mL of tetrahydrofuran, and then the inside of the system was replaced with nitrogen by bubbling nitrogen through the system. To this solution, under a nitrogen atmosphere, bis(1,5-cyclooctadiene)nickel (0) {Ni(COD)₂} (40.66 g) was added and the mixture was heated to 60°C and reacted for 8 hours with stirring. After the reaction, the reaction solution was cooled to room temperature (about 25°C), added dropwise into a mixed solution of 25% ammonia water (1,200 ml), methanol (1,200 ml) and ion exchange water (1,200 ml) and stirred for 0.5 hour. The produced precipitate was fitered off, dried in vacuo for 2 hours, then dissolved in 1,110 ml of toluene and again filtered. Toluene was added to the filtrate to form approximately 2,800 mL of a solution. The organic layer was washed with 2,000 mL of 1N hydrochloric acid solution for one hour, then with 2,200 mL of 4% ammonia water for one hour, further with 1,000 mL of ion exchange water for 10 minutes and additionally with 1,000 mL of ion exchange water for 10 minutes. This organic layer was concentrated under reduced pressure to 592 g at 50°C, then added dropwise to 3,330 mL of methanol and stirred for 0.5 hour. The produced precipitate was filtered off, washed twice with 500 ml of methanol and then dried in vacuo at 50°C for 5 hours. There was obtained a copolymer in a yield of 12.6 g. This copolymer is called aromatic polymer compound 3. Its polystyrene-reduced number-average molecular weight Mn was 8.4 x 10⁴ and weight-average molecular weight Mw was 1.6 x 10⁵ (GPC analytical method C). In this aromatic polymer compound 3, the ratio of 9,9-di-n-octylfluorene repeating units to 9,9-bis(3-methylbutyl)fluorene repeating units conjectured from the feed rate was 80:20.

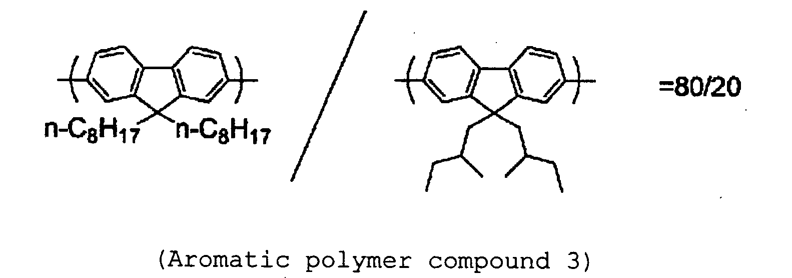

### Example 15

### <Synthesis of brominated aromatic polymer compound 9: Bromination of aromatic polymer compound 3>

Under an argon gas atmosphere, the aromatic polymer compound 3 (2.00 g, 5.38 mmol calcd. in terms of fluorene repeating units) and 100 ml of chloroform were supplied to a 200 mL flask and dissolved by stirring at room temperature. Then 8.3 mL of trifluoroacetic acid and 104 µL of bromine (2.05 mmol, 38 mol% based on fluorene repeating units) were supplied successively and, with light shut out, stirred for 20 hours. The reaction mass was added dropwise to 500 mL of methanol with stirring to cause precipitation. The precipitate was filtered off, washed with methanol and dried in vacuo to obtain 2.17 g of a polymer. This polymer is called brominated aromatic polymer compound 9. Mn = 9.2 x 10⁴; Mw = 1.7 x 10⁵; Mp = 1.4 x 10⁵; Mw/Mn = 1.90 (GPC determination method C).

From the result of an elemental analysis, this polymer had a combination of repeating units having Br group (P-7) and a combination of repeating units having no Br group (P-6) in a ratio of: (P-6)/(P-7) = 63/37; bromination ratio = 37%; bromination yield = 97%.

Elemental Anal. Found: C, 82.48%; H, 9.25%; N<0.3%; Br, 7.44%.

Elemental Anal. Calcd. (on condition of (P-6)/(P-7) = 63/37): C, 83.21%; H, 9.35%; N, 0%; Br.7.44%.

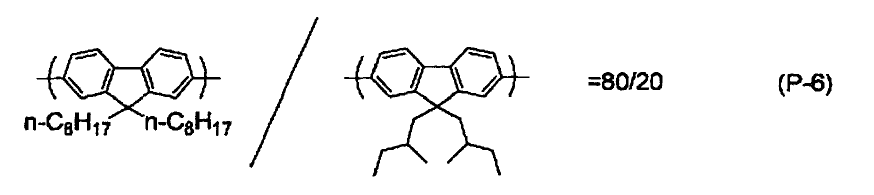

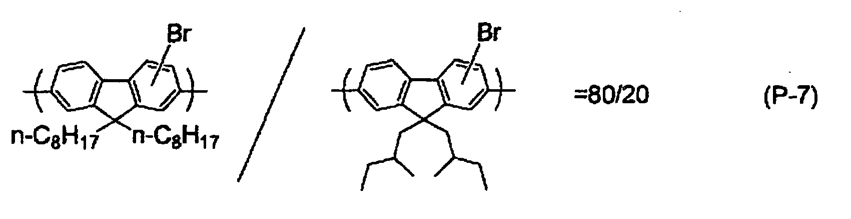

### Synthesis Example 14

### <Synthesis of compounds L>

### (Synthesis of compound L-1)

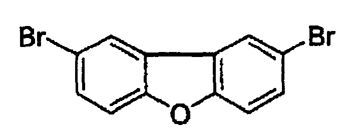

### Compound L-1

Under an inert atmosphere, benzofuran (23.2 g, 137.9 mmol) and acetic acid (232 g) were supplied to a 1-litre three-necked flask, dissolved by stirring at room temperature and heated to 75°C. After heating to this temperature, a solution of bromine (92.6 g, 579.3 mmol) diluted with acetic acid (54 g) was added dropwise. The mixture was stirred for 3 hours while maintaining the temperature and allowed to stand for cooling. After disappearanc of the starting material was confirmed by TLC, a sodium thiosulfate solution was added to end the reaction. The reaction mixture was stirred at room temperature for one hour and then filtered. The filtered-off cakes were washed with a sodium thiosulfate solution and water, and then dried. The obtained crude product was recrystallized from hexane to obtain the objective substance. (Yield: 21.8 g (49%).)
¹H-NMR (300 MHz/CDCl₃): δ 7.44 (d, 2H), 7.57 (d, 2H), 8.03 (s, 2H).

### (Synthesis of compound L-2)

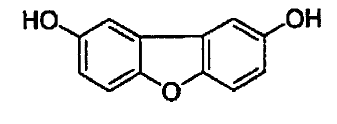

### Compound L-2

Under an inert atmosphere, the compound L-1 (16.6 g, 50.9 mmol) and tetrahydrofuran (293 g) were supplied to a 500 ml four-necked flask and cooled to -78°C. Then n-butyllithium (80 ml <1.6 mol hexane solution>, 127.3 mmol) was added dropwise and the mixture was stirred for one hour while maintaining the temperature. This reaction solution was added dropwise to a solution of trimethoxyboric acid (31.7 g, 305.5 mmol) and tetrahydrofuran (250 ml) which had been put into a 1,000 ml four-necked flask and cooled to -78°C under an inert atmosphere. Then the solution was allowed to return slowly to room temperature and stirred at room temperature for 2 hours, after which disappearance of the starting material was confirmed by TLC. The reaction mass was poured into a 2,000 ml beaker containing concentrated sulfuric acid (30 g) and water (600 ml) to end the reaction. Then toluene (300 ml) was added and the organic layer was extracted and washed with water. After evaporating away the solvent, 8 g of the extract and 160 ml of ethyl acetate were supplied to a 300 ml four-necked flask, followed by addition of a 30% hydrogen peroxide solution (7.09 g) and 2-hour stirring at 40°C. This reaction solution was poured into a solution of ammonium iron sulfate (II) (71 g) and water (500 ml) in a 1,000 ml beaker. After stirring, the organic layer was extracted and washed with water, and then the solvent was removed to obtain 6.72 g of a crude preparation of compound L-2.
MS spectrum: M⁺ 200.0.

### (Synthesis of compound L-3)

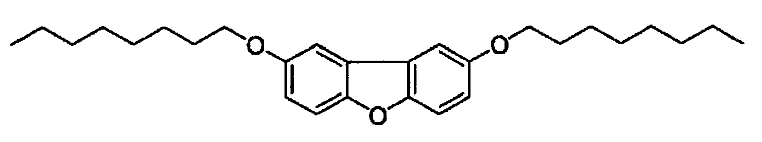

### Compound L-3

Under an inert atmosphere, the compound L-2 (2.28 g, 11.4 mmol) synthesized as described above and N,N-dimethylformamide (23 g) were supplied to a 200 ml four-necked flask and dissolved by stirring at room temperature. Then potassium carbonate (9.45 g, 68.3 mmol) was added and the mixture was heated to 60°C. After heating, a solution of n-octyl bromide (6.60 g, 34.2 mmol) diluted with N,N-dimethylformamide (11 g) was added dropwise. Thereafter, the solution was heated to 60°C and stirred for 3 hours while maintaining the temperature, and disappearance of the starting material was confirmed by TLC. Water (20 ml) was added to end the reaction. Then toluene (20 ml) was added and the organic layer was extracted, washed twice with water and dried over anhydrous sodium sulfate, and then the solvent was evaporated away. The resulting crude product was purified by silica gel column chromatography to obtain the objective substance.
(Yield: 1.84 g (38%).)
MS spectrum: M⁺ 425.3

### (Synthesis of compound L)

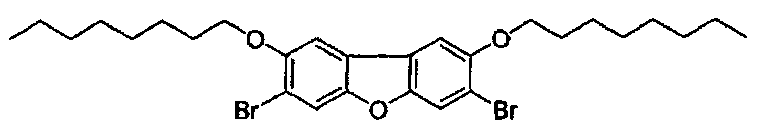

### Compound L

Under an inert atmosphere, the compound L-3 (7.50 g, 17.7 mmol) synthesized as described above and N,N-dimethylformaide were supplied to a 500 ml four-necked flask, dissolved by stirring at room temperature and cooled by an ice bath. After cooling, a solution of N-bromosuccineimide (6.38 g, 35.9 mmol) diluted with N,N-dimethylformamide (225 ml) was added dropwise. Thereafter, the mixture was cooled by the ice bath for one hour, then kept at room temperature for 18.5 hours and then heated to 40°C. The mixture was stirred for 6.5 hours while maintaining the temperature and disappearance of the starting material was confirmed by liquid chromatography. The solvent was removed and toluene (75 ml) was added for promoting dissolution. The organic layer was washed thrice with water and dried over anhydrous sodium sulfate, and then the solvent was evaporated away. About half amount of the obtained crude product was purified by silica gel column and liquid chromatography to obtain the objective substance. (Yield: 0.326 g.)
¹H-NMR (300 MHz/CDCl₃) : δ 0.90 (t, 6H), 1.26-1.95 (m, 24H), 4.11 (t, 4H), 7.34 (s, 2H), 7.74 (s, 2H).
MS spectrum: M⁺ 582.1.
Synthesis Example 15

### <Synthesis of aromatic polymer compound 4>

Under a nitrogen atmosphere, 0.104 g of 3,8-dibromodibenzofuran, 0.719 g of the compound L and 0.578 g of 2,2'-bipyridyl were dissolved in 30 g of dehydrated tetrahydrofuran and heated to 60°C. To this solution was added 1.040 g of bis(1,5-cyclooctadiene)nickel (0) {Ni(COD)₂}, and the mixture was reacted at 60°C for 3 hours. After the reaction, the reaction solution was cooled to room temperature, added dropwise to a mixed solution of 25% ammonia water (9 g), methanol (95 g) and ion exchange water (50 g) and stirred for 30 minutes. The formed precipitate was filtered off, dried in vacuo for 2 hours and dissolved in 30 ml of toluene. After adding 30 g of 1N hydrochloric acid, the mixture was stirred for 3 hours and then the aqueous layer was removed. Then 30 g of 4% ammonia water was added to the organic layer, and after 3-hour stirring, the aqueous layer was removed. Then the organic layer was added dropwise to 200 ml of methanol, followed by 30-minute stirring. The precipitate was filtered off, dried in vacuo for 2 hours and dissolved in 30 ml of toluene. The resulting product was purified by passing through an alumina column (amount of alumina: 10 g) and the recovered toluene solution was added dropwise to 200 ml of toluene and stirred for 30 minutes. The formed precipitate was filtered off and drived in vacuo for 2 hours, obtaining a polymer in a yield of 0.456 g. This polymer is called aromatic polymer compound 4. Mn = 1.3 x 10⁵; Mw = 4.6 x 10⁵ (GPC determination method A).

The aromatic polymer compound 4 had dibenzofuran repeating units of formulae (P-9) and those of formula (P-10), and their ratio conjectured from the feed rate was: (P-9)/(P-10) = 80/20.

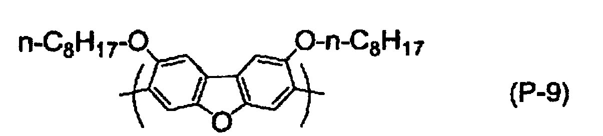

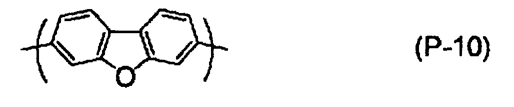

### Example 16

### <Synthesis of brominated aromatic polymer compound 10: Bromination of aromatic polymer compound 4>

Under an argon gas atmosphere, the aromatic polymer compound 4 (150 mg, 0.404 mmol calcd. in terms of dibenzofuran repeating units) and chloroform (8 mL) were supplied to a 20 mL flask and dissolved by stirring at room temperature. Then 0.6 mL of trifluoroacetic acid and a solution (0.10 mmol, 25 mol% based on dibenzofuran repeating units) of bromine (5.2 µL) diluted with 1 mL of chloroform were supplied successively, and the mixture was stirred for 20 hours, with light shut out. The reaction mass was added dropwise to 38 mL of methanol with stirring to cause precipitation. The precipitate was filtered off, washed with methanol, dried in vacuo for 2 hours and dissolved in 25 mL of toluene. This solution was passed through a silica gel column and an alumina column through which toluene had previously been passed, further washed out with toluene, concentrated under reduced pressure, and added dropwise into methanol to cause reprecipitation. The precipitate was filtered off, washed with methanol and dried in vacuo to obtain 152 mg of a polymer. This polymer is called brominated aromatic polymer compound 10. Mn = 1.5 x 10⁵; Mw = 3.8 x 10⁵; Mp = 3.7 x 10⁵; Mw/Mn = 2.6 (GPC determination method C).

It is considered that the brominated aromatic polymer compound 10 has dibenzofuran repeating units represented by the formulae (P-9), (P-10), (P-9b) and (P-11).

From the result of an elemental analysis, the ratio of the repeating units having no Br groups (P-9), (P-10) to the repeating units having Br groups (P-9b), (P-11) was: {(P-9) + (P-10)}/{(P-9b) + (P-11)} = 77/23, and (overall dibenzofuran repeating units)/Br groups = 81/19.

Elemental Anal. Found: C, 75.46%; H, 7.93%; N<0.3%; Br, 4.67%.

Elemental Anal. Calcd. (on condition of {(P-9) + (P-10)}/{(P-9b) + (P-11)} = 77/23): C, 76.52%; H, 8.12%; N, 0%; Br, 4.67%.

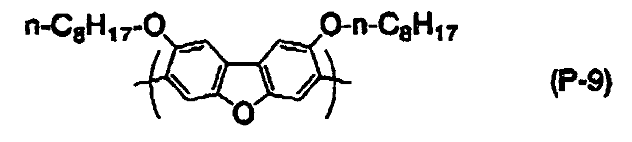

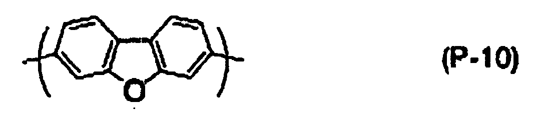

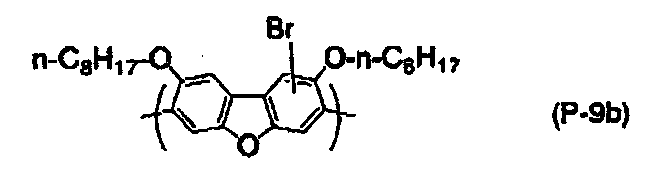

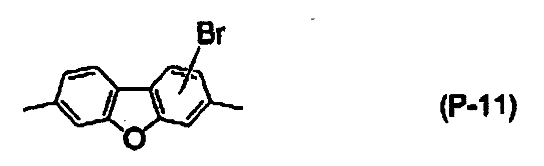

### INDUSTRIAL APPLICABILITY

According to the process in the first embodiment of the present invention, it is possible to produce with ease the polymers having an aromatic ring in the backbone and a substituent group of an intricate structure in the side chain. The polymers produced by the process of the present invention are expected to serve as a polymer material useful for the production of various types of high-functionability materials in the fiels of electronics, chemistry, energy-generative materials, medicines, etc.

According to the process in the second embodiment of the present invention, it is possible to produce with ease the aromatic polymers having repeating units with a characteristic group. Further, even the aromatic polymers of the type which can not be brominated at all by the conventional methods or can be brominated only under a strict condition, or the so-called brominated aromatic polymers, can be easily produced under a mild condition in a high yield while controlling the bromination rate.

### BRIEF DESCRIPTION OF THE DRAWING

FIG. 1 shows the result of measurement of voltage-current characteristic of an electron single element, a hole single element and an EL element.

## Claims

1. A process for producing a polymer **characterized by** comprising the following step (A) and step (B):
(A) a step in which a polymer having repeating units represented by the general formula (1):
-Ar¹- (1)
(wherein Ar¹ represents an arylene, divalent heterocyclic or divalent aromatic amine group having at least one C-H bond on the aromatic ring) is used as a starting material and one or more of the C-H bond(s) on the aromatic ring are converted to thereby produce a polymer having repeating units which have one or more characteristic groups X and are represented by the general formula (2): 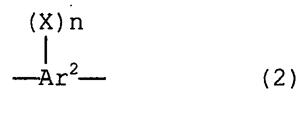 (wherein X represents a characteristic group; Ar² represents an arylene group, heterocyclic group or aromatic amine group which each has a valence of n + 2 and in each of which n of the C-H bonds on the aromatic ring of Ar¹ have been converted into a C-X bond; and n is an integer of 1 to 4) (hereinafter, this polymer is referred to as polymer having the characteristic group X);
(B) a step in which the polymer having the characteristic group X produced in the step (A) is reacted with a compound having a characteristic group Y which reacts with the characteristic group X to form a bond.

2. The process according to Claim 1 wherein in the step (A), the reaction for converting the C-H bond(s) on the aromatic ring is an aromatic electrophilic substitution reaction, and the characteristic group X is a group introduced by the aromatic electrophilic substitution reaction or a group derived therefrom.

3. The process according to Claim 1 or 2 wherein in the step (A), the reaction for converting the C-H bond(s) on the aromatic ring is an aromatic electrophilic substitution reaction selected from the group consisting of halogenation, nitration, Friedel-Crafts alkylation, halomethylation, Friedel-Crafts acylation, Gattermann aldehyde synthesis and Vilsmeier formylation.

4. The process according to any one of Claims 1 to 3 wherein the characteristic group X is a group selected from the group consisting of halogen atom, -OSO₂Q¹, -B(OQ²)₂, -Sn(Q³)₃, Z¹(Z)m, -OH, -CH₂Z³, -CHQ⁴-P⁺(Q⁵)₃Z⁴, -CHQ⁶-P (=O) (OQ⁷)₂ and -C(=O)Q⁸ (wherein Q¹ is a hydrocarbon group; Q² is a hydrogen atom or a hydrocarbon group, and two Q²'s may be identical or different from each other and may be bonded to each other to form a ring; Q³ is a hydrocarbon group, and three Q³'s may be identical or different from each other; Q⁴ is a hydrogen atom or a hydrocarbon group; Q⁵ is a hydrocarbon group, and three Q⁵'s may be identical or different from each other; Q⁶ is a hydrogen atom or a hydrocarbon group; Q⁷ is a hydrocarbon group, and two Q⁷'s may be identical or different from each other; Q⁸ is a hydrogen atom or a hydrocarbon group; Z¹ is a metal atom or a metal ion; Z² is a counter anion, with m representing an integer of 0 or greater; Z³ is a halogen atom or a cyano group; and Z⁴ is a monovalent counter anion).

5. The process according to any one of Claims 1 to 4 wherein in the step (A), the reaction for converting the C-H bonds on the aromatic ring is halogenation reaction.

6. The process according to any one of Claims 1 to 5 wherein the characteristic group X is a group selected from the group consisting of halogen atom, -OSO₂Q¹, -B(OQ²)₂, -Sn(Q³)₃, Z¹(Z²)m and -CHO (wherein Q¹, Q², Q³, Z¹, Z² and m have the same meaning as defined above).

7. The process according to any one of Claims 1 to 6 wherein in the step (B), at least one compound selected from the compounds represented by the following general formulae (3) and (4) is used as the compound having the characteristic group Y:
Y-G-A¹ (3)
(wherein Y has the same meaning as defined above; G represents a direct bond or a C₁-C₂₀ alkyl group which may have a linear or branched structure or may have a cyclic structure; and A¹ represents a monovalent organic group which has therein no characteristic group that substantially reacts with the characteristic group X or Y to form a bond);
Y-B-A²-X² (4)
(wherein Y and G have the same meaning as defined above; X² represents a characteristic group which reacts with the characteristic group Y to form a bond, and its definition is the same as given with X above; X and X² may be identical or different from each other; and A² represents a divalent organic group which has therein no characteristic group that substantially reacts with the characteristic group X, Y or X² to form a bond.)

8. The process according to any one of Claims 1 to 7 wherein in the step (B), there are used at least one of the compounds represented by the formula (4) and also at least one of the compounds represented by the formula (3).

9. The process according to any one of Claims 1 to 8 wherein the charactereistic group Y is a characteristic group selected from the group consiting of halogen atom, -OSO₂Q¹, -B(OQ²)₂, -Sn(Q³)₃, Z¹(Z²)m, -OH, -CH₂Z³, -CHQ⁴-P⁺(Q⁵)₃Z⁴, -CHQ⁶-P(=O)(OQ⁷)₂, -C(=O)Q⁸, -CHQ⁹=CHQ¹⁰, -C≡CH, -NHQ¹¹ and -SH (wherein Q¹, Q², Q³, Q⁴, Q⁵, Q⁶, Q⁷, Q⁸, Z¹, Z², Z³, Z⁴ and m have the same meaning as defined above; Q⁹, Q¹⁰ and Q¹¹ each represents a hydrogen atom or a hydrocarbon group.)

10. The process according to any one of Claims 1 to 9 wherein the characteristic group Y is a characteristic group selected from the group consisting of halogen atom, -OSO₂Q¹, -B(OQ²)₂, -Sn(Q³)₃, Z¹(Z²)ₘ, -OH, -CHQ⁴-P⁺(Q⁵)₃Z⁴, -CHQ⁶-P(=O)(OQ⁷)₂, -CHQ⁹=CHQ¹⁰, -C≡CH, -NHQ¹¹ and -SH (wherein Q¹, Q², Q³, Q⁴, Q⁵, Q⁶, Q⁷, Q⁹, Q¹⁰, Q¹¹, Z¹, Z², Z³, Z⁴ and m have the same meaning as defined above.)

11. The process according to any one of Claims 1 to 10 wherein the characteristic group Y is a characteristic group selected from the group consisting of halogen atom, -OSO₂Q¹, -B(OQ²)₂, -Sn(Q³)₃ and Z¹(Z²)ₘ (wherein Q¹, Q², Q³, Z¹, Z² and m have the same meaning as defined above.)

12. The process according to any one of Claims 1 to 11 wherein in the step (B), the combination of the characteristic group X and the charactertistic group Y is a combination of a halogen atom and -B(OQ²)₂ (wherein Q² has the same meaning as defined above.)

13. The process according to any one of Claims 1 to 12 wherein the polymer having repeating units represented by the formula (1) is a conjugated polymer.

14. The process according to any one of Claims 1 to 13 wherein the polystyrene-reduced number-average molecular weight of the conjugated polymer mentioned in Claim 13 is 10³ to 10⁸.

15. A process for producing a polymer **characterized in that** a polymer having one or more repeating units represented by the general formula (1):
-Ar¹- (1)
(wherein Ar¹ represents an arylene, divalent heterocyclic or divalent aromatic amine group having at least one C-H bond on the aromatic ring), the total of the repeating units represented by the formula (1) being 0.1 to 100 mol% of the total of the whole repeating units (wherein said polymer may have, in addition to the repeating units of the formula (1), the repeating units represented by the general formula (1a)
-Ar⁰- (1a)
(wherein Ar⁰ represents an arylene, divalent heterocyclic or divalent aromatic amine group which has no C-H bond on the aromatic ring) and may also have a linking group having a nonconjugated portion represented by any one of the following formulae X-1 to X-11: 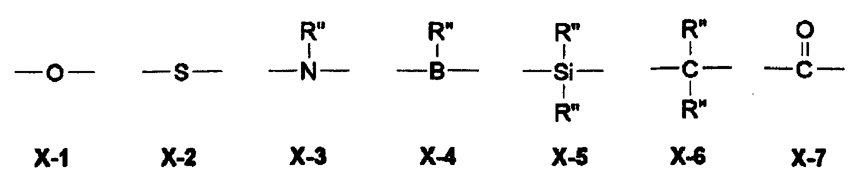 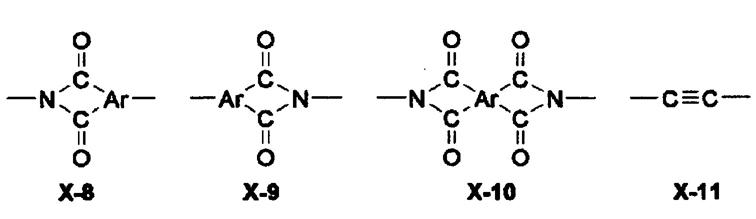 (wherein Ar represents a C₆-C₆₀ hydrocarbon group; and R" represents a substituent group selected from the group consisting of hydrogen atom, alkyl group, aryl group and monovalent heterocyclic group) and/or a combination of two or more of such linking groups in an amount of 40 mol% or less based on the total of the repeating units represented by the formulae (1) and (2)), is used as the starting material, and the C-H bond on the aromatic group is converted by an aromatic electrophilic substitution reaction selected from the group consisting of halogenation, nitration, Friedel-Crafts alkylation, halomethylation, Friedel-Crafts acylation, Gattermann aldehyde synthesis and Vilsmeier formylation to thereby obtain a polymer having repeating units which have one or more characteristic groups X and are represented by the general formula (2'): 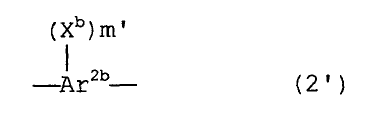 (wherein X^{b} represents a characteristic group introduced by the aromatic electrophilic substitution reaction or a group derived therefrom; Ar^{2b} represents an arylene group, heterocyclic group or aromatic amine group which each has a valence of m' + 2 and in each of which m' of the C-H bonds on the aromatic ring of Ar¹ have been converted into a C-X bond; and m' is an integer of 1 to 4).

16. The process according to Claim 1 wherein the characteristic group represented by X is a characteristic group selected from the group consisting of halogen atom, -OSO₂Q¹, -B(OQ²)₂, -Sn(Q³)₃, Z¹(Z²)m, -OH, -CH₂Z³, -CHQ⁴-P⁺(Q⁵)₃Z⁴, -CHQ⁶-P(=O) (OQ⁷)₂, -C(=O)Q⁸, -NH₂ and diazonio group (wherein Q¹ is a hydrocarbon group; Q² is a hydrogen atom or a hydrocarbon group, and two Q²'s may be identical or different from each other and may be bonded to each other to form a ring; Q³ is a hydrocarbon group, and three Q³'s may be identical or different from each other; Q⁴ is a hydrogen atom or a hydrocarbon group; Q⁵ is a hydrocarbon group, and three Q⁵'s may be identical or different from each other; Q⁶ is a hydrogen atom or a hydrocarbon group; Q⁷ is a hydrocarbon group, and two Q⁷'s may be identical or different from each other; Q⁸ is a hydrogen atom or a hydrocarbon group; Z¹ is a metal atom or a metal ion; Z² is a counter anion, with m representing an integer of 0 or greater; Z³ is a halogen atom or a cyano group; and Z⁴ is a monovalent counter anion).

17. The process according to Claim 15 or 16 wherein the reaction for converting C-H bond on the aromatic ring is a halogenation reaction.

18. The process according to any one of Claism 15 to 17 wherein the halogenation reaction is a bromination reaction which is carried out by acting bromine as a brominating agent in an organic solvent in the presence of an organic strong acid of an amount 5 times or more by mol the total of the repeating units represented by the general formula (1).

19. The process according to any one of Claims 15 to 18 wherein the characteristic group represented by X is a characteristic group selected from the group consisting of halogen atom, -OSO₂Q¹, -B (OQ²)₂, -Sn(Q³)₃, Z¹(Z²)m and -CHO (wherein Q¹, Q², Q³, Z¹, Z² and m have the same meaning as defined above).

20. The process according to any one of Claims 15 to 19 wherein the characteristic group represented by X is a halogen atom.

21. The process according to any one of Claims 18 to 20 wherein the organic strong acid is trifluoroacetic acid.

22. The process according to any one of Claims 18 to 21 wherein the organic solvent contains at least one selected from the group consisting of halogenated methanes and halogenated ethanes.

23. The process according to any one of Claims 15 to 22 wherein Ar¹ represents an arylene group, and Ar² represents an arylene group having a valence of n + 2.

24. The process according to any one of Claims 15 to 23 wherein n in the formula (2') is 1.

25. The process according to any one of Claims 15 to 24 wherein the polystyrene-reduced number-average molecular weight of the polymer is 10³ to 10⁸.

26. The polymers having repeating units which have one or more characteristic groups X and are represented by the general formula (2'), said polymers being obtained from the process set forth in any one of Claims 15 to 25.
